(19) Europäisches Patentamt
European Patent Office
Office européen des brevets

(11) EP 2 040 304 B1

(12) EUROPEAN PATENT SPECIFICATION

(45) Date of publication and mention
of the grant of the patent:
26.03.2014 Bulletin 2014/13

(51) Int Cl.:
*H01L 31/0232* (2014.01)

(21) Application number: 08153697.1

(22) Date of filing: 31.03.2008

(54) **Interferometric photovoltaic cell**

Interferometrische photovoltaische Zelle

Cellule photovoltaïque interférométrique

(84) Designated Contracting States:
AT BE BG CH CY CZ DE DK EE ES FI FR GB GR
HR HU IE IS IT LI LT LU LV MC MT NL NO PL PT
RO SE SI SK TR

(30) Priority: 24.09.2007 US 995259 P
03.12.2007 US 949699

(43) Date of publication of application:
25.03.2009 Bulletin 2009/13

(73) Proprietor: QUALCOMM MEMS TECHNOLOGIES,
INC
San Diego CA 92121 (US)

(72) Inventors:
• Khazeni, Kasra
San Jose, CA 95120 (US)
• Kothari, Manish
Cupertino, CA 95014 (US)
• Xu, Gang
Cupertino, CA 95014 (US)

(74) Representative: Witte, Weller & Partner
Patentanwälte mbB
Postfach 10 54 62
70047 Stuttgart (DE)

## Description

CROSS-REFERENCE TO RELATED APPLICATIONS

This application claims priority under 35 U.S.C. § 119(e) to United States Provisional Application Serial No. 60/995,259 filed on September 24, 2007, titled "INTERFEROMETRIC LIGHT TRAPPING FOR PHOTOVOLTAIC CELL" (Atty. Docket No. QCO.207PR2), which is hereby expressly incorporated by reference in its entirety.

BACKGROUND

Field of the Invention

The present invention relates generally to the field of optoelectronic tranducers that convert optical energy into electrical energy, such as for example photovoltaic cells.

Documents EP-A-1691429 and US 2007/0153860 disclose solar cell structures.

Description of the Related Art

For over a century fossil fuel such as coal, oil, and natural gas has provided the main source of energy in the United States. The need for alternative sources of energy is increasing. Fossil fuels are a non-renewable source of energy that is depleting rapidly. The large scale industrialization of developing nations such as India and China has placed a considerable burden on the available fossil fuel. In addition, geopolitical issues can quickly affect the supply of such fuel. Global warming is also of greater concern in recent years. A number of factors are thought to contribute to global warming; however, widespread use of fossil fuels is presumed to be a main cause of global warming. Thus there is an urgent need to find a renewable and economically viable source of energy that is also environmentally safe.

Solar energy is an environmentally safe renewable source of energy that can be converted into other forms of energy such as heat and electricity. Photovoltaic (PV) cells convert optical energy in to electrical energy and thus can be used to convert solar energy into electrical power. Photovoltaic solar cells can be made very thin and modular. PV cells can range in size from a few millimeters to 10's of centimeters. The individual electrical output from one PV cell may range from a few milliwatts to a few Watts. Several PV cells may be connected electrically and packaged to produce sufficient amount of electricity. PV cells can be used in wide range of applications such as providing power to satellites and other spacecraft, providing electricity to residential and commercial properties and charging automobile batteries. However, the use of solar energy as an economically competitive source of renewable energy is hindered by low efficiency in converting light energy into electricity.

What is needed therefore are photovoltaic devices and methods that provide increased efficiency in converting optical energy into electrical energy.

SUMMARY

There are disclosed interferometrically tuned photovoltaic cells wherein reflection from interfaces of layered PV devices coherently sum to produce an increased electric field in an active region of the photovoltaic cell where optical energy is converted into electrical energy. Such interferometrically tuned or interferometric photovoltaic devices (iPVs) increase the absorption of optical energy in the active region of the interferometric photovoltaic cell and thereby increase the efficiency of the device. There are disclosed photovoltaic devices, where, one or more optical resonant cavities and/or optical resonant layers are included in the photovoltaic device to increase the electric field concentration and the absorption in the active region. The optical resonant cavities and/or layers may comprise transparent non-conducting materials, transparent conducting material, air gaps, and combinations thereof. Other embodiments are also possible.

There is also disclosed a photovoltaic device comprises an active layer configured to produce an electrical signal as a result of light absorbed by the active layer. A reflector layer is disposed to reflect light transmitted through the active layer; and an optical resonance cavity is disposed between the active layer and the reflector layer. The presence of the optical resonance cavity can increase the amount of light absorbed by the active layer. In some embodiments, the optical resonance cavity may comprise a dielectric. In some embodiments, the optical resonance cavity may comprise an air gap. In certain embodiments, the optical resonance cavity may comprise a plurality of layers.

There is also disclosed a photovoltaic device comprises at least one active layer configured to produce an electrical signal as a result of light absorbed by the active layer. The photovoltaic device also comprises at least one optical resonance layer, wherein the at least one active layer has an absorption efficiency for wavelengths in the solar spectrum, and the absorption efficiency integrated over the wavelengths in the solar spectrum increases by at least about 20% with the presence of the at least one optical resonance layer.

There is also disclosed a photovoltaic device comprising an active layer configured to produce an electrical signal as a result of light absorbed by the active layer. The photovoltaic device also comprises at least one optical resonance layer, wherein the photovoltaic device has an overall conversion efficiency for wavelengths in the solar spectrum, and the overall conversion efficiency integrated over the wavelengths in the solar spectrum increases by at least about 15% by the presence of the at least one optical resonance layer.

There is also disclosed a photovoltaic device comprises an active layer configured to produce an electrical signal as a result of light absorbed by the active layer. The photovoltaic device further comprises an optical resonance layer, the optical resonance layer having a thickness such that the photovoltaic device has an overall conversion efficiency integrated over the solar spectrum that is greater than 0.7.

There is also disclosed a photovoltaic device comprises an active layer configured to produce an electrical signal as a result of light absorbed by the active layer. The photovoltaic device further comprises at least one optical resonant layer that increases the average electric field intensity in the active layer, wherein the active layer has an average electric field intensity therein for wavelengths in the solar spectrum when the photovoltaic device is exposed to sunlight. The presence of the at least one optical resonant layer produces an increase in the average electric field intensity integrated over the solar spectrum that is greater for the active layer than the increase in average electric field intensity integrated over the solar spectrum for any other layers in the photovoltaic device.

There is also disclosed a photovoltaic device comprises an active layer configured to produce an electrical signal as a result of light absorbed by the active layer. The active layer has an average electric field intensity and absorbed optical power therein for wavelengths in the solar spectrum when the photovoltaic device is exposed to sunlight. The photovoltaic device further comprises at least one optical resonant layer that increases the average electric field intensity and absorbed optical power in the active layer, wherein the presence of the at least one optical resonant layer produces an increase in the absorbed optical power integrated over the solar spectrum that is greater for the active layer than the increase in absorbed optical power integrated over the solar spectrum for any other layers in the photovoltaic device.

There is also disclosed a photovoltaic device comprises a substrate; an optical stack disposed on the substrate; and a reflector layer disposed on the optical stack. The optical stack further comprises at least one active layer and one or more layers; wherein the at least one active layer comprises an absorption efficiency greater than 0.7 for light at approximately 400 nm.

There is also disclosed a method of increasing light absorption inside an active layer in a photovoltaic device using interference principles comprises providing at least one active layer for absorbing light and converting it into electrical energy; and positioning at least one optically resonant layer with respect to the active layer, wherein interference principles of electromagnetic radiation increases absorption of solar energy in the at least one active layer by at least 5%, the absorption being integrated for wavelengths in the solar spectrum.

There is also disclosed a photovoltaic device comprises at least one active layer for absorbing electromagnetic radiation and converting it into electrical energy. The photovoltaic device further comprises at least one optically resonant layer disposed with respect to the active layer, wherein the optical resonance layer increases absorption of solar energy in the at least one active layer by at least 5% as a result of optical interference, the absorption being integrated across the solar spectrum.

There is also disclosed a photovoltaic device comprises an active layer configured to produce an electrical signal as a result of light absorbed by the active layer. A reflector layer is disposed to reflect light transmitted through the active layer, the reflector layer being partially optically transmissive such that the photovoltaic device is partially transmissive for some wavelengths. The photovoltaic device further comprises at least one optical resonance layer disposed between the active layer and the reflector layer, the presence of the at least one optical resonance layer increasing the amount of light absorbed by the active layer.

There is also disclosed a photovoltaic device comprises an active layer configured to produce an electrical signal as a result of light absorbed by the active layer. The photovoltaic device further comprises at least one optical resonance layer, the presence of the at least one optical resonance layer increasing the amount of light absorbed by the active layer, wherein the thickness of the at least one optical resonance layer is adjustable with application of a control signal for controlling the thickness.

There is also disclosed a method of optimizing absorption efficiency of a photovoltaic cell comprises providing a photovoltaic cell comprising a stack of layers, wherein at least one layer comprises at least one active layer, wherein providing a photovoltaic cell comprises using interference principles to optimize absorption efficiency of the at least one active layer in the photovoltaic cell at a plurality of wavelengths.

There is also disclosed a photovoltaic comprises a substrate; an optical stack disposed on the transparent substrate; and a reflector disposed on the substrate. The optical stack further comprises one or more thin film layers and an active layer optimized for absorbing a selected wavelength of light based upon a thickness of the one or more thin film layers, wherein the absorption of the active layer is optimized via an analysis of coherent summation of reflections from a plurality of interfaces.

There is also disclosed a photovoltaic device comprises first and second active layers configured to produce an electrical signal as a result of light absorbed by the active layers. The photovoltaic device further comprises a first optical resonance layer between the first and second active layers, the presence of the optical resonance layer increasing the amount of light absorbed by at least one of the first and second active layers.

There is also disclosed a photovoltaic device comprises a means for absorbing light. The light absorbing means is configured to produce an electrical signal as a result of light absorbed by the light absorbing means.

The means for reflecting light is disposed to reflect light transmitted through the at least one light absorbing means. The means for producing optical resonance is disposed between the light absorbing means and the light reflecting means. The optical resonance producing means is configured to increase the amount of light absorbed by the at least one light absorbing means, wherein the optical resonance producing means comprises means for electrically insulating.

There is also disclosed a method of manufacturing a photovoltaic device comprising providing an active layer, the active layer configured to produce an electrical signal as a result of light absorbed by the active layer. The method further comprises disposing a reflector layer to reflect light transmitted through the active layer; and disposing an optical resonance cavity between the active layer and the reflector layer. In one embodiment, the optical resonance cavity comprises a dielectric. In another embodiment, the optical resonance cavity comprises an air gap.

There is also disclosed a photovoltaic device comprises means for absorbing light. The light absorbing means is configured to produce an electrical signal as a result of light absorbed by the light absorbing means. The photovoltaic device further comprises means for reflecting light disposed to reflect light transmitted through the light absorbing means and means for producing optical resonance between the light absorbing means and the light reflecting means. The optical resonance producing means is configured to increase the amount of light absorbed by the at least one light absorbing means, wherein the optical resonance producing means comprising a plurality of means for propagating light therethrough.

There is also disclosed a method of manufacturing a photovoltaic device comprising providing an active layer, the active layer configured to produce an electrical signal as a result of light absorbed by the active layer. The method further comprises disposing a reflector layer to reflect light transmitted through the at least one active layer; and forming an optical resonance cavity between the active layer and the reflector layer, wherein the optical resonance cavity comprises a plurality of layers.

There is also disclosed a means for converting light energy into electrical energy comprising means for absorbing light, the light absorbing means being configured to produce an electrical signal as a result of light absorbed by the light absorbing means. The means for converting light energy into electrical energy further comprises means for reflecting light disposed to reflect light transmitted through the at least one light absorbing means; and means for producing optical resonance disposed between the light absorbing means and the light reflecting means, wherein the light absorbing means has an absorption efficiency for wavelengths in the solar spectrum, and the absorption efficiency integrated over the wavelengths in the solar spectrum increases by at least about 20% with the presence of the optical resonance producing means.

There is also disclosed a method of manufacturing a photovoltaic device comprising providing at least one active layer, the active layer being configured to produce an electrical signal as a result of light absorbed by the active layer. The method further comprises disposing a reflector layer to reflect light transmitted through the at least one active layer and disposing at least one optical resonance layer between the active layer and the reflector layer, wherein the at least one active layer has an absorption efficiency for wavelengths in the solar spectrum, and the absorption efficiency integrated over the wavelengths in the solar spectrum increases by at least about 20% with the presence of the at least one optical resonant layer.

There is also disclosed a means for converting light energy into electrical energy comprising means for absorbing light, the light absorbing means configured to produce an electrical signal as a result of light absorbed by the light absorbing means. The means for converting light energy into electrical energy further comprises means for reflecting light disposed to reflect light transmitted through the at least one light absorbing means; and means for producing optical resonance disposed between the light absorbing means and the light reflecting means. The means for converting light energy into electrical energy has an overall conversion efficiency for wavelengths in the solar spectrum, and the overall conversion efficiency integrated over the wavelengths in the solar spectrum increases by at least about 15% with the presence of the optical resonance producing means.

There is also disclosed a method of manufacturing a photovoltaic device comprising providing an active layer, the active layer configured to produce an electrical signal as a result of light absorbed by the active layer. The method further comprises disposing a reflector layer to reflect light transmitted through the at least one active layer; and disposing at least one optical resonance layer between the at least one active layer and the reflector layer. The photovoltaic device has an overall conversion efficiency for wavelengths in the solar spectrum, and the overall conversion efficiency integrated over the wavelengths in the solar spectrum increases by at least about 15% with the presence of the at least one optical resonant layer.

There is also disclosed a means for converting light energy into electrical energy comprises means for absorbing light, the light absorbing means configured to produce an electrical signal as a result of light absorbed by the light absorbing means. The means for converting light energy into electrical energy further comprises means for producing optical resonance, wherein the optical resonance producing means increases the average electric field intensity in the light absorbing means. The light absorbing means has an average electric field intensity for wavelengths in the solar spectrum therein when the means for converting light energy into electrical energy is exposed to sunlight. The presence of the optical resonance producing means produces an increase in the average electric field intensity integrated over the solar spectrum that is greater for the light absorbing means than the increase in average electric field intensity integrated over the solar spectrum for any other layers in the means for converting light energy into electrical energy.

There is also disclosed a method of manufacturing a photovoltaic device comprising providing an active layer, the active layer configured to produce an electrical signal as a result of light absorbed by the active layer. The method further comprises providing at least one optical resonance layer, wherein the optical resonance cavity increases the average electric field intensity in the active layer. The active layer has an average electric field intensity for wavelengths in the solar spectrum therein when the photovoltaic device is exposed to sunlight, and the presence of the at least one optical resonance layer produces an increase in the average electric field intensity integrated over the solar spectrum that is greater for the active layer than the increase in average electric filed intensity integrated over the solar spectrum for any other layers in the photovoltaic device.

There is also disclosed a means for converting light energy into electrical energy comprising means for absorbing light configured to produce an electrical signal as a result of light absorbed by the light absorbing means, the light absorbing means having an average electric field intensity and absorbed optical power therein for wavelengths in the solar spectrum when the means for converting light energy into electrical energy is exposed to sunlight. The means for converting light energy into electrical energy further comprises means for producing optical resonance which increases the average electric field intensity and absorbed optical power in the light absorbing means, wherein the presence of the optical resonance producing means produces an increase in the absorbed optical power integrated over the solar spectrum that is greater for the light absorbing means than the increase in absorbed optical power integrated over the solar spectrum for any other layers in the means for converting light energy into electrical energy.

There is also disclosed a method of manufacturing a photovoltaic device comprising providing an active layer, the active layer configured to produce an electrical signal as a result of light absorbed by the active layer, the active layer having an average electric field intensity and absorbed optical power for wavelengths in the solar spectrum therein when the photovoltaic device is exposed to sunlight. The method further comprises providing at least one optical resonance layer, wherein the optical resonance cavity increases the average electric field intensity and absorbed optical power in the active layer, wherein the presence of the at least one optical resonance layer produces an increase in the absorbed optical power integrated over the solar spectrum that is greater for the active layer than the increase in absorbed optical power integrated over the solar spectrum for any other layers in the photovoltaic device.

There is also disclosed a photovoltaic device comprising a means for supporting. The photovoltaic device further comprises a means for interacting with light disposed on the supporting means, the light interacting means comprising at least one means for absorbing light and one or more means for propagating light. The photovoltaic device also comprises a means for reflecting light disposed on the light interacting means, wherein the at least one light absorbing means comprises an absorption efficiency greater than 0.7 for light at approximately 400 nm.

There is also disclosed a method of manufacturing a photovoltaic device comprising providing a substrate. The method also comprises disposing an optical stack on the substrate, the optical stack comprising at least one active layer and one or more layers; and disposing a reflector layer on the optical stack, wherein the at least one active layer comprises an absorption efficiency greater than 0.7 for light at approximately 400 nm.

There is also disclosed a photovoltaic device comprising means for absorbing light, the light absorbing means configured to absorb light and convert the absorbed light into electrical energy. The photovoltaic device further comprises means for producing optical resonance, wherein interference principles of electromagnetic radiation increases absorption of solar energy in the light absorbing means by at least 5%, the absorption being integrated for wavelengths in the solar spectrum.

There is also disclosed a photovoltaic device comprising means for absorbing light configured to produce an electrical signal as a result of light absorbed by the means for absorbing light. The photovoltaic device further comprises a means for reflecting light disposed to reflect light transmitted through the at least one light absorbing means; and means for producing optical resonance between the light absorbing means and the light reflecting means, the presence of the optical resonance producing means increasing the amount of light absorbed by the light absorbing means, wherein the reflecting means is partially optically transmissive such that the means for converting light energy into electrical energy is partially transmissive for some wavelengths.

There is also disclosed a method of manufacturing a photovoltaic device comprising forming an active layer configured to produce an electrical signal as a result of light absorbed by the active layer; forming a reflector layer disposed to reflect light transmitted through the at least one active layer; and forming at least one optical resonance layer between the active layer and the reflector layer, the presence of the at least one optical resonance layer increasing the amount of light absorbed by the active layer, wherein the reflector layer is partially optically transmissive such that the photovoltaic device is partially transmissive for some wavelengths.

There is also disclosed a photovoltaic device comprising means for absorbing light configured to produce an electrical signal as a result of light absorbed by the light absorbing means. The photovoltaic device further comprises means for reflecting light disposed to reflect light transmitted through the at least one light absorbing means; and means for producing optical resonance disposed between the light absorbing means and the light reflecting means, the presence of the optical resonance producing means increasing the amount of light absorbed by the light absorbing means, wherein the thickness of the optical resonance producing means is adjustable with application of a control signal for controlling the thickness.

There is also disclosed a method of manufacturing a photovoltaic device comprising forming at least one active layer configured to produce an electrical signal as a result of light absorbed by the active layer. The method further comprises forming a reflector layer disposed to reflect light transmitted through the at least one active layer and forming at least one optical resonance layer between the at least one active layer and the reflector layer, the presence of the at least one optical resonance layer increasing the amount of light absorbed by the active layer, wherein the thickness of the at least one optical resonance layer is adjustable with application of a control signal for controlling the thickness.

There is also disclosed a photovoltaic device comprising first and second means for absorbing light configured to produce an electrical signal as a result of light absorbed by the first and second light absorbing means. The photovoltaic device further comprises first means for producing optical resonance. The presence of the first optical resonance producing means increasing the amount of light absorbed by the first and second light absorbing means.

There is also disclosed a method of manufacturing a photovoltaic device comprising forming first and second active layers configured to produce an electrical signal as a result of light absorbed by the first and second active layers and forming a first optical resonance layer, the presence of the first optical resonance layer increasing the amount of light absorbed by the first and second active layer.

BRIEF DESCRIPTION OF THE DRAWINGS

Examples disclosed herein are illustrated in the accompanying schematic drawings, which are for illustrative purposes only.

The embodiments falling under the scope of the claims comprise optical resonance producing means with means for electrically insulating which comprise air.

Figure 1 schematically illustrates an optical interferometric cavity.

Figure 2 schematically illustrates an optical interferometric cavity that increases reflected light.

Figure 3 is a block diagram of an interferometric modulator ("IMOD") stack comprising a plurality of layers including an absorber layer, an optical resonant cavity, and a reflector.

Figure 4A is a schematic illustration showing some of the reflections produced by a ray of light incident on the "IMOD" of Figure 3. Only a portion of the reflections are shown for illustrative purposes. For any given layer, however, the incident ray and the rays reflected from various interfaces within the IMOD can be coherently summed to determine the electric field intensity within that layer.

Figure 4B illustrates an IMOD in "open" state.

Figure 4C illustrates an IMOD in "closed" state.

Figures 5A-5D show the resultant spectral responses, e.g., reflection and absorption, of an interferometric light modulator in the "open" state for normally incident and reflected light.

Figures 6A-6D show the spectral responses of an interferomteric light modulator in the "closed" state for normally incident and reflected light.

Figures 7A-7D show the spectral responses of an interferometric light modulator in the "open" state when the angle of incidence or view angle is approximately 30 degrees.

Figures 8A-8D show the spectral responses of an interferometric light modulator in the "closed" state when the angle of incidence or view angle is approximately 30 degrees.

Figure 9 schematically illustrates a photovoltaic cell comprising a p-n junction.

Figure 10 is a block diagram that schematically illustrates a photocell with a p-i-n junction comprising amorphous silicon.

Figure 11A schematically illustrates another conventional PV cell.

Figure 11B-H schematically illustrates embodiments comprising PV cells that employ principles of the interferometric modulation to increase absorption in active regions of the PV cells thereby increasing efficiency.

Figures 11I-11J schematically illustrates embodiments comprising PV cells having optical resonant cavities having thicknesses that can be varied electrostatically.

Figure 12 schematically illustrates nomenclature used in calculating the electric field intensity in various layers of a PV cell.

Figure 13 is a flow diagram illustrating a method of fabricating a PV cell that employs principles of the IMOD to increase absorption in an active region of the PV cell.

Figure 14 is a graph of the modeled absorption in a $Cu(In,Ga)Se_2$ (CIGS) active layer for various designs of the PV cell.

Figure 15A is an example of a conventional PV cell comprising a p-i-n junction comprising a-Si-H surrounded by first and second indium tin oxide (ITO) layers and an aluminum (Al) reflector. Absorption and reflectivity spectra for a PV cell such as shown in Figure 15A having a 900 nm thick first ITO layer, a 330 nm thick $\alpha$-Si active layer and a 80 nm thick second ITO layer are provided below.

Figure 15B is a plot of the total absorption versus wavelength for the PV cell of Figure 15A.

Figure 15C is a plot of the total reflection versus wavelength for the PV cell of Figure 15A.

Figure 15D is a plot of the absorption in the active layer versus wavelength for the PV cell of Figure 15A.

Figure 15E is a plot of the absorption in the first ITO layer versus wavelength for the PV cell of Figure 15A.

Figures 15F-15G are plots of the absorption versus wavelength in the ITO layer and the reflector layer for the PV cell of Figure 15A.

Figure 16A is a contour plot showing the integrated absorption in the active layer of the photovoltaic device of Figure 15A as a function of the thicknesses of a first electrode and a second electrode. The integrated absorption comprises the absorption integrated over the solar spectrum.

Figures 16B-16C are plots of the absorption for the active layer and the total absorption, respectively, of an optimized version of the PV cell of Figure 15A that has a first ITO layer (54 nm thick), a $\alpha$-Si active layer (330 nm thick) and a second ITO layer (91 nm thick).

Figure 17 schematically illustrates a photovoltaic device disclosed by Krc et al comprising an active region comprising a Cu(In,Ga)Se$_2$ ("CIGS"), p-type layer and a CdS, n-type layer, wherein the Cu(In,Ga)Se$_2$ ("CIGS"), p-type layer and the CdS, n-type layer have not been optimized for maximum absorption efficiency.

Figures 18A-18C comprise a series of plots of modeled absorbance versus wavelength for the photovoltaic device of Figure 17 comprising a CIGS, p-type layer and a CdS, n-type layer.

Figures 19A-19B comprise diagrams of photovoltaic devices such as shown in Figure 17 after the addition of an optical resonant cavity between the active region and the reflective layer.

Figures 20A-20C illustrate a series of plots of modeled absorbance versus wavelength for the device shown in Figure 19A comprising an active region including a CIGS, p-type layer and a CdS, n-type layer and an optical resonant cavity that demonstrate the increased absorption in the active region compared to the device of Figure 17.

Figure 21 schematically illustrates a photovoltaic device having an active region surrounded above and below by conductive layers (an ITO layer and a metal layer) and having vias for electrical connection thereto, wherein the device further includes an optical resonant cavity that has been designed to interferometrically increase absorption in the active region.

Figure 22 schematically illustrates a photovoltaic device having an active region surrounded above and below by an optical resonant layer and a metal layer and having a via for electrical connection, wherein the device further includes an optical cavity that has been designed to interferometrically increase absorption in the active region.

Figure 23 schematically illustrates another photovoltaic device having an optical resonant cavity disposed between an active region and a metal layer and having vias for electrical connection, wherein the photovoltaic device has been designed to interferometrically increase absorption in the active region.

Figures 24 is a graph of modeled absorption in the CIGS, p-type layer of the photovoltaic device of Figure 23 over the wavelength range of approximately 400 nm to approximately 1100 nm showing an average of about 90% absorption in the active region between 500 nm and 750 nm.

Figure 25A schematically illustrates an embodiment of a photocell wherein the active layer of the photocell is disposed between an optical resonant cavity and an optical resonant layer.

Figure 25B schematically illustrates another embodiment similar to the photocell illustrated in Figure 25A wherein the resonant layer above the active layer comprises a dielectric and the resonant cavity below the active layer comprises an air gap or a dielectric and vias provide electric conduction through the air gap or dielectric.

Figure 25C schematically illustrates another embodiment wherein an ITO layer is disposed between the active layer and the resonant cavity.

Figure 26 schematically illustrates another embodiment of a simplified photocell having an optical resonant cavity between the active layer of the photocell and a reflector wherein no layer is shown on the active layers.

Figure 27 schematically illustrates a conventional multi-junction photovoltaic device.

Figure 28A schematically illustrates an embodiment of the multi-junction photovoltaic device such as illustrated in Figure 27 further comprising an optical resonant layer and an optical resonant cavity designed to interferometrically increase absorption in the active region.

Figure 28B schematically illustrates another embodiment similar to the multi-junction photocell illustrated in Figure 28A wherein the resonant cavity comprises an air gap or a dielectric and vias provide electric conduction through the air gap or dielectric.

Figure 29A schematically illustrates the multi-junction photovoltaic device illustrated in Figure 27 further comprising a plurality of optical resonant layers and an optical resonant cavity designed to interferometrically increase absorption in the active region.

Figure 29B schematically illustrates another embodiment similar to the multi-junction photocell illustrated in Figure 29A wherein the resonant cavity comprises an air gap or a dielectric and vias provide electric conduction through the air gap or dielectric.

Figure 30 schematically illustrates a conventional semi-transparent PV cell.

Figure 31 schematically shows a PV cell with a reflector having a reduced thickness that provides increased transparency.

Figure 32A schematically shows a semi-transparent multi-junction PV cell that includes an optical resonant layer but does not include an optical resonant cavity.

Figure 32B schematically shows a semi-transparent multi-junction PV cell similar to that shown in Figure 32A comprising a via to provide electrical connection.

DETAILED DESCRIPTION OF CERTAIN PREFERRED EMBODIMENTS

The following detailed description is directed to certain specific embodiments of the invention. However, the invention can be embodied in a multitude of different ways. In this description, reference is made to the drawings wherein like parts are designated with like numerals throughout. As will be apparent from the following description, the embodiments may be implemented in any device that comprises a photovoltaic material. MEMS devices may be coupled to photovoltaic devices as described herein below.

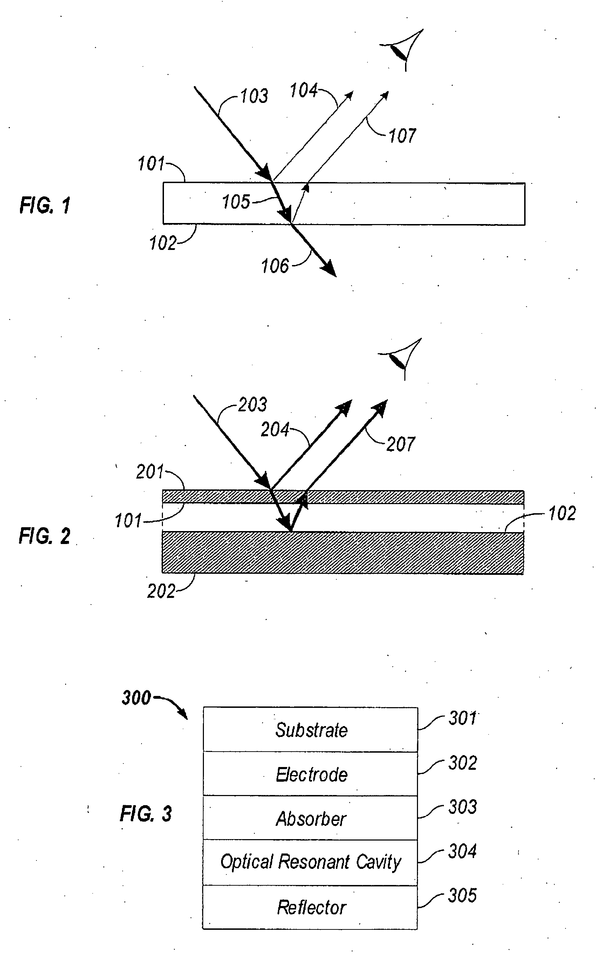

An optically transparent dielectric film or layer such as shown in Figure 1 is an example of an optical resonant cavity. The dielectric film or layer may comprise a dielectric material such as glass, plastic, or any other transparent material. An example of such an optical resonant cavity is a soap film which may form bubbles and produce a spectrum of reflected colors. The optical resonant cavity shown in Figure 1 comprises two surfaces 101 and 102. The two surfaces 101 and 102 may be opposing surfaces on the same layer. For example, the two surfaces 101 and 102 may comprise surfaces on a glass or plastic plate or sheet or a film. Air or another medium may surround the sheet or film.

A ray of light 103 that is incident on surface 101 of the optical resonant cavity is partially reflected (e.g., due to Fresnel reflection) as indicated by the light path 104 and partially transmitted through surface 101 along light path 105. The transmitted light may be partially reflected (e.g., again due to Fresnel reflection) along light path 107 and partially transmitted out of the resonant cavity along light path 106. The amount of light transmitted and reflected may depend on the refractive indices of the material comprising the optical resonant cavity and of the surrounding medium.

For purposes of the discussions provided herein, the total intensity of light reflected from the optical resonant cavity is a coherent superposition of the two reflected light rays 104 and 107. With such coherent superposition, both the amplitude and the phase of the two reflected beams contribute to the aggregate intensity. This coherent superposition is referred to as interference. Generally, the two reflected rays 104 and 107 may have a phase difference with respect to each other. In some embodiments, the phase difference between the two waves may be 180 degrees and cancel each other out. If the phase and the amplitude of the two light rays 104 and 107 are configured so as to reduce the intensity, then the two light beams are referred to as interfering destructively. If on the other hand, the phase and the amplitude of the two light beams 104 and 107 are configured so as to increase the intensity, then the two light rays are referred to as interfering constructively. The phase difference depends on the optical path difference of the two paths, which depends both on the thickness of the optical resonator cavity and the index of refraction and thus the material between the two surface 101 and 102. The phase difference is also different for different wavelengths in the incident beam 103. Accordingly, in some embodiments the optical resonant cavity may reflect a specific set of wavelengths of the incident light 103 while transmitting other wavelengths in the incident light 103. Thus, some wavelengths may interfere constructively and some wavelengths may interfere destructively. In general, the colors and the total intensity reflected and transmitted by the optical resonant cavity therefore depend on the thickness and the material comprising the optical resonant cavity. The reflected and transmitted wavelengths also depend on angle, with different wavelengths being reflected and transmitted at different angles.

In Figure 2, a top reflector layer 201 is deposited on the top surface 101 of the optical resonant cavity while a bottom reflector layer 202 is deposited on the bottom surface 102 of the optical resonant cavity. The thickness of the top and bottom reflector layers 201, 202 may be substantially different from each other. For example, in some embodiments, the top reflector layer 201 may be thinner than the bottom reflector layer 202. The reflector layers 201, 202 may comprise metal. As shown in Figure 2, the ray of light 203 that is incident on the top reflector layer 201 of the optical interference cavity is partially reflected from the optical interference cavity along each of the paths 204 and 207. The illumination field as viewed by an observer comprises a superposition of the two reflected rays 204 and 207. The amount of light substantially absorbed by the device or transmitted out of the device through the bottom reflector 202 can be significantly increased or reduced by varying the thickness and/or the composition of the reflector layers 201, 202. In the embodiment shown, the increased thickness of the bottom reflector 202 increases reflection of the optical resonant cavity 101.

In some embodiments, the dielectric (e.g. glass, plastic, etc.) between the top and bottom reflector layers 201, 202 may be replaced by an air gap. The optical interference cavity may reflect one or more specific colors of the incident light. The color or colors reflected by the optical interference cavity may depend on the thickness of the air gap. The color or colors reflected by the optical interference cavity may be changed by changing the thickness of the air gap.

In certain embodiments, the gap between the top and the bottom reflectors 201, 202 may be varied for example by a microelectromechanical systems (MEMS). MEMS include micro mechanical elements, actuators, and electronics. Micromechanical elements may be created using deposition, etching, and/or other micromachining processes that etch away or remove parts of substrates and/or deposited material layers or that add layers to form electrical and electromechanical devices. Such MEMS devices include interferometric modulators ("IMODs") having an optical resonant cavity that can be adjusted electrically. As used herein, the term interferometric modulator or interferometric light modulator refers to a device that selectively absorbs and/or reflects light using the principles of optical interference regardless of whether or not the device can be adjusted or whether movement within the device is possible (e.g. static IMOD). In certain embodiments, an interferometric modulator may comprise a pair of conductive plates, one of which is partially reflective and partially transmissive and the other of which is partly or totally reflective. The conductive plates are capable of relative motion upon application of an appropriate electrical signal. In a particular embodiment, one plate may comprise a stationary layer deposited on a substrate and the other plate may comprise a metallic membrane separated from the stationary layer by an air gap. As described herein in more detail, the position of one plate in relation to another can change the optical interference of light incident on the interferometric modulator. In this manner, the color of light output by the interferometric modulator can be varied.

Using this optical interference cavity it is possible to provide at least two states. There is also disclosed, for example, a first state comprises an optical interference cavity of a certain dimension whereby light of a selected color (based upon the size of the cavity) interferes constructively and is reflected out of the cavity. A second state comprises a visible black state produced either due to constructive and/or destructive interference of light, such that visible wavelengths are substantially absorbed.

Figure 3 is a diagram of an interferometric modulator stack 300. As illustrated, the IMOD stack 300 comprises a glass substrate 301, an electrode layer 302, and an absorber layer 303 on top thereof. The IMOD stack 300 also includes an Al reflector 305 such that an optical resonant cavity 304 is formed between the absorber layer 303 and the Al reflector 305. The Al reflector 305 may, for example, be about 300 nm thick in certain embodiments and the optical resonant cavity 304 may comprise an air gap. In some embodiments, the optical cavity may comprise one or more partially transparent conductors or partially transparent non-conductors. For example, in some embodiments, the optical interference cavity may comprise a transparent conducting layer such as an ITO layer or a nonconducting material such as for example a $SiO_2$ layer or both. In various embodiments, the optical resonant cavity can comprise a composite structure comprising one or more layers that may include an air gap, a transparent conducting material such as transparent conducting oxide, a transparent non-conducting material such as transparent non-conducting oxide or combinations thereof.

In the embodiment shown as Figure 3, light passes through the IMOD stack 300 first by passing through the glass substrate 301 and the electrode layer 302 into the absorber layer 303. Light not absorbed in the absorber layer 303 passes through the optical interference cavity 304 where the light is reflected off the Al reflector 305 back through the optical resonant cavity 304 into the absorber layer 303. Within the IMOD, the thickness of the air gap can be selected to produce a "bright" state for a given wavelength or wavelength range or a "dark" state for a given wavelength or wavelength range. In certain embodiments, in the "bright" state, the thickness of the optical resonant cavity 304 is such that the light exhibits a first interference in the absorber layer 303. In the "dark" state, the thickness of the optical resonant cavity 304 is such that light exhibits a second interference in the absorber layer 303. In some embodiments, the second interference is more constructive than the first interference (e.g. for visible wavelengths). The more constructive the interference in the absorption layer, the stronger the field and the greater is the absorption in the absorber layer 303.

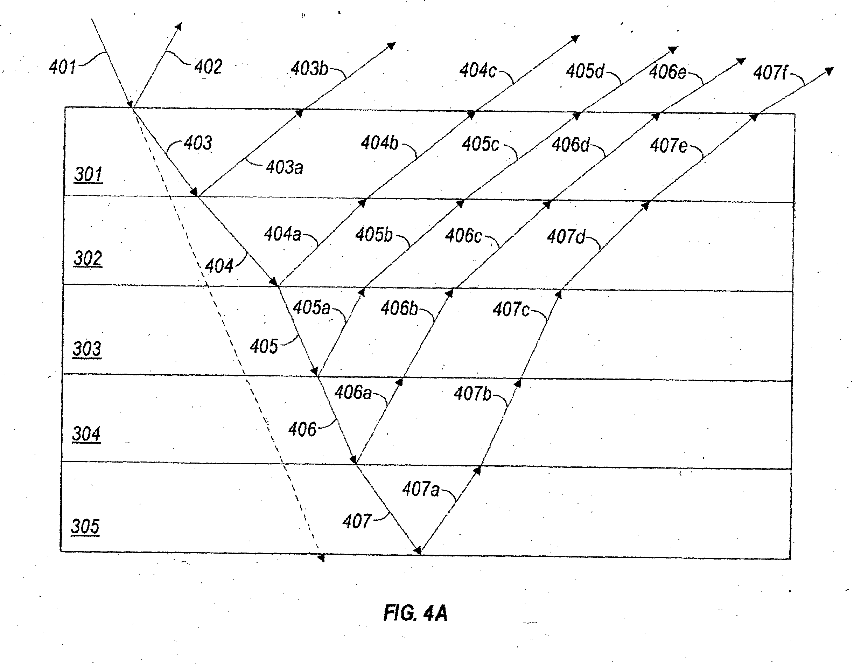

To illustrate how an IMOD can produce dark output, Figure 4A shows a light ray incident on the IMOD illustrated in Figure 3 and various reflections of that incident ray of light from different interfaces within the IMOD. These reflections comprise only a portion of the reflections that result from such an incident ray. For example, rays reflected from the various interfaces may again be reflected from other interfaces, yielding a large number of backward and forward reflections. For simplicity, however, only a portion of the reflections and reflected rays are illustrated.

In Figure 4A, for example, ray 401 comprises a ray of light incident on the IMOD structure. The incident ray of light 401 may have intensity $E_1$ and phase $\Phi_1$. Upon striking layer 301 of the IMOD, the incident ray of light 401 may be partially reflected as indicated by ray 402 and partially transmitted as indicated by ray 403. The reflected light 402 can have intensity $E_{1ar}$ and phase $\Phi_{1ar}$. The transmitted light 403 can have intensity $E_2$ and phase $\Phi_2$. The transmitted light 403 may be further partially reflected as indicated by ray of light 403a and partially transmitted as indicated by ray 404 at the surface of layer 302. The reflected light 403a can have intensity $E_{2ar}$ and phase $\Phi_{2ar}$. The transmitted light 404 can have intensity $E_3$ and phase $\Phi_3$. Similarly, the transmitted light 404 can be further partially reflected as indicated by ray of light 404a and partially transmitted as indicated by ray 405 on striking the top surface of layer 303. The reflected light 404a can have intensity $E_{3ar}$ and phase $\Phi_{3ar}$. The transmitted light 405 can have intensity $E_4$ and phase $\Phi_4$. The transmitted light 405 may be again further partially reflected as indicated by ray of light 405a and partially transmitted as indicated by ray 406 from the surface of layer 304. The reflected light 405a can have intensity $E_{4ar}$ and phase $\Phi_{4ar}$. The transmitted light 406 can have intensity $E_5$ and phase $\Phi_5$. The transmitted light 406 may be further partially reflected as indicated by ray of light 406a and partially transmitted as indicated by ray 407 at the surface of layer 305. The reflected light 406a can have intensity $E_{5ar}$ and phase $\Phi_{5ar}$. The transmitted light 407 can have intensity $E_6$ and phase $\Phi_6$. At the bottom surface of the reflector 305, the transmitted light indicated by ray 407 is almost completely reflected as indicated by ray of light 407a. The intensity of ray 407a can be $E_{6ar}$ and the phase can be $\Phi_{6ar}$.

The reflected rays 403a, 404a, 405a, 406a and 407a may be transmitted out of each of the layers of the IMOD and may be finally transmitted out of the device as indicated in Figure 4A. These rays are transmitted through additional interfaces and thus undergo additional Fresnel reflections. For example, reflected ray 403a is transmitted through the substrate 301 as represented by ray 403b. Reflected ray 404a is transmitted through the electrode 302 and substrate 301 (as shown by ray 404b) and exists as ray 404c. Likewise reflected ray 405a is transmitted through the absorber 303, the electrode 302 and the substrate 301 (as shown by rays 405b, 405c) and exits as ray 405d. Reflected ray 405a is transmitted through the absorber 303, the electrode 302 and the substrate 301 (as shown by rays 405b, 405c) and exits as ray 405d. Reflected ray 406a is transmitted through the optical resonant cavity 304, absorber 303, the electrode 302, and the substrate 301 (as shown by rays 406b, 406c, 406d) and exits as ray 405e. Reflected ray 407a is transmitted through the reflector 305, optical resonant cavity 304, absorber 303, the electrode 302, and the substrate 301 (as shown by rays 406b, 406c, 406d, 406e) and exits as ray 405f.

As described with reference to Figure 1, the intensity and the wavelength of light reflected from the IMOD structure as measured above the top surface of layer 301 comprises a coherent superposition of all the reflected rays 402, 403b, 404c, 405d, 406e and 407f such that both the amplitude and phase of each of the reflected rays is taken into consideration. Other reflected rays not shown in Figure 4A may also be included in the coherent superposition of rays. Similarly, the total intensity of light at any region within the IMOD structure, for example, within the absorber 403 can be calculated based on the field strengths of the reflected and transmitted waves. It is possible therefore to design the IMOD by varying the thickness and material of each layer such that the amount of light or field strength within given layers are increased or decreased using interference principles. This method of controlling the intensity and field strength levels within the different layers by varying the thicknesses and the materials of the layers can be used to increase or optimize the amount of light within the absorber and thus the amount of light absorbed by the absorber.

The description above is an approximation of the optical process. More details may be included in a higher order analysis. For example, as described above, only a single pass and the reflections generated were discussed above. Of course, light reflected from any of the layers may be again reflected backward toward another interface. Light may thus propagate multiple times within any of the layers including the optical resonant cavity 304. The effect of these additional reflections is not illustrated in Figure 4A although these reflections may be considered in the coherent superposition of rays. A more detailed analysis of the optical process may therefore be undertaken. Mathematical approaches can be used. For example, software can be employed to model the system. Certain embodiments of such software may calculate reflection and absorption and perform a multi-variable constrained optimization.

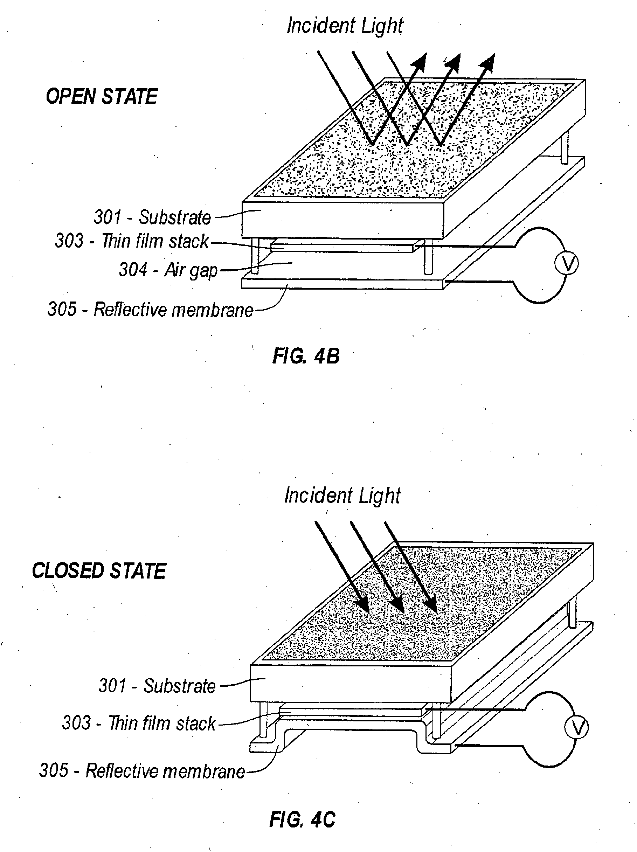

The IMOD stack 300 can be static. In a static IMOD stack, the thickness and the material of the various layers is fixed by the manufacture process. Some embodiments of a static IMOD stack include an air gap. In other embodiments, for example, instead of an air gap, the optical resonant cavity may comprise a dielectric or an ITO. The light output by the static IMOD stack 300, however, depends on the view angle, the wavelength of light incident thereon, and the interference condition at the viewing surface of the IMOD stack for that particular wavelengths incident thereon. By contrast, in a dynamic IMOD stack, the thickness of the optical resonant cavity 304 can be varied in real time using, for example, a MEMS engine, thereby altering the interference condition at the viewing surface of the IMOD stack. Similar to the static IMOD stack, the light output by the dynamic IMOD stack depends on the view angle, the wavelength of light, and the interference condition at the viewing surface of the IMOD stack. Figures 4B and 4C show dynamic IMOD's. Figure 4B illustrates an IMOD configured to be in the "open" state and Figure 4C illustrates an IMOD configured to be in the "closed" or "collapsed" state. The IMOD illustrated in Figures 4B and 4C comprises a substrate 301, a thin film layer 303 and a reflective membrane 305. The reflective membrane 305 may comprise metal. The thin film layer 303 may comprise an absorber. The thin film layer 303 may include an additional electrode layer and/or a dielectric layer and thus the thin film layer 303 may be described as a multilayer in some embodiments. In some embodiments, the thin film layer 303 may be attached to the substrate 301. In the "open" state, the thin film layer 303 is separated from the reflective membrane 305 by a gap 304. In some embodiments, for example, as illustrated in Figure 4B, the gap 304 may be an air gap. In the "open" state, the thickness of the gap 304 can vary, for example, between 120 nm and 400 nm (e.g., approximately 260 nm) in some embodiments. In certain embodiments, the IMOD can be switched from the "open" state to the "closed" state by applying a voltage difference between the thin film stack 303 and the reflective membrane 305. In the "closed" state, the gap between the thin film stack 303 and the reflective membrane 305 is lesser than the thickness of the gap in the "open" state. For example, the gap in the "closed" state can vary between 30 nm and 90 nm (e.g., approximately 90nm) in some embodiments. The thickness of the air gap in general can vary between approximately 0 nm and approximately 2000 nm, for example, between "open" and "closed" states in some embodiments. Other thicknesses may be used in other embodiments.

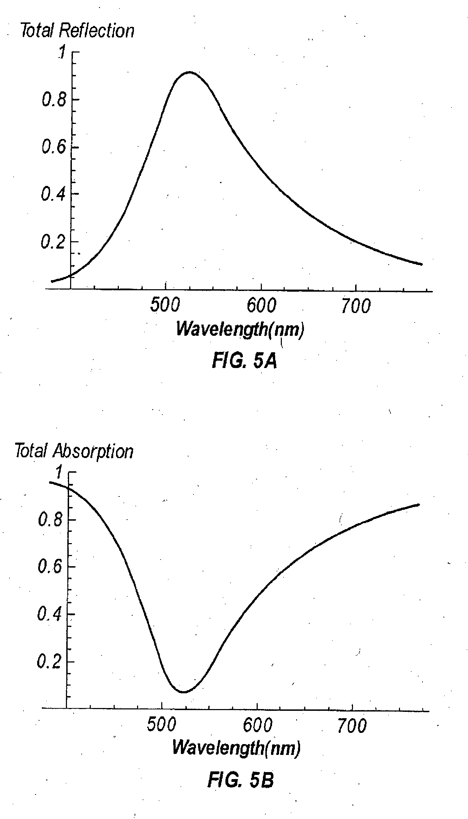

In the "open" state, one or more frequencies of the incident light interfere constructively above the surface of the substrate 301 as described with reference to Figure 4A. Accordingly, some frequencies of the incident light are not substantially absorbed within the IMOD but instead are reflected from the IMOD. The frequencies that are reflected out of the IMOD interfere constructively outside the IMOD. The display color observed by a viewer viewing the surface of the substrate 301 will correspond to those frequencies that are substantially reflected out of the IMOD and are not substantially absorbed by the various layers of the IMOD. The frequencies that interfere constructively and are not substantially absorbed can be varied by changing the thickness of the gap. The reflected and absorbed spectra of the IMOD and the absorption spectrum of certain layers therein are shown in Figures 5A-5D for light normally incident on the IMOD when in the "open" state.

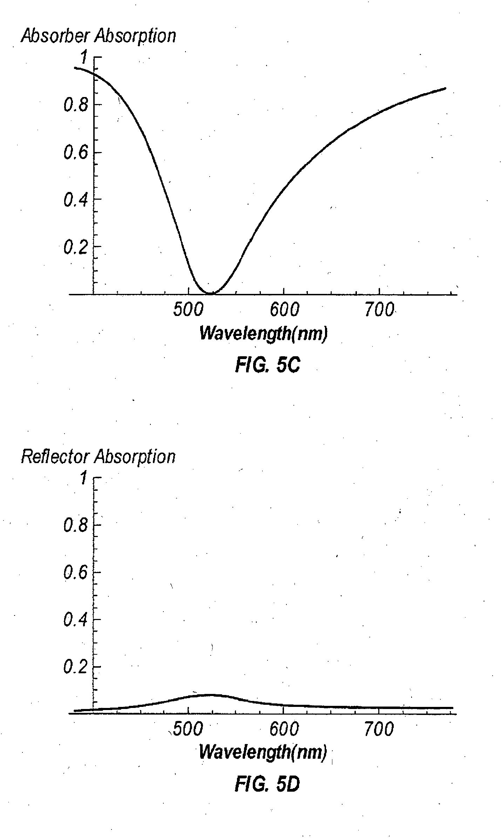

Figure 5A illustrates a graph of total reflection of the IMOD (for example, IMOD 300 of Figure 3) in the "open" state as a function of the wavelength viewed at normal incidence when light is directed on the IMOD at normal incidence. The graph of total reflection shows a reflection peak at approximately 550 nm (for example, yellow). A viewer viewing the IMOD will observe the IMOD to be yellow. As mentioned previously, the location of the peak of the total reflection curve can be shifted by changing either the thickness of the air gap or by changing the material and/or thickness of one or more other layers in the stack. For example, the total reflection curve can be shifted by changing the thickness of the air gap. Figure 5B illustrates a graph of total absorption of the IMOD over a wavelength range of approximately 400 nm to 800 nm. The total absorbance curve shows a valley at approximately 550 nm corresponding to the reflection peak. Figure 5C illustrates a graph of absorption in the absorber layer (for example, layer 303 of Figure 3) of the IMOD over a wavelength range of approximately 400 nm to 800 nm. Figure 5D illustrates absorption in the reflector layer (for example, 305 of Figure 3) of the IMOD over a wavelength range of approximately 400 nm to 800 nm. The energy absorbed by the reflector is low. The total absorption curve is obtained by a summation of the absorption curve in the absorber portion of the IMOD 400 and the absorption curve in the reflector portion of the IMOD if the absorption in the other layers is negligible. It should be noted that the transmission through the IMOD stack is substantially negligible since the lower reflector (e.g., 305 of Figure 3) is substantially thick.

Referring to Figure 4C, in the "closed" state, the IMOD absorbs almost all frequencies of the incident visible light in the thin film stack 303. Only a small amount of the incident light is reflected. The display color observed by a viewer viewing the surface of the substrate 301 may generally be black, reddish black or purple in some embodiments. The frequencies absorbed in the thin film stack 303 may be changed or "tuned" by changing the thickness of the gap.

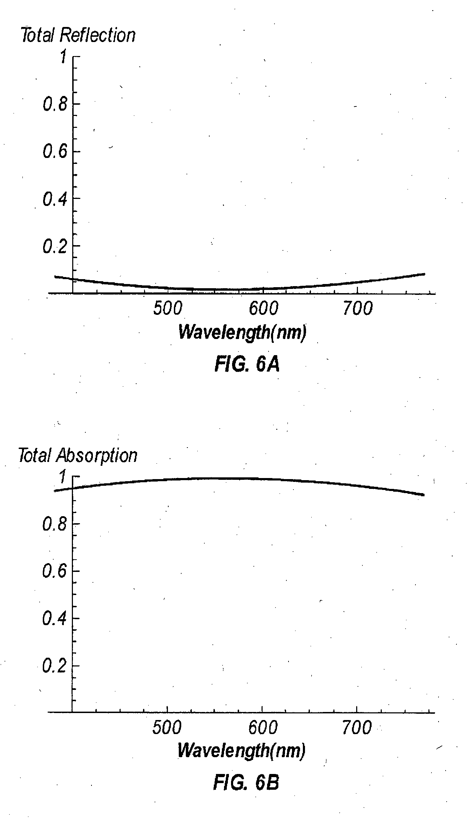

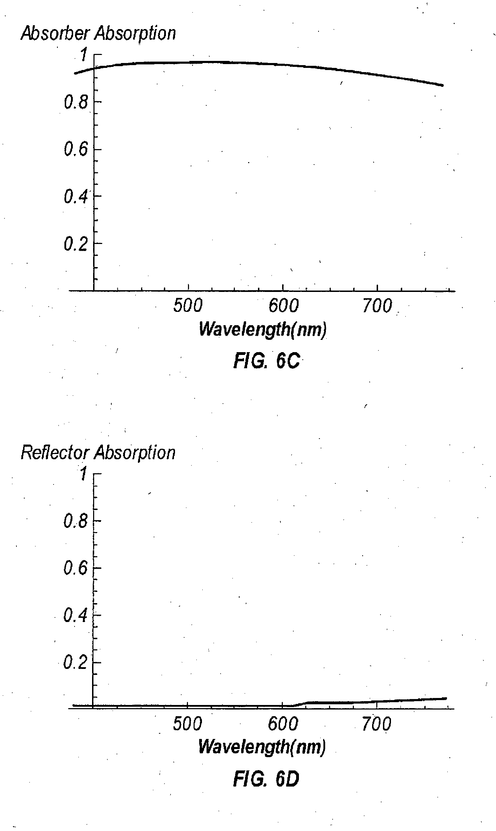

The spectral response of the various layers of the IMOD in the "closed" state for normally incident light viewed normal to the IMOD is shown in Figures 6A-6D. Figure 6A illustrates a graph of total reflection of the IMOD versus wavelength over a wavelength range of approximately 400 nm to 800 nm. It is observed that the total reflection is uniformly low in the entire wavelength range. Thus very little light is reflected out of the interferometric modulator. Figure 6B illustrates a graph of total absorbance of the IMOD over a wavelength range of approximately 400 nm to 800 nm. The total absorbance curve indicates approximately uniform absorbance in the entire wavelength range corresponding to the graph of total reflectance. Figure 6C illustrates a graph of absorption in the absorber layer over a wavelength range of approximately 400 nm to 800 nm. Figure 6D illustrates absorption in the reflector layer of the IMOD over a wavelength range of approximately 400 nm to 800 nm. It is noted from Figure 6A that in the "closed" state, the IMOD exhibits relatively low total reflection as compared to the total reflection in Figure 5A. Additionally, the IMOD exhibits a relatively high total absorbance and absorbance in the absorber layer in the "closed" state (Figure 6B and Figure 6C respectively) in contrast to the "open" state (Figure 5B and Figure 5C). Reflector absorption is relatively low in the IMOD both when the IMOD is in the "open" state (Figure 5D) or in the "closed" state (Figure 6D). Accordingly, much of the field strength is within the absorber layer where the light is being absorbed.

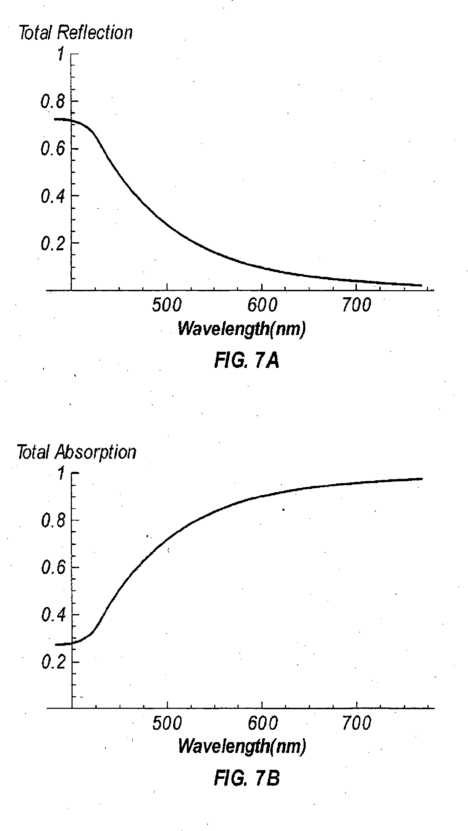

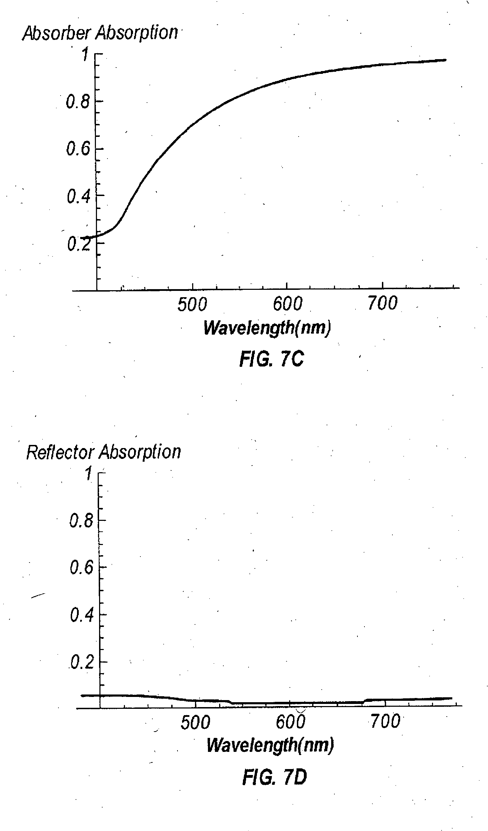

Generally, the IMOD stack has a view angle dependency that may be taken into consideration during the design stage. More generally, the spectral response of the IMOD can depend on the angle of incidence and the view angle. Figures 7A-7D illustrate a series of graphs of modeled absorbance and reflection versus wavelength for the IMOD in an "open" state position when the angle of incidence or view angle is 30 degrees with respect to the normal of the stack. Figure 7A illustrates a graph of total reflection of the IMOD versus wavelength for the IMOD over a wavelength range of approximately 400 nm to 800 nm. The graph of total reflection shows a reflection peak at approximately 400 nm. Comparing Figure 7A and Figure 5A indicates that the graph of total reflection versus wavelength is shifted along the wavelength axis, when the angle of incidence or view angle changes from normal incidence to 30 degrees. Figure 7B illustrates a graph of total absorbance over a wavelength range of approximately 400 nm to 800 nm for the IMOD. The total absorbance curve shows a valley at approximately 400 nm corresponding to the reflection peak. A comparison of Figure 7B with 5B indicates that the valley in the absorption curve is shifted along the wavelength axis as well when the angle of incidence or view angle changes from normal incidence to 30 degrees. Figure 7C illustrates a graph of absorption in the absorber (for example, 303 of Figure 3) of the IMOD over a wavelength range of approximately 400 nm to 800 nm. Figure 7D illustrates absorption in the reflector (for example, 305 of Figure 3) of the IMOD over a wavelength range of approximately 400 nm to 800 nm.

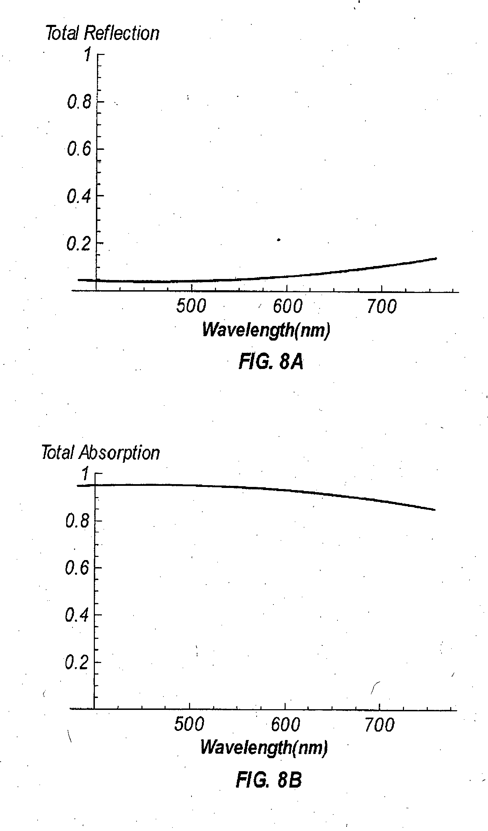

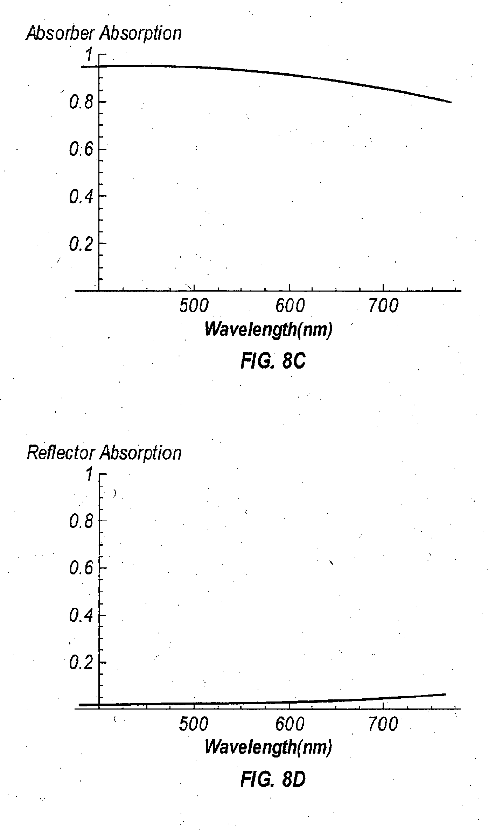

Figures 8A-8D illustrate a series of graphs of modeled absorbance and reflection versus wavelength for the IMOD of Figure 4A in a "closed" state position when the angle of incidence or view angle is 30 degrees. Figure 8A illustrates a graph of total reflection of the IMOD versus wavelength for the IMOD over a wavelength range of approximately 400 nm to 800 nm. It is observed that the total reflection is uniformly low in the entire wavelength range. Thus very little light is reflected out of the interferometric modulator. Figure 8B shows a graph of total absorbance over a wavelength range of approximately 400 nm to 800 nm. The total absorbance curve indicates approximately uniform absorbance over the entire wavelength range corresponding to the graph of total reflectance. Figure 8C illustrates a graph of absorption in the absorber layer over a wavelength range of approximately 400 nm to 800 nm. Figure 8D illustrates absorption in the reflector layer of the IMOD over a wavelength range of approximately 400 nm to 800 nm. A comparison of Figures 6A-6D and Figures 8A-8D shows that the spectral response of the IMOD in the "closed" state is approximately the same for normal incidence and when the angle of incidence or view angle is 30 degrees. Therefore it can be inferred that the spectral response of the IMOD in the "closed" state does not exhibit a strong dependency on the angle of incidence or the view angle.

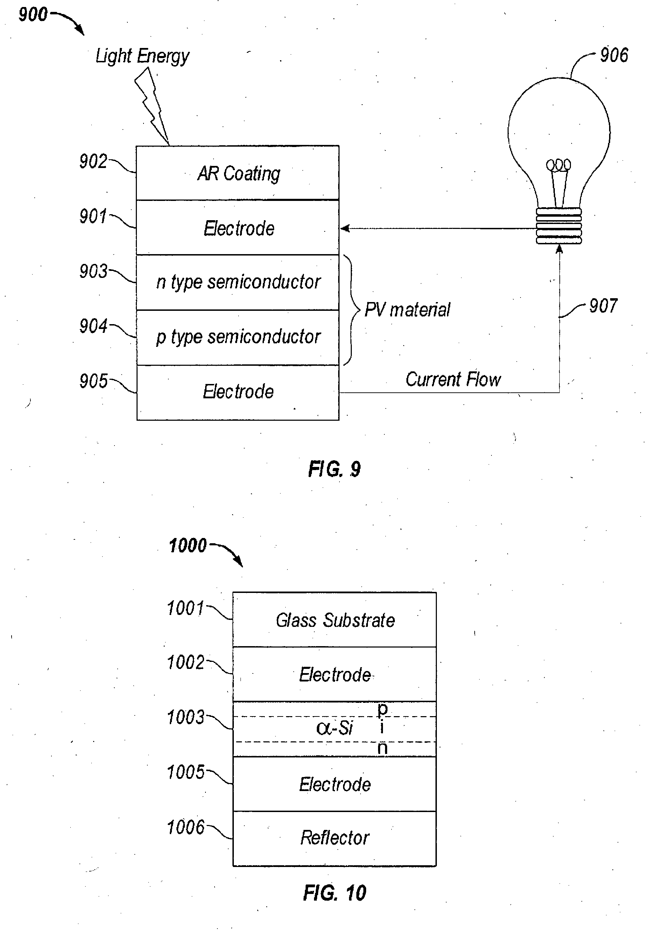

Figure 9 shows a typical photovoltaic cell 900. A typical photovoltaic cell can convert light energy into electrical energy. A PV cell is an example of a renewable source of energy that has a small carbon footprint and has less impact on the environment. Using PV cells can reduce the cost of energy generation and provide possible cost benefits.

PV cells can have many different sizes and shapes, e.g., from smaller than a postage stamp to several inches across. Several PV cells can often be connected together to form PV cell modules that may be up to several feet long and a few feet wide. The modules can include electrical connections, mounting hardware, power-conditioning equipment, and batteries that store solar energy for use when the sun is not shining. Modules, in turn, can be combined and connected to form PV arrays of different sizes and power output. The size of an array can depend on several factors, such as the amount of sunlight available in a particular location and the needs of the consumer.

A photocell has an overall energy conversion efficiency ($\eta$, "eta") that may be determined by measuring the electrical power output from a photocell and the optical power incident on the solar cell and computing the ratio. According to one convention, the efficiency of the solar cell can be given by the ratio of the amount of peak electrical power in Watts produced by a photocell having

$1m^2$ of surface area that is exposed to the standard solar radiation (known as the "air mass 1.5"). The standard solar radiation is the amount of solar radiation at the equator at noon on a clear March or September equinox day. The standard solar radiation has a power density of 1000 watts per square meter.

A typical PV cell comprises an active region disposed between two electrodes and may include a reflector. The reflector may have a reflectivity of greater than 50%, 60%, 70%, 80%, 90% or more in some embodiments. The reflector may have lower reflectivity in other embodiments. For example, the reflectivity may be 10%, 20%, 30%, 40% or more. In some embodiments, the PV cell additionally comprises a substrate as well. The substrate can be used to support the active layer and electrodes. The active layer and electrodes, for example, may comprise thin films that are deposited on the substrate and supported by the substrate during fabrication of the photovoltaic device and/or thereafter. The active layer of a PV cell may comprise a semiconductor material such as silicon. In some embodiments, the active region may comprise a p-n junction formed by contacting an n-type semiconductor material 903 and a p-type semiconductor material 904 as shown in Figure 9. Such a p-n junction may have diode like properties and may therefore be referred to as a photodiode structure as well.

The layers 903 and 904 are sandwiched between two electrodes that provide an electrical current path. The back electrode 905 can be formed of aluminum or molybdenum or some other conducting material. The back electrode can be rough and unpolished. The front electrode 901 is designed to cover a large portion of the front surface of the p-n junction so as to lower contact resistance and increase collection efficiency. In embodiments wherein the front electrode is formed of an opaque material, the front electrode may be configured to have holes or gaps to allow illumination to impinge on the surface of the p-n junction. In such embodiments, the front electrode can be a grid or configured in the shape of a prong or fingers. In some other embodiments, the electrodes can be formed from a transparent conductor, for example, transparent conducting oxide (TCO) such as tin oxide ($SnO_2$) or indium tin oxide (ITO). The TCO can provide good electrical contact and conductivity and simultaneously be optically transmissive to the incoming light. In some embodiments, the PV cell can also comprise a layer of anti-reflective (AR) coating 902 disposed over the front electrode 901. The layer of AR-coating 902 can reduce the amount of light reflected from the surface of the n-type layer 903 shown in Figure 9.

When the surface of the p-n junction is illuminated, photons transfer energy to electrons in the active region. If the energy transferred by the photons is greater than the band-gap of the semiconducting material, the electrons may have sufficient energy to enter the conduction band. An internal electric field is created with the formation of the p-n junction. The internal electric field operates on the energized electrons to cause these electrons to move thereby producing a current flow in the external circuit 907. The resulting current flow can be used to power various electrical devices such as a light bulb 906 as shown in Figure 9.

The efficiency at which optical power is converted into electrical power corresponds to the overall efficiency as described above. The overall efficiency depends at least in part on the efficiency at which light is absorbed by the active layer. This efficiency, referred to herein by the absorption efficiency, $\eta_{abs}$, is proportional to the index of refraction, n, the extinction coefficient, k, and the square of the electric field amplitude, $|E(x)|^2$, in the active layer shown by the relationship set forth below,

$$\eta_{abs} \propto n \times k \times |E(x)|^2$$

The value, n, is the real part of the complex index of refraction. The absorption or extinction coefficient k is generally the imaginary part of the complex index of refraction. The absorption efficiency, $\eta_{abs}$, can thus be calculated based on the material properties of the layer and the electric field intensity in the layer (e.g., active layer). The electric field intensity for a particular layer may be referred to herein as the average electric field intensity wherein the electric field is averaged across the thickness of the particular layer.

As described above, light absorbed in the active layer generates free carriers, e.g., electron hole pairs, that may be used to provide electricity. The overall efficiency or overall conversion efficiency depends in part on the efficiency at which these electrons and holes generated in the active material are collected by the electrodes. This efficiency is referred to herein as collection efficiency, $\eta_{collection}$. Thus, the overall conversion efficiency depends on both the absorption efficiency, $\eta_{abs}$, and the collection efficiency, $\eta_{collection}$.

The absorption efficiency $\eta_{abs}$ and the collection efficiency $\eta_{collection}$ of the PV cell are dependent on a variety of factors. The thickness and material used for the electrode layers 901 and 905, for example, can affect both the absorption efficiency $\eta_{abs}$ and the collection efficiency $\eta_{collection}$ simultaneously. Additionally, the thickness and the material used in the PV material 903 and 904 can affect the absorption and collection efficiencies.

The overall efficiency can be measured by placing probes or conductive lead to the electrode layers 901 and 905. The overall efficiency can also be calculated using a model of the photovoltaic device.

As used herein, these efficiencies are for standard solar radiation - air mass 1.5. Also, the electric field, absorption efficiencies, etc. may be integrated for wavelengths over the solar spectrum. The solar spectrum is well known and comprises the wavelengths of light emitted by the sun. These wavelengths include visible, UV, and infrared wavelengths. In some embodiments, the electric field, absorption efficiency, overall efficiency etc.

are integrated over a portion of the solar spectrum, for example, over the visible range of wavelengths, infrared range of wavelengths or the ultraviolet wavelength range. In certain embodiments, the electric field, absorption efficiency, overall efficiency etc. are computed over smaller wavelength ranges e.g. ranges having a bandwidth of 10 nm, 100 nm, 200 nm, 300 nm, 400 nm, 500 nm or 600 nm, etc.

In some embodiments, the p-n junction shown in Figure 9 can be replaced by a p-i-n junction wherein an intrinsic semiconducting or un-doped semiconducting layer is sandwiched between a p-type and a n-type semiconductor. A p-i-n junction may have higher efficiency than a p-n junction. In some other embodiments, the PV cell can comprise multi-junctions.

The active region can be formed of a variety of light absorbing materials such as crystalline silicon (c-Silicon), amorphous silicon ($\alpha$-silicon), cadmium telluride (CdTe), copper indium diselenide (CIS), copper indium gallium diselenide (CIGS), light absorbing dyes and polymers, polymers having light absorbing nanoparticles disposed therein, III-V semiconductors such as GaAs etc. Other materials may also be used. The light absorbing material where photons are absorbed and transfer energy for example to electrons is referred to herein as the active layer of the PV cell. The material for the active layer can be chosen depending on the desired performance and the application of the PV cell.

In some embodiments, the PV cell can be formed by using thin film technology. For example, in one embodiment, the PV cell may be formed by depositing a first layer of TCO on a substrate. A layer of active material (or light absorbing material) is deposited on the first TCO layer. A second TCO layer can be deposited on the layer of active material. In some embodiments, a layer of AR coating can be deposited over the second TCO layer. The layers may be deposited using deposition techniques such as physical vapor deposition techniques, chemical vapor deposition techniques, electro-chemical vapor deposition techniques etc. Thin film PV cells may comprise polycrystalline materials such as thin-film polycrystalline silicon, CIS, CdTe or CIGS. Some advantages of thin film PV cells are small device footprint and scalability of the manufacturing process, among others.

Figure 10 is a block diagram schematically illustrating a typical thin film PV cell 1000. The typical PV cell 1000 includes a glass substrate 1001 through which light can pass. Disposed on the glass substrate 1001 is a first transparent electrode layer 1002, a layer 1003 of PV material comprising amorphous silicon, a second transparent electrode layer 1005 and a reflector 1006 comprising aluminum or some other metal such as Mo, Ag, Au, etc.. The second transparent electrode layer 1005 can comprise ITO. Portions of the active material maybe doped to form a n-type region and a p-type region and a portion of the active material maybe undoped to create a p-i-n structure. In one design, the thickness of the first transparent electrode layer can be approximately 900 nm while the thickness of the PV material can be approximately 330 nm. In one design, the second transparent electrode layer 1005 has a thickness of approximately 80 nm and the reflector 1006 has a thickness of approximately 300 nm. As illustrated, the first transparent electrode layer 1003 and the second transparent electrode layer 1005 sandwich the amorphous silicon layer 1003 therebetween. The reflector layer 1006 is disposed on the second transparent electrode layer 1005. In a PV cell, photons are absorbed in the active or absorber layer and some of the absorbed photons can produce electron-hole pairs.

Comparing Figure 10 and Figure 3, it is observed that the structure of an IMOD and the typical PV device have similarities. For example, the IMOD illustrated in Figure 3 and the PV cell illustrated in Figure 10 each comprise a stacked structure comprising multiple layers. Both the IMOD and the PV device also comprise a light absorbing layer (for example, 303 of Figure 3 and 1003 of Figure 10) disposed on a substrate (for example, 301 of Figure 3 and 1001 of Figure 10). The light absorbing layer can be selected to have similar properties for both IMOD and the PV cell. Both the IMOD of Figure 3 and PV cell of Figure 10 comprise a reflector (for example, 305 of Figure 3 and 1006 of Figure 10). Thus, it is conceivable that the ability to tune an IMOD to provide for the desired distribution of electric field in the various layers thereof and the resultant output can be applied to a PV device. For example, an optical resonant cavity can be included below the active layer (e.g. the light absorbing layer 1003 of Figure 10) to tune the PV device to decrease absorption in all layers except the active or absorbing layer 1003 to increase absorption in the active or absorbing layer 1003 and in some sense, the IMOD can be said to be incorporated into the PV cell or vice versa.

In a conventional PV cell such as the one illustrated in Figure 10, the absorption in the PV material layer 1003 has been conventionally believed to be enhanced by the introduction of layer 1005. Accordingly, the second transparent electrode 1005 has been referred to as a reflection enhancement layer. It is also conventionally believed that the absorption in the active layer increases linearly with the thickness of the second transparent electrode layer 1005 (see for e.g. "Light-Trapping in a-Si Solar Cells: A Summary of the Results from PV Optics", B. L. Sopori, et.al., National Center for Photovoltaics Program Review Meeting, Denver, Colorado, September 8-11, 1988). In general, the inclusion of layer 1005 does not increase the reflection of the reflector layer 1006. Further, the absorption in the active layer does not necessarily increase linearly with the thickness of the second transparent electrode layer 1005 as conventionally believed. As is demonstrated below, in general the thickness of the first electrode layer 1002 and the second electrode layer 1005 can have an optimal point at which absorption is maximized.

Additionally, in some conventional designs, the thickness of the electrode layer 1005 and the reflector layer 1006 is varied to minimize the total amount of light reflected from the PV cell. The assumption is that if light is not reflected from the PV cell, this light is absorbed and the overall efficiency of the photovoltaic device is increased. To this end, the surface of the reflector 1006 may be roughened to be more diffuse to reduce specular reflection from the reflector. These methods can potentially produce a PV cell that looks black. However, the above described methods directed to reducing reflection from the PV device and producing a PV cell that looks black alone may be insufficient to increase the absorption in the absorbing or active layer 1003 and thus may be insufficient to increase the efficiency of the photovoltaic device.

The success of such conventional approaches to increasing efficiency of the PV cell have been limited. As described above, however, interference principles can be used to "tune" the one or more layers in the PV device and optimize the PV cell such that more light can be absorbed by the absorbing layer 1003. For example, the principles of interference used in the design of IMODs can be applied to the fabrication of PV cell. Optical resonant cavities that produce electric field resonances in the active layer, can be included in the PV cell thereby increasing electric field strength and absorption in the active layer. As will be shown, for example, increasing absorption in the active layer (or light absorbing layer 1003) can be accomplished by replacing the second transparent electrode layer 1005 with an optical resonant cavity comprising an air gap or a transparent non-conducting dielectric such as $SiO_2$. By replacing the transparent electrode layer 1005 with an optical resonant cavity, the reflection of the reflector is not necessarily enhanced, however, the optical resonant cavity comprises a low absorption layer that can interferometrically increase absorption in the active layer.

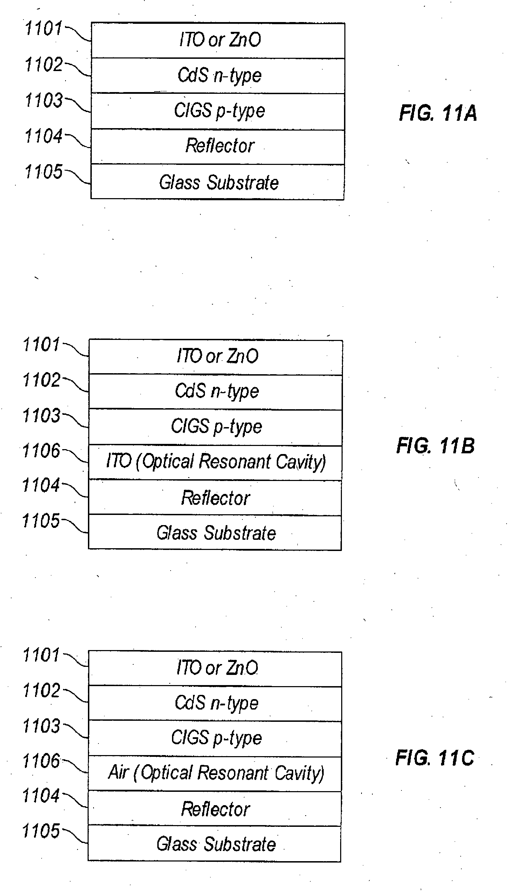

To demonstrate how the efficiency of a solar cell can be increased, a conventional solar cell design shown in Figure 11A is studied. Figure 11A illustrates a PV cell comprising a $Cu(In,Ga)Se_2$ 'CIGS/CdS' PV stack. The PV cell comprises an ITO or ZnO conducting electrode layer 1101, a layer 1102 of n-type material comprising CdS, a layer 1103 of p-type material comprising CIGS, a reflector layer 1104 comprising Mo and a glass substrate 1105. As described above, the efficiency of the PV cell illustrated in Figure 11A can be increased by incorporating the IMOD structure and the principles of interference exploited by IMOD into the PV cell. This can be accomplished by introducing a static or dynamic optical resonant layer as shown in the Figures 11B-11H. In various embodiments, the optical resonant layer introduces electric resonances in the active layer thereby increase the average electric field therein. In the description below the following naming convention is adopted for clarity. An optical resonant layer sandwiched between an absorbing layer and a reflector layer is referred to as 'optical resonant cavity' whereas an optical resonant layer disposed elsewhere in the stack is referred to as an 'optical resonant layer'. The terms resonant and resonance in describing cavities or layers may be used interchangeably herein.

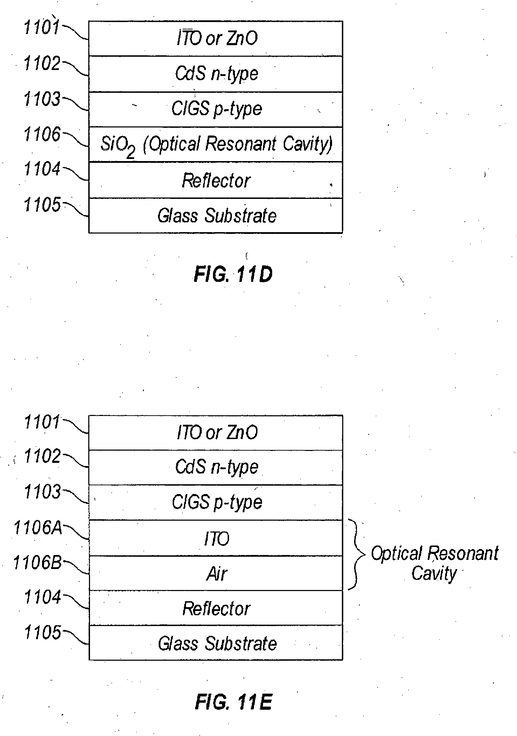

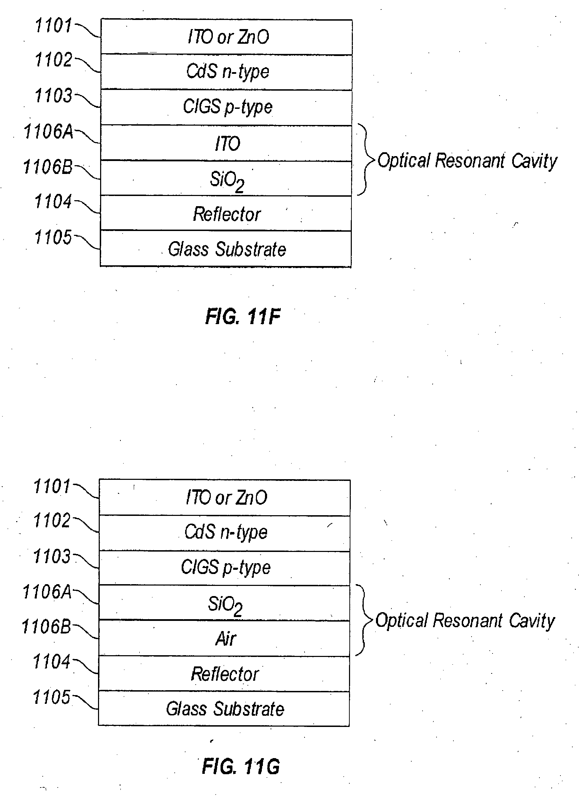

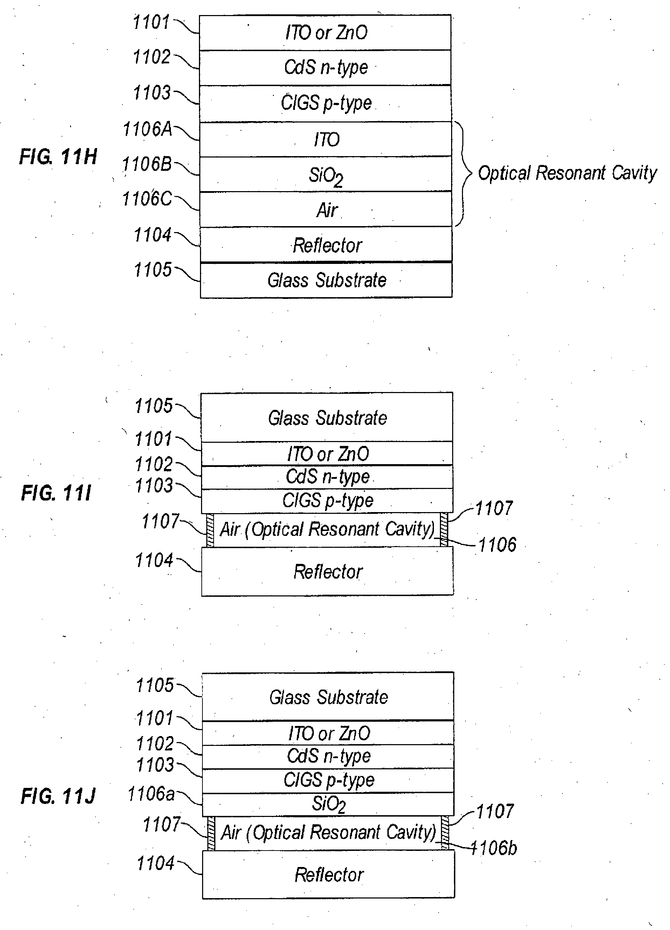

In Figure 11B, an optical resonant cavity 1106 comprising an ITO is sandwiched between the active or absorbing material (layers 1102 and 1103) and the reflector layer 1104. In the embodiment illustrated in Figure 11C, the optical resonant cavity 1106 comprises a hollow region. In some embodiments as shown in Figure 11C, the hollow region comprises air or other gases. Replacing the ITO layer with an air gap can, with the exception of the active layer, decrease the absorption in all layers (for example, including the optical resonant cavity). For some embodiments, the choice of material for the optical resonant cavity can thus be important. For example, an embodiment wherein the optical resonant cavity comprises air or $SiO_2$ as shown in Figure 11D may increase the absorption in the active layer more than an optical resonant cavity comprising ITO as shown in 11B. The embodiments illustrated in Figures 11B-11D comprise an optical resonant cavity comprising a single material or medium through which light propagates. In various embodiments such as shown in Figures 11E-11H the interferometrically tuned photovoltaic (iPV) cells can comprise a composite optical resonant cavity comprising two or more layers. For example, in the embodiment illustrated in Figure 11E, the optical resonant cavity comprises an ITO layer 1106a and an air layer 1106b. The embodiment shown in Figure 11F comprises a composite optical resonant cavity comprising an ITO layer 1106a and a $SiO_2$ layer 1106b. The embodiment shown in Figure 11G comprises a composite optical resonant cavity comprising a $SiO_2$ layer 1106a and an air gap 1106b. The embodiment shown in Figure 11H can comprise an ITO layer 1106a, a $SiO_2$ layer 1106b and an air gap 1106c. Accordingly, in various embodiments, the optical resonant cavity and other optical resonant layers may comprise one or more transparent conducting or non-conducting materials such as conducting or non-conducting oxide or nitride layers. Other materials may also be used. The layers may be partially transparent.

The optical resonant cavity (or layer) can be dynamic in some embodiments. As shown in Figure 11I, for example, the reflector layer 1107 may be separated from the active layer with posts 1107. The reflector layer 1104 may be moveable and in particular may be moved toward or away from the active layer thereby changing the thickness of the optical resonant cavity. Movement of the reflector layer 1104 may be induced by applying a voltage between to the reflector layer 1104 and ITO layer 1101 to create an electrostatic force. The optical resonant cavity may be dynamically tuned, for example, to alter the absorption characteristics of the active layer with changes in environmental conditions. Figure 11J shows an alternate embodiment wherein the optical resonant cavity is a composite resonant cavity comprising a layer 1106a of $SiO_2$ and an air gap 1106b. The dielectric layer

1106a comprising $SiO_2$ may be used in electrically isolating the electrodes 1101, 1104 in the closed state. The process of increasing the absorption efficiency of the iPV cell is explained below.

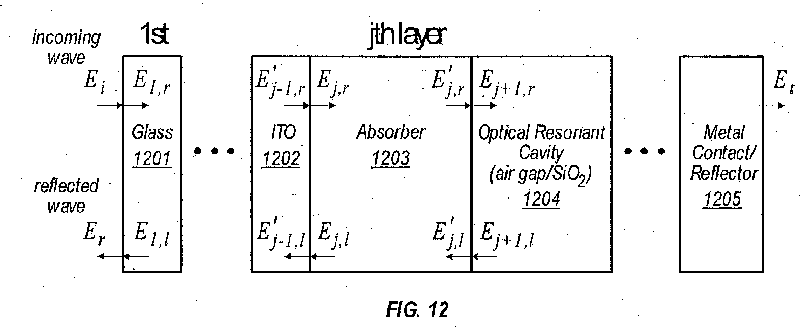

In general, an optical stack may comprise multiple layers wherein each interface between layers will reflect some portion of the incident light. In general, the interfaces also allow some portion of incident light to pass through (except maybe the last layer). Figure 12 shows incident light reflected from the various layers of the generalized iPV device having an unspecified number of layers. An incoming wave characterized by electric field $E_i$, incident on layer 1201 of the iPV device is partially reflected and partially transmitted as explained above with reference to Figure 4A. The transmitted wave is characterized by an electric field $E_{1,r}$ that propagates toward the right of the drawing. A portion of this wave characterized by an electric field $E'_{j-1,r}$ is incident at the interface of layer 1202 and 1203. Of this a portion characterized by $E_{j,r}$ is transmitted into the absorber layer 1203. A portion of the transmitted radiation is absorbed in the absorber 1203. The unabsorbed portion of the wave characterized by an electric field $E'_{j,r}$ is incident at the boundary of layer 1203 and 1204. A portion characterized by $E_{j+1,r}$ of the incident field $E'_{j,r}$ is transmitted into the optical resonant cavity 1204. A small portion characterized by electric field $E_t$ of the incoming wave $E_i$ is transmitted out of the iPV in the case where metal conductor/reflector 1205 is partially transmissive.

At the interfaces of the various layers, a portion of the incident radiation is reflected as well. For example, electric field $E_{j+1,1}$ represents the portion of the electric field $E_{j+1,r}$ that is reflected from the boundary of layers 1204 and 1205 and thus propagates toward the left of the drawing. Similarly the electric fields $E'_{j,1}$; $E_{j,1}$; $E'_{j-1,1}$ and $E_{1,1}$ represent the waves propagating in the iPV device towards layer 1201. The reflected wave $E_r$ is given by a superposition of the waves reflected from the various layers of the iPV device. The electric fields going into and coming out of a given interface can be calculated using matrix methods and values for the reflection coefficient and the transmission coefficient for various interfaces and the phase due to traversing the layers. Once the electric fields in a given layer, e.g. the active layer, are known, the absorption therein may be determined. The time averaged magnitude of the Poynting vector or the time averaged energy flux (time-averaged power per unit of normal area) going into the absorber layer 1203 and coming out of e.g. the absorber layer, can be calculated. The total power absorbed by the absorber layer 1203 can thus be calculated by subtracting the amount of power going out of the absorber layer 1203 from the total power going into the absorber layer 1203. In various embodiments, the ratio of the time averaged magnitude of the Poynting vector going into the absorber layer 1203 to the time averaged magnitude of the Poynting vector coming out of the absorber layer 1203 can be increased to increase the efficiency of the iPV device.

The power absorbed in any layer of the iPV cell, e.g., the absorber layer, can depend on the entire iPV stack as described above. The amount of energy absorbed in any layer of the iPV cell is directly proportional to the refractive index n of the layer, the extinction coefficient k of the layer, the square of the electric field amplitude $|E(x)|^2$ in the layer and the thickness of the layer, t. One approach to increasing or optimizing the energy absorption in the iPV device is to decrease the amount of energy absorbed in the layers surrounding the absorber layer and increase the amount of energy absorbed in the absorber layer. The amount of energy absorbed in the layers surrounding the absorber layer can be decreased, for example, by choosing materials with low $n \times k$ value, reducing the thickness of the surrounding layers or by decreasing the electric field strength in the surrounding layers or any combination of these approaches. For example, in one optimization method, the electric field in the absorber layer of the iPV cell can be increased using one or more of the following. A) The material and the thickness of the various layers of the iPV stack can be adjusted so the reflected and transmitted electric fields reaching the active layer interfere constructively. B) The electric field strength in the layers of the iPV device other than the active layer can be reduced, for example, as a result of at least in part from destructive interference. C) A material can be selected for the optical resonant cavity having a desirable or optimum refractive index n that provides, for example, appropriate phase shift and reflections, and a low index of refraction, n, and/or low extinction coefficient constant k, so that the optical resonant cavity has a low absorption for wavelengths corresponding to the band-gap of the active layer such that less light converted into electrical energy by the active layer is absorbed by optical resonant cavity. In some embodiments, the composition and the thickness of the optical resonant cavity may be such that the electric field in the absorber is increased, for example, for wavelengths having an energy equivalent to the band-gap of the active layer. D) More generally, materials wherein the product of refractive index n and extinction coefficient k is low, for example, for wavelengths having an energy equivalent to the band-gap of the active layer, may be used in those layers other than the active layer. By reducing the electric field strength in the layers of the iPV device other than the active layer and/or reducing the absorption using materials with low refractive index and/or extinction coefficient k value in those layers, a decrease in the energy absorption in all the layers except the active or absorber layer of the iPV device can be achieved. E) Materials with low n and/or k value and thus low absorption may also be used, in particular, in those layers other than the active layer where electric field strength is high.

To optimize the iPV device for increased absorption in the active or absorber layer, the thickness of the optical resonant cavity can be selected to, through interference effects, increase the intensity of light in the active region. In some embodiments, the thickness of the gap in the optical resonant cavity is selected or optimized during the design stage of the iPV cell by using modeling software and numerical routines. The thickness of the gap in the optical resonant cavity can also be varied dynamically in real time by further incorporating a MEMS engine or platform in the IMOD incorporated PV cell structure of Figures 11B-11F. (See, for example, Figures 11G and 11H). In various embodiments, however, the gap is fixed. In some embodiments, the thickness of the active layer can also be changed or optimized in addition to changing or optimizing the thickness of the optical resonant cavity to increase the absorption efficiency of the active or absorber layer.

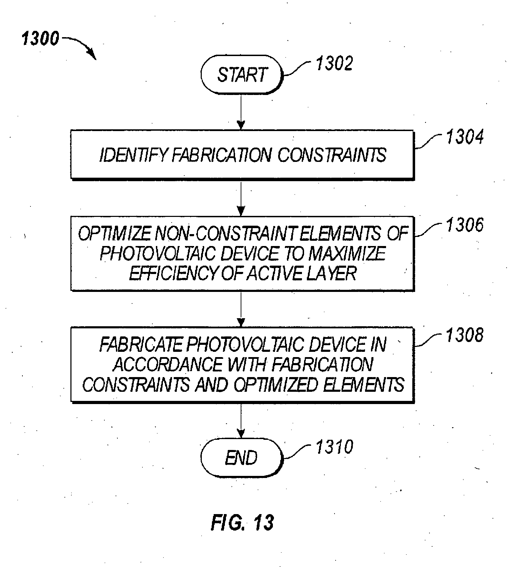

Figure 13 is a flow diagram of one embodiment of a method of fabricating an iPV device 1300. The process begins at a start 1302 and then moves to a state 1304 wherein a iPV device designer identifies a set of design characteristics and/or fabrication constraints. An iPV device comprises an optical stack including multiple layers. In general, the layers include an active layer and an optical resonant layer (e.g., optical resonant cavity). Additional layers may include, for example, electrodes, and electrical isolation layers. In some embodiments, the optical resonant layer comprise an electrode, electrical isolation layers or layer having another function in addition to increasing the absorption in the active layer. Various parameters (e.g. thickness, material) of any of these layers may need to be constrained for one or more reasons. The design characteristics and/or fabrication constraints may include, for example, in-plane resistance of one or more electrode layers such that collected electrons are used for electricity rather than dissipated as heat as well as absorption in inactive layers. Further, because the absorption in the active layer depends both on the thickness of all layers in the stack as well as the particular materials used, such materials and layer thicknesses of the constrained layer(s) are carefully selected in certain embodiments.

The method then moves to state 1306, wherein the parameters that are not constrained are selected or optimized to increase efficiency (e.g. absorption efficiency) of the active layer. In one embodiment, optimizing efficiency comprises identifying a maximum in efficiency based upon at least one design characteristic. In some embodiments, the efficiency can be optimized for a particular wavelength or a range of wavelengths (e.g. solar spectrum, visible spectrum, infrared spectrum, ultraviolet spectrum). The range may be at least 100 nm wide, 200 nm wide, 300 nm wide, 400 nm wide, 500 nm wide, 600 nm wide, etc. The process for increasing or optimizing absorption in a particular layer at a particular wavelength or wavelength range can involve a calculation based upon all or most of the layers in the optical stack. For certain embodiments, the precise thickness of each layered material may be calculated to increase or optimize the absorption in the active layer for a particular wavelength or a particular range of wavelengths.

In some embodiments, the layers comprise thin film layers. Accordingly, the layers are treated as thin films in the design process. "Thin films" can have a thickness less than or on the order of coherence length of the incident light, e.g. less than 5000 nm. For thin films, the phase of the light is considered in what is referred to as coherent superposition for determining the intensity levels resulting from multiple reflections. As described above, the absorption efficiency of the active layer can be optimized via an analysis of coherent summation of reflections from the plurality of interfaces of the iPV device. In some embodiments, such coherent summations are used to calculate the energy input and output from a given layer to determine the absorption in the layer, e.g., the active layer, and likewise the absorption efficiency thereof. Poynting vectors may be used in this process. Other steps in the method may also include the deletion of or replacement of layers within a conventional photovoltaic device.

In some embodiments, the overall efficiency is increased or optimized by increasing or optimizing the absorption efficiency, $\eta_{abs}$. As described above, however, the overall absorption efficiency, $\eta_{overall}$, is dependent on both the efficiency at which light is absorbed in the active layer to form electron hole pairs, $\eta_{abs}$, and the efficiency of which the electron hole pairs are collected by the electrodes, $\eta_{collection}$.

Interferometric principles can be used to increase or optimize the overall conversion efficiency $\eta_{overall}$ by increasing or optimizing one or both of the above defined parameters $\eta_{abs}$ and $\eta_{collection}$. For example, in some embodiments, the absorption efficiency $\eta_{abs}$ can be optimized or maximized without taking into account the collection efficiency $\eta_{collection}$. However, parameters varied to increase or optimize the absorption efficiency, $\eta_{abs}$, may also affect the collection efficiency, $\eta_{collection}$. For example, the thickness of the electrodes or the thickness of the active layer may be altered to increase absorption in the active layer, however, this thickness adjustment may also impact the collection efficiency. Accordingly, in some embodiments an optimization can be performed such that both the collection efficiency, $\eta_{collection}$, and the absorption efficiency, $\eta_{abs}$, are considered and/or optimized to achieve an increased or optimized overall efficiency $\eta_{overall}$. In certain other embodiments, the absorption efficiency, $\eta_{abs}$, and the collection efficiency, $\eta_{collection}$, can be optimized recursively to maximize the overall efficiency, $\eta_{overall}$. Other factors may also be included in the optimization process. In some embodiments, for example, optimizing the overall efficiency of the iPV device can be based upon heat dissipation or absorption in one or more inactive layers.

The method then proceeds to state 1308, wherein the photovoltaic device is fabricated in accordance with the fabrication constraints and optimized elements. Once the designer has completed state 1308, the method terminates at an end state 1310. It will be understood that other steps may be included to improve or optimize a photovoltaic device.

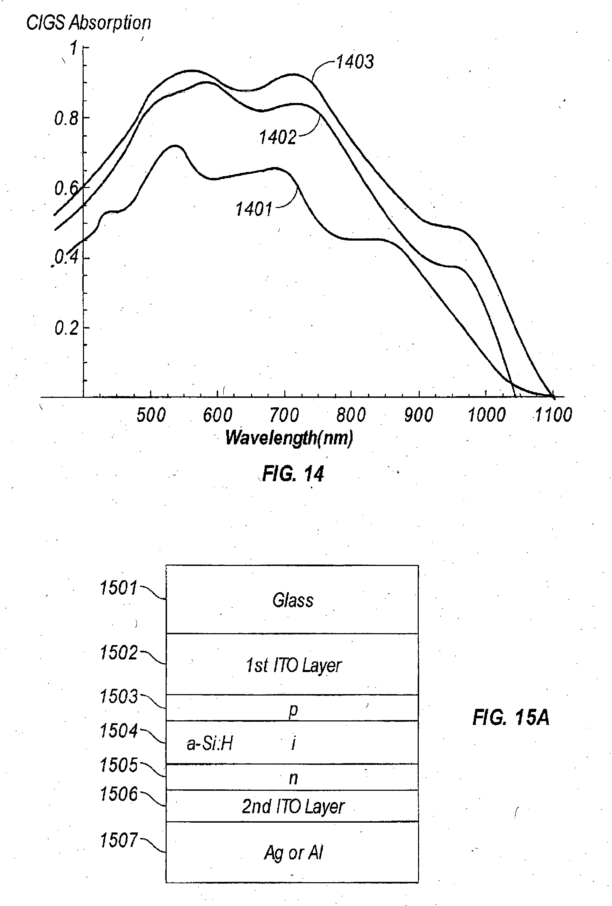

Figure 14 illustrates a graph of the modeled absorption in the wavelength region from approximately 400 nm to approximately 1100 nm for each of the embodiments described in Figures 11A-11C. Curve 1401 is the absorbance in the absorber layer 1103 for the embodiment illustrated in Figure 11A. Curve 1402 is the absorbance in the absorber layer 1103 for the embodiment illustrated in Figure 11B. Curve 1403 is the absorbance in the absorber layer 1103 for the embodiment illustrated in Figure 11C. As illustrated in Figure 14, according to curve 1402, the modeled absorption in the absorber layer of the embodiment illustrated in Figure 11B at wavelength equal to approximately 550 nm, is approximately 28% higher than the corresponding modeled absorption value in the absorber layer of the embodiment of Figure 11A shown in curve 1401. Further, according to curve 1403, the modeled absorption in the absorber layer of the embodiment illustrated in Figure 11C at wavelength equal to approximately 550 nm, is approximately 35% higher than the corresponding modeled absorption value in the absorber layer of the embodiment of Figure 11A shown in curve 1401. Thus the embodiments illustrated in Figures 11B and 11C comprising an optical resonant cavity show approximately 10%-35% improvement in the absorption in the active region in comparison to the embodiment illustrated in Figure 11A. A comparison of curves 1402 and 1403 shows that between the embodiment comprising an ITO layer in the optical resonant cavity illustrated in Figure 11B and the embodiment comprising air or $SiO_2$ in the optical resonant cavity illustrated in Figure 11C, the embodiment illustrated in Figure 11C has higher absorption in the absorber layer 1103. This result can be explained as follows: The electric field strength in the active or absorber layer is high. The electric field in the optical resonant cavity layer outside the absorber layer drops rapidly but does not become zero. The product of the refractive index n and the extinction coefficient k of ITO is low in the wavelengths having an energy equivalent to the band-gap of the absorber layer (for example, wavelengths between 300 nm and 800 nm), but it is not lower than the product of the refractive index n and the extinction coefficient k of air or $SiO_2$ in the wavelengths having an energy equivalent to the band-gap of the absorber layer. Thus, the ITO layer in the optical resonant cavity absorbs significantly more radiation than the air (or $SiO_2$) layer. This results in decreasing the absorption in the absorber layer. It can be observed in curve 1403 that when optimized, the modeled absorption in the active layer of embodiment shown in Figure 11C is approximately 90% in the wavelength range from 500 nm to 700 nm.

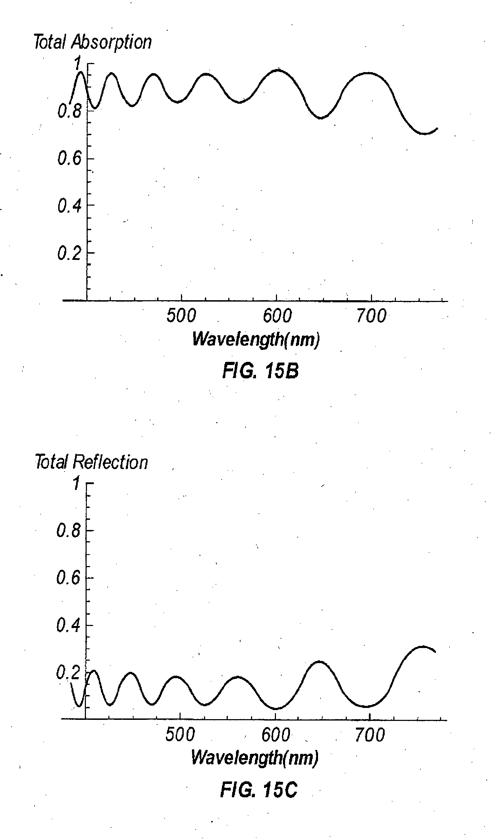

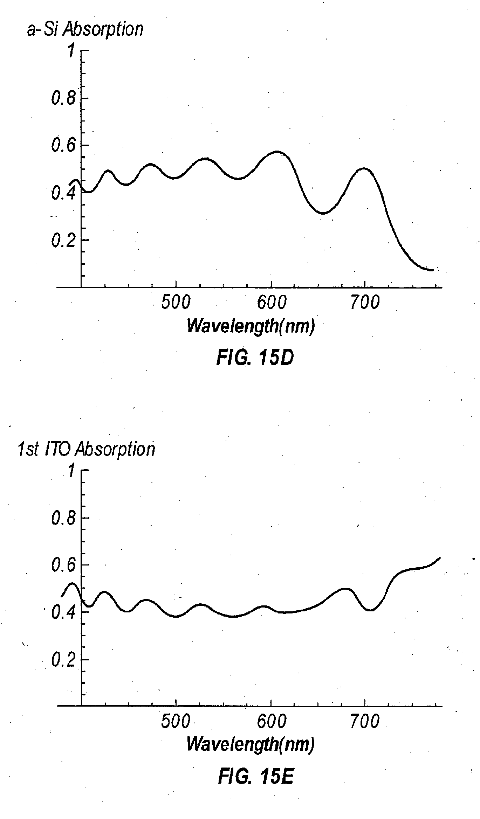

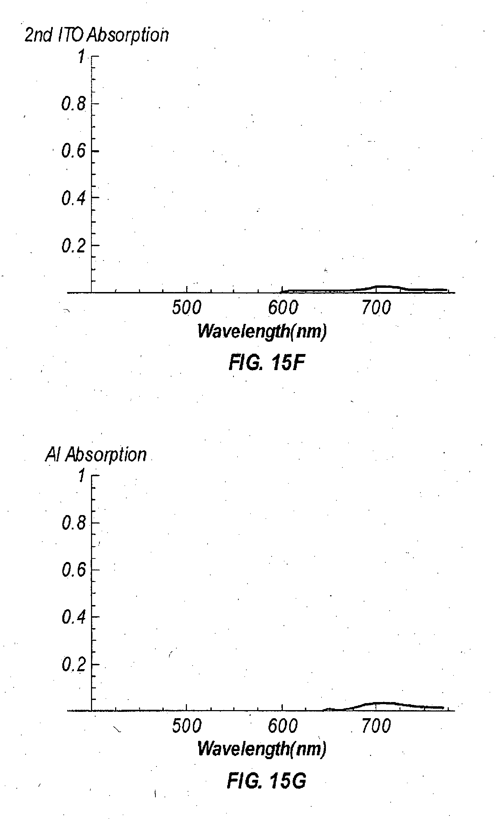

Figure 15A illustrates a diagram of a single p-i-n junction amorphous silicon solar cell structure. This device is similar to that disclosed by Miro Zeman in Chapter 5 of "Thin Film Solar Cells, Fabrication, Characterization & Applications," edited by J. Poortmans & V. Arkhipov, John Wiley and Sons, 2006, pg. 205 except that the PV cell comprises a plurality of ITO layers (which replace the TCO layer and ZnO layer disclosed by Miro Zeman). The embodiment shown in Figure 15A comprises a textured glass substrate 1501, a first ITO layer 1502 approximately 900 nm thick, a p-i-n junction approximately 330 nm thick, wherein the region 1504 comprises α:Si, a 80 nm thick second ITO layer 1506 and a 300 nm thick Ag or Al layer 1507. The thicknesses of various layers match the thicknesses disclosed by Miro Zeman which were chosen such that the total absorption in the entire stack disclosed by Miro Zeman is maximized. This maximization was achieved by varying the thicknesses of various layers until the PV cell looked black. The total absorption versus wavelength is illustrated in Figure 15B. It can be observed that all wavelengths are absorbed uniformly in the PV stack. The total reflection from the PV device versus wavelength is illustrated in Figure 15C. The total reflection from the PV cell is low and likewise the PV cell appears black. Figure 15D shows the absorption in the absorber or active layer 1504 of the PV cell. Figures 15E-G show the absorption in the first ITO layer 1502, the second ITO layer 1506 and the Ag or Al layer 1507. As illustrated in Figures 15D and 15E, the amount of radiation absorbed in the active layer 1504 is approximately equal to the amount of radiation absorbed in the first ITO layer 1502. Thus, this design is sub-optimal as light that might otherwise be converted into electrical energy by the active layer 1504 is absorbed instead in the first ITO layer 1502. The amount of absorption in the second ITO layer 1506 and the Ag or Al layer 1507 is negligible.

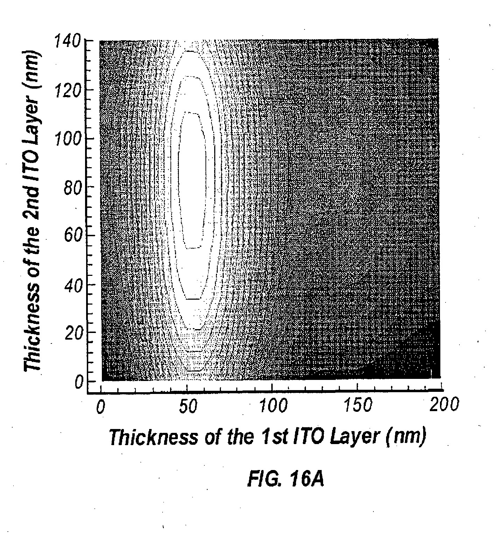

The PV stack of Figure 15A can, however, be optimized by applying the interference principles of IMOD design described above. In some embodiments, the values of the refractive index n and the extinction coefficient k for the p, i and n layers may be substantially similar to each other and the p, i and n layers may be considered as a single layer having a combined thickness of the three distinct layers in the optimization process. In one embodiment, the optimization can be performed by keeping the thickness of the active layer 1504 constant while varying the thickness of the first ITO layer 1502 and the second ITO layer 1506. Figure 16A illustrates a contour plot 1600 of the integrated energy absorbed in the active or absorber layer versus the thickness of the first ITO layer 1502 and the second ITO layer 1506. Each point in Figure 16A is the integrated absorption (absorption integrated over wavelength) in the active layer when the thickness of the first ITO layer 1502 and the second ITO layer 1506 is given by the corresponding x (horizontal) and y (vertical) axis. The lighter the shade, the larger the total absorption of the active layer. In the contour plot 1600, a maximum absorption 1610 is achieved when the thicknesses of the first ITO layer 1502 and the second ITO layer 1506 are approximately 54 nm and 91 nm, respectively. Thus, increased or optimal absorption efficiency occurs when the thickness of the first ITO layer 1502 is reduced significantly from 900 nm to 54 nm. The plot of Figure 16A shows that, contrary to conventional belief, the absorption in the active layer does not increase linearly with increase in the thickness of the ITO layer. Instead, the absorption varies non-linearly with thickness and there may be an optimal thickness for the ITO thickness that maximizes the absorption in the active layer. The increase in the absorption in the active layer 1504 is largely due to a significant reduction in the amount of radiation absorbed in the first ITO layer. The contour plot 1600 may thus be used to determine desirable or optimum thicknesses of electrode layers in the stack so as to increase the absorption efficiency in a particular active layer 1504.

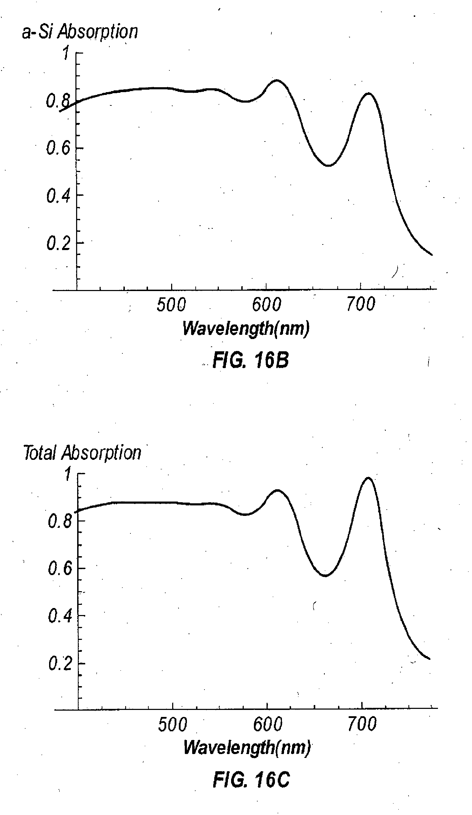

Figure 16B shows the absorption in the active layer of the optimized PV stack. A comparison of Figure 16A with Figure 15D, shows that the absorption in the active layer of the optimized PV stack is increased by approximately twice the absorption in the active layer of the unoptimized PV stack. Figure 16C shows the total absorption versus wavelength in the optimized PV stack. The absorption curve shows less absorption in the wavelength region around red. Thus, a viewer viewing the optimized PV stack will observe that the PV cell looks reddish black as opposed to a completely black appearance of the unoptimized PV stack. This example demonstrates that in some embodiments, a PV cell that looks black does not necessarily have the highest amount of absorption in the active layer. In some embodiments, the higher amount of absorption in the active layer accompanies a device that has some color other than completely black. Advantageously, in certain embodiments, as described above, an increased absorption of energy in the PV absorber results in a linear increase in the overall energy conversion efficiency of the PV cell.

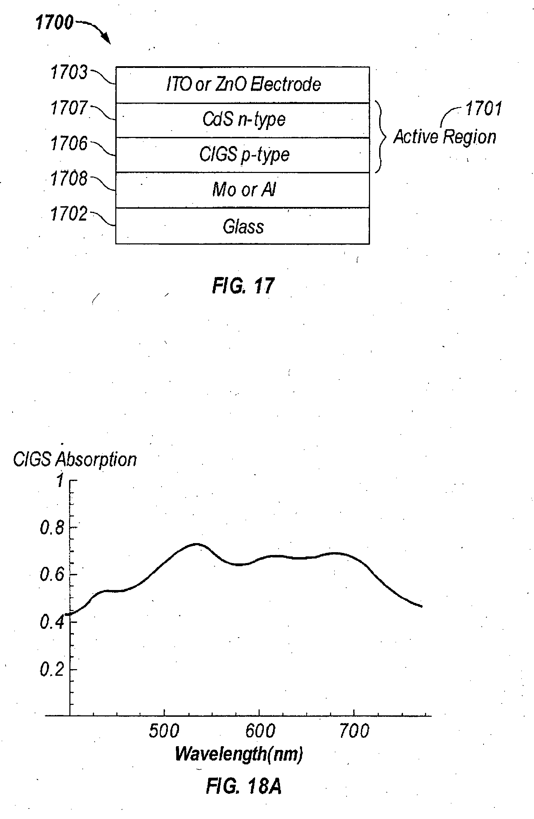

Figure 17 illustrates a diagram of a photovoltaic device 1700 similar to the device illustrated in Figure 11A. The photovoltaic device 1700 of Figure 17 comprises thin film layers including an active region 1701 comprising a $Cu(In,Ga)Se_2$ ("CIGS"), p-type layer 1706 and a CdS, n-type layer 1707, wherein the active region 1701 has not been optimized for maximum absorption efficiency in the active region. The photovoltaic device shown in Figure 17 is similar to that disclosed by Krc et al. in "Optical and Electrical Modeling of Cu(In,Ga)Se2 Solar Cells" OPTICAL AND QUANTUM ELECTRONICS (2006) 38:1115-1123 ("Krc et al."). This embodiment comprises a glass substrate 1702, an ITO or ZnO electrode layer 1703, the polycrystalline $Cu(In,Ga)Se_2$ (CIGS) p-type layer 2206, the CdS, n-type layer 1707 and a Mo or Al reflector layer 1708.

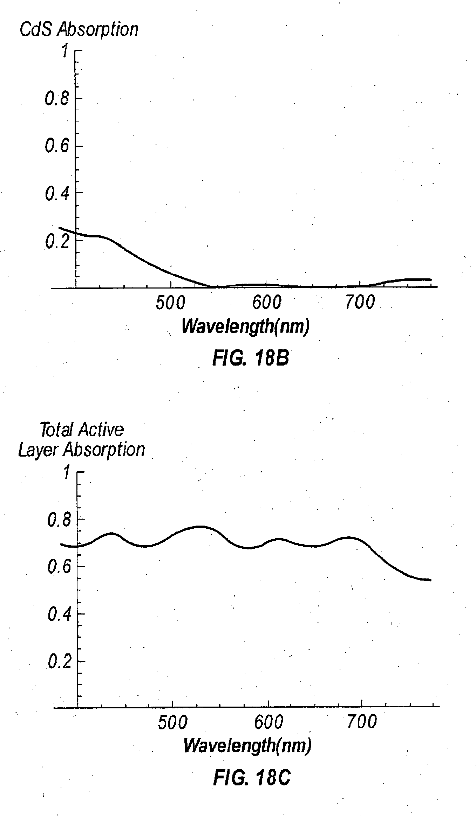

Figures 18A-18C comprise a series of graphs for modeled absorbance versus wavelength of the CIGS, p-type layer 1706 and the CdS, n-type layer 1707 in the device reported by Krc et al. Figure 18A shows absorbance of approximately 60% in the CIGS, p-type layer 1706 over the wavelength range of approximately 400 nm to approximately 800 nm. From approximately 500 nm to approximately 700 nm almost 70% absorbance was achieved. Figure 18B illustrates a graph of the CdS, n-type layer 1707 absorbance over the wavelength range of approximately 400 nm to approximately 800 nm, wherein a range of 0% and 20% absorbance was achieved. Figure 18C illustrates a graph of total absorbance for the active region 1701 over the wavelength range of approximately 400 nm to approximately 800 nm. An average of approximately 70% absorbance was achieved over this range. The results of the modeled graph of Figure 18A are nearly identical to the measured absorbance of the CIGS layer illustrated in Figure 2 as reported in Krc. As discussed below, the measured and modeled absorbances illustrated in Krc and in Figures 18A-18C are improved dramatically when an optical resonant cavity is placed between the active region 1701 and the reflector layer 1708 in the embodiment of Figure 17.

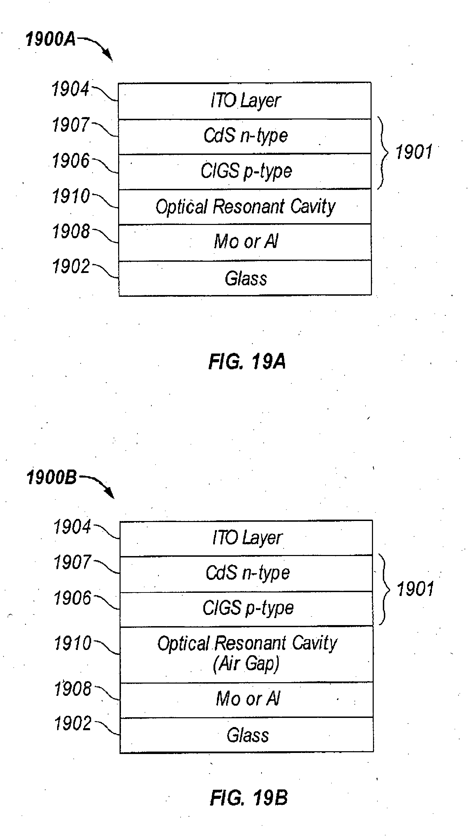

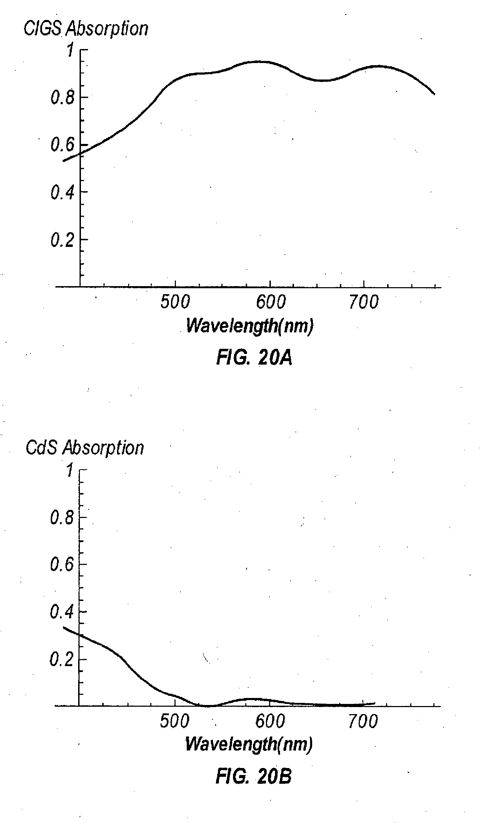

Figure 19A illustrates a diagram of a photovoltaic device 1900A after an optical resonant cavity 1910 has been added between the active region 1701 and the reflective layer 1708 of Figure 17. In particular, the photovoltaic device 1700 was optimized according to the principles of IMOD design described above. In this embodiment, the optical resonant cavity comprises transparent ITO or ZnO. The thickness and the optical properties (for example, refractive index n and extinction coefficient k) of the active layer 1901 comprising a CdS, n-type layer 1907 and a CIGS, p-type layer 1906 was not changed. In another embodiment, the parameters, for example, thickness and index of refraction, of a glass substrate 1902 and Mo or Al reflective layer 1908 were not altered by the optimization process. The thicknesses of an ITO or ZnO electrode layer 1904 and the optical resonant cavity 1910 were varied and absorption in the active region 1901 was thereby increased. The optimized thickness of the ITO or ZnO electrode layer 1904 was approximately 30 nm and the optimized thickness of the optical resonant cavity 1910 was approximately 70 nm. The absorbance of the CIGS, p-type layer 1906 and the CdS, n-type layer 1907 was then modeled as illustrated Figures 20A-20C. Figure 19B illustrates an alternate embodiment of Figure 19A, wherein the optical resonant cavity 1910 comprises an air gap.

Figures 20A-20C comprise a series of graphs for the modeled absorbance versus wavelength of the CIGS, p-type layer 1906 and the CdS, n-type layer 1907 in the optimized photovoltaic device 1900A of Figure 19A. Figure 20A shows a modeled graph of absorbance in the CIGS, p-type layer 1906 over the wavelength range of approximately 400 nm to approximately 800 nm illustrating approximately 60% to 90% absorbance. Figure 20B shows a modeled graph of absorbance in the CdS, n-type layer 1907 over the wavelength range of approximately 400 nm to approximately 800 nm illustrating 0% to 30% absorbance.

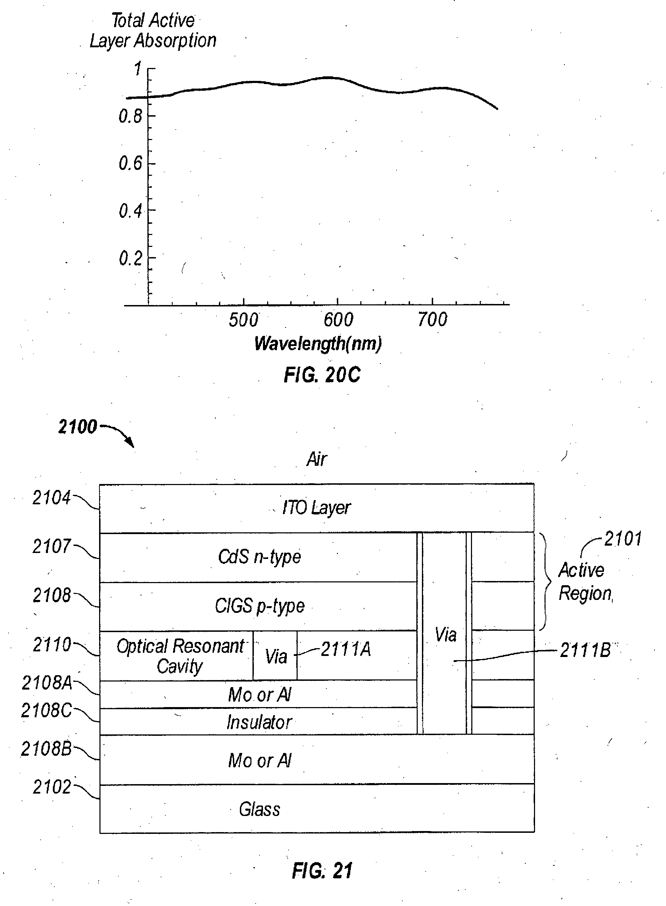

Figure 20C shows a modeled graph of total absorption of the CIGS, p-type layer 1906 and the CdS, n-type layer 1907 of approximately 90% over the wavelength range of 400 nm to 800 nm. Thus, the absorption efficiency of the combination CIGS, p-type layer 1906 and the CdS, n-type layer 1907 was increased approximately 20% over the wavelength range 400 nm to 800 nm by applying the methods described above to the embodiment of Figure 17.

Figure 21 is a diagram of one embodiment of an iPV device 2100 that has been optimized according to the methods described above. The photovoltaic device 2100 includes an active region 2101. The photovoltaic device 2100 also comprises a glass substrate 2102 and an ITO layer 2104 disposed over the active region 2101. The active region 2101 comprises a CIGS, p-type layer 2106 and a CdS, n-type layer 2107. Two metal layers 2108A and 2108B, respectively, are disposed (the first metal layer 2108A over the second metal layer 2108B) on the glass substrate 2102. The first metal layer 2108A is both a reflector and an electrode. The second metal layer 2108B is also an electrode. A dielectric material 2108c may be disposed between the reflector 2108a and the electrode 2108b to electrically isolate these electrical pathways from each other. The metal layers 2108A and 2108B each comprise Mo or Al. In this embodiment, an optical resonance cavity 2110 comprising an air gap is created between the first metal layer 2108A and the active region 2101. The air has less absorption, a lower k, than other materials. Air also has a refractive index of 1.0. Although an air gap may be effective for purposes of absorption efficiency, air is a non-conductor of electricity. Thus, the photovoltaic will not function to provide electrical current from the absorbed light. This problem is solved using vias to draw electrical charge from the active layer. Thus, electrically connecting the first metal layer 2108A to the CIGS, p-type layer 2106 is a first via 2111A. Electrically connecting the second metal layer 2108B to the ITO layer 2104 and passing through the optical resonant cavity 2110, the CIGS, p-type layer 2106, and CdS, n-type layer 2107 is a second via 2111B. This second via 2111B may be surrounded by an insulating layer to electrically isolate the via from, for example the CIGS, p-type layer 2106. As optimized, the ITO layer 2104 has a thickness of 15 nm, the CdS, n-type layer 2107 has a thickness of 40 nm, the CIGS, p-type layer 2106 has a thickness of 360 nm and the air gap optical resonance cavity 2110 has a thickness of 150 nm. The air gap optical resonance cavity 2110 may be replaced with either silicon dioxide or magnesium dioxide or another transparent dielectric, such as $MgF_2$ or other suitable materials known in the art. In various embodiments, a dielectric with a low $n \times k$ value is used. In such embodiments, the first via 2111A may advantageously connect the bottom electrode to the CIGS, p-type absorber layer 2106. In various other embodiments disclosed herein as well as embodiments yet to be devised that include optical resonant layers (e.g. optical resonant cavity) comprising non-conducting material, vias can be used to provide electrical connection through such non-conducting layers.

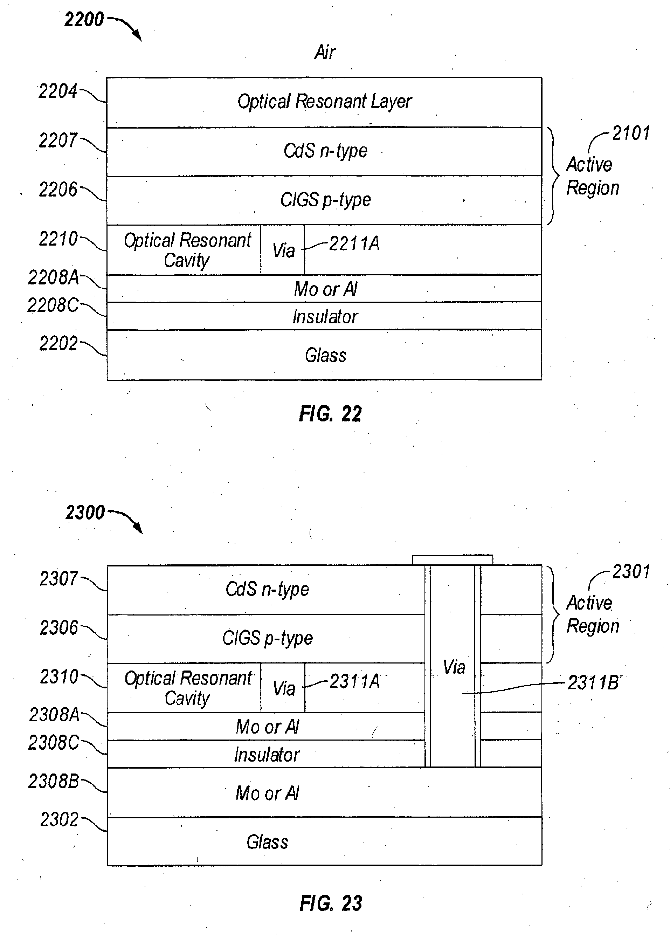

Figure 22 is a diagram of the embodiment illustrated in Figure 21 with via 2111B and the metal electrode layer 2108B removed. Electrical contact may be made, for example, by contacting a top optical resonant layer 2204, which may comprise transparent conducting material such as conducting oxide.

Figure 23 is a diagram of one embodiment of a photovoltaic device 2300 similar to the embodiment of Figure 21, except that the ITO layer 2104 is removed. Thus, the photovoltaic device 2300 comprises a glass substrate 2302 and a first metal layer 2308A disposed on a second metal layer 2308B, which is disposed on the glass substrate 2302. An air gap optical resonance cavity 2310 separates the first metal layer 2308A from a CIGS, p-type layer 2306 and a CdS, n-type layer 2307. As above, the first metal layer 2308A is a reflector as well as an electrode that is electrically connected to the base of the CIGS, p-type layer 2306 by a first via 2311A. Similarly, the second metal layer 2308B comprises an electrode that is electrically connected to the top of the CdS, n-type layer 2307 by a second via 2311B. As optimized, the CdS, n-type layer 2307 has a thickness of 40 nm, the CIGS, p-type layer 2306 has a thickness of 360 nm and the air gap optical resonance cavity 2310 has a thickness of 150 nm. Similar to the discussion above, the air gap optical resonance cavity 3010 may be replaced with either silicon dioxide or magnesium dioxide or another dielectric. In such embodiments, the first via 2311A may advantageously connect the electrode 2308A to the CIGS, p-type absorber layer 2306.

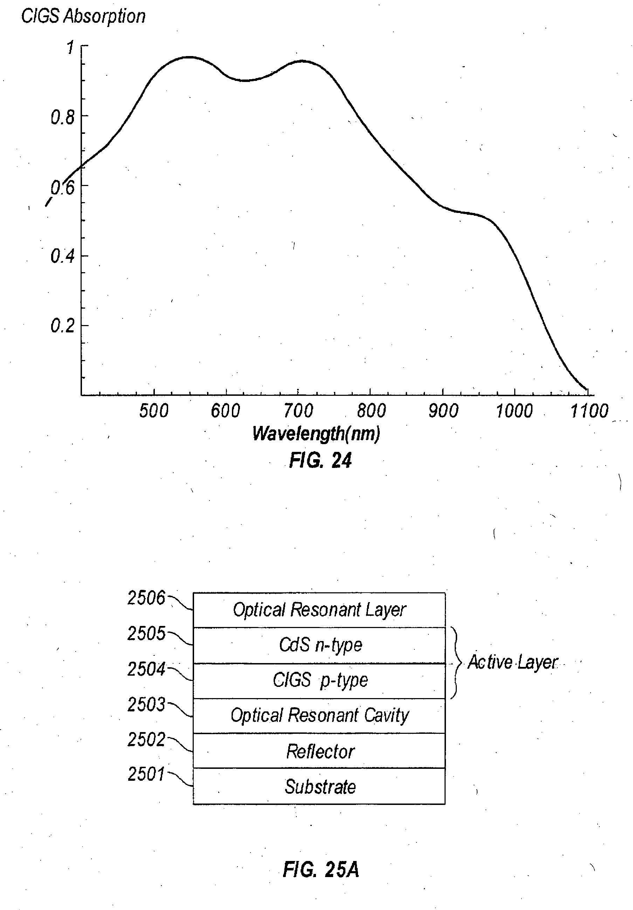

Figure 24 is a graph of modeled absorption in the CIGS, p-type layer of the photovoltaic device 2300 of Figure 23 over the wavelength range of approximately 400 nm to approximately 1100 nm. The graph illustrates that the CIGS, p-type layer exhibits over 90% absorption efficiency in the range of approximately 500 nm to approximately 750 nm.

In general, layers may be included in the PV device that provide increased absorption in the active layer by appropriate selection of parameters, e.g., materials and dimensions, associated with these layers. One or more parameters of one of these layers may be adjusted while holding the parameters of other layers fixed, or, in certain embodiments one or more parameters of one or more layers may be adjusted to provide for increased absorption in the active layer. In some embodiments, one or more parameters of all the layers may be adjusted to obtain increased absorption in the active layer. In various embodiments, these parameters may be adjusted at the design stage, for example, by calculating the effects of different parameters on the absorption. Optimization procedures may be used. A range of other techniques may also be used to obtain values for the parameters that yield improved performance.

Figure 25A, for example, shows how an optical resonant layer 2506 and an optical resonant cavity 2503 may be included in a photovoltaic device and may be tuned to provide increased absorption. This device is a more generalized version of the devices shown in Figure 19A and 19B. Parameters of the optical resonant layer 2506 and optical resonant cavity 2503, such as thickness, may be varied to interferometrically tune the device and produce increased absorption in the active layer.

In some embodiments, the optical resonant layer 2506 and the optical resonant cavity 2503 may comprise electrode layers. In various embodiments, however, either or both the optical resonant layer 2506 and the optical resonant cavity 2503 may comprise a material with a low extinction (or absorption) coefficient k and/or low index of refraction, n that yield a low n × k value. One or both of the optical resonant layer 2506 and the optical resonant cavity 2503 may comprise, for example, a low n × k value. As described above, for example, the optical resonant cavity 2503 may comprise air or a dielectric such as $SiO_2$ or an electrically conducting material such as a TCO, like ITO or ZnO. Other materials with low or approximately zero k may also be used so as to provide low n × k value. Still other materials are possible. Similarly, the optical resonant layer 2506 may comprise air, a dielectric material with a low extinction (or absorption) coefficient k; or an electrically conducting material such as a TCO, like ITO or ZnO; or any other material with low n × k value. Also, other materials may also be used.

In certain embodiments hybrid or composite structures are used for the optical resonant cavity and/or optical resonant layer. For example, the optical resonant cavity and/or optical resonant layer may comprise an air/dielectric, conductor/dielectric, air/conductor combination or mixture.

In the embodiment shown, the active layer of the PV cell comprises an n-type CDS layer 2505 and a p-type CIGS layer 2504. In other embodiments, the active layer may comprise other materials. The optical stack can be deposited on a substrate 2501 by using thin film fabrication techniques. The substrate 2502 may comprise glass or other suitable material. In some embodiments, a reflector 2502 may be deposited between the substrate and the remainder of the optical stack comprising the active layer surrounded by the optical resonant layer and optical resonant cavity. The reflector may be formed of Al, Mo or other reflecting material such as a metal or dielectric. In some embodiments, the reflector may comprise single or composite material.

The reflector 2502 of Figure 25A may also be selected to optimize certain parameters. For example, the material and thickness of the reflector layer 2502 may be selected so as to increase or optimize the reflectance over a certain wavelength range. In other embodiments, the reflector may be selected to reflect a certain range of wavelengths (such as red) and absorb another range of wavelengths (such as blue).

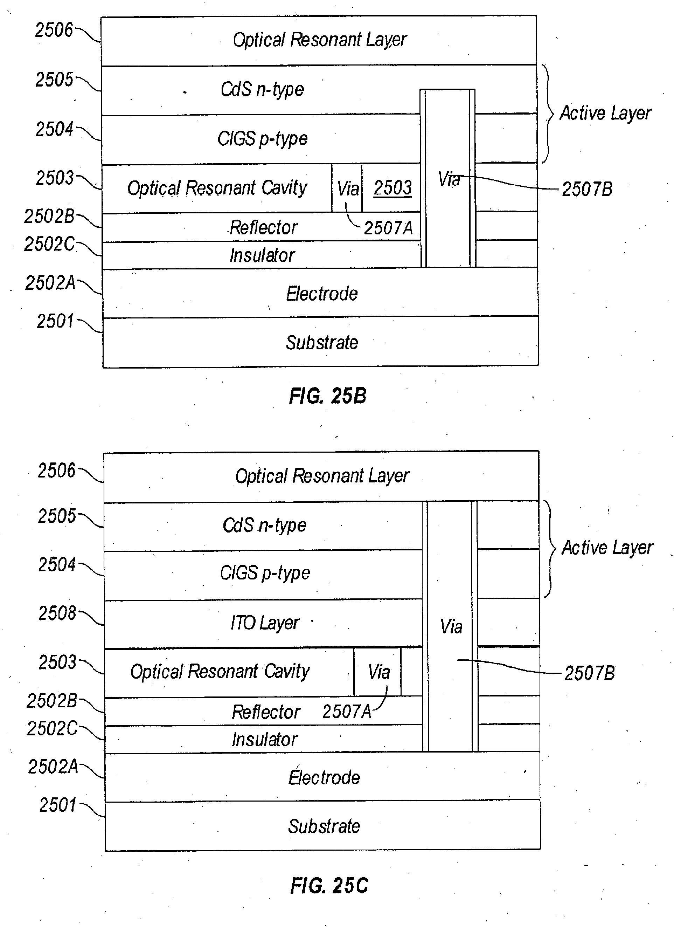

As described above, the optical resonant cavity 2503 and the optical resonant layer 2506 may comprise TCO such as TTO or $SnO_2$. In other embodiments, the optical resonant cavity and the optical resonant layer may comprise transparent dielectric material or an air gap or combination thereof. The materials used for the optical resonant cavity 2503 and the optical resonant layer 2506 need not be the same. Figure 25B illustrates an embodiment of the iPV cell wherein the optical resonant cavity 2503 comprises an air gap or a dielectric material such as $SiO_2$ and the optical resonant layer 2506 also comprises a non-conducting layer such as $SiO_2$. To provide a conducting path for the electrons from the active layer vias 2507a and 2507b are provided as indicated in Figure 25B. The iPV cell comprises a reflector 2502b and an electrode 2502a as indicated in Figure 25B. In some embodiments, the electrode 2502a may comprise the same material as the reflector 2502b. The reflector 2502b and the electrode 2502c may comprise conducting materials. Via 2507a terminates on reflector 2502b and via 2507b terminates on electrode 2502a. Metal leads can be provided to the two reflectors to provide external electrical connection. A dielectric material 2502c may be disposed between the reflectors 2502b and the electrode 2502a to electrically isolate these electrical pathways from each other. The reflectors 2502a and 2502b can thus be used as electrical pathways to extract electrical power from the active layer using the vias. In those embodiments wherein the optical resonant layer 2506 comprises a conducting material, the via 2507b can extend up to the optical resonant layer 2506. Alternately, in such embodiments, the via 2507b may be eliminated all together.

Figure 25C illustrates another embodiment of an iPV cell comprising a conducting ITO layer 2508 disposed between the active layer and the optical resonant cavity 2503. A conducting path for the electrons from the active layer is provided by vias 2507a and 2507b. Via 2507a connects the ITO layer 2508 to the reflector 2502b while via 2507b connects the n-type CdS layer 2505 to an electrode 2502a. The ITO layer 2508 and the optical resonant cavity 2503 may form a composite optical resonant cavity as described in Figures 11E-11H, and thus the ITO may be said to be part of the optical resonant cavity.

As described above, one or more parameters of one or more of the layers in these devices shown in Figures 25A-25C may be adjusted to provide for increased absorption in the active layer using for example interferometric principles or as the result of interferometric effects.

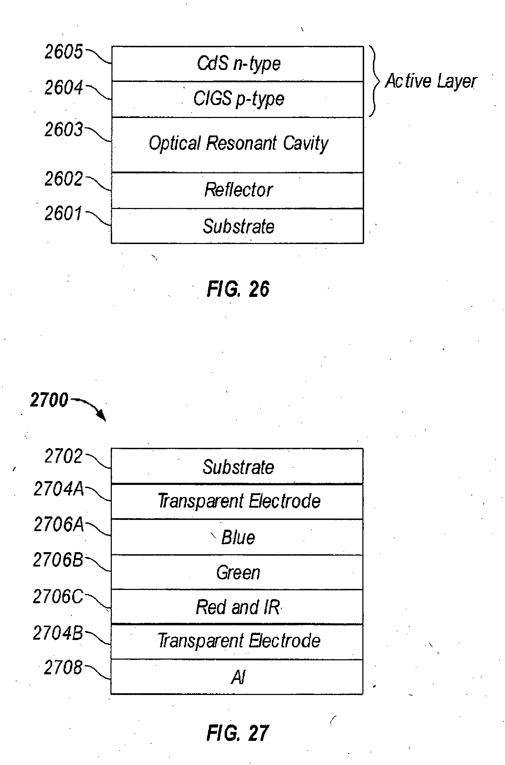

Figure 26 shows a simpler device than shown in Figures 25A-25C. This PV device includes, an optical resonant cavity 2603 disposed between the active layer of the iPV and a reflector 2602. The active layer of the iPV comprises an n-type CdS layer 2605 and a p-type CIGS layer 2604. The reflector layer 2602 can comprise Al, Mo or other metallic/dielectric reflecting material. As described above, the optical resonant cavity may comprise air, a dielectric material or a transparent conducting material with a low $n \times k$ value or combinations thereof. Other material may also be used. In some embodiments, the reflector 2602 may be removed. As described above, one or more parameters of one or more of the layers in this device may be adjusted to provide for increased absorption in the active layer based on for example interferometric principles. In some embodiments, the optical resonant cavity 2603 may be excluded and still one or more parameters of one or more layers may be optimized to provide for increased absorption in the active layer.

Parameters of different layers may be selected based on their spectral properties. For example, gold has a high extinction coefficient, k, in the wavelength region around red and has a relatively low extinction coefficient, k, in the wavelength region around blue. However, the refractive index n of gold is low in the wavelength region around red and high in the wavelength region around blue. As a result, the product $n \times k$ is low for gold in the wavelength region around red and high in the wavelength region around blue. Therefore, a reflector comprising gold will predominantly reflect wavelengths around red and absorb wavelengths around blue. Thus a reflector can be used to tune the absorption by choosing a material for the reflector that has a low $n \times k$ value in the wavelength range that corresponds to the useful optical absorption range of the active layer (where light is absorbed and converted into electrical power) and a high $n \times k$ value in wavelengths that are not in the useful optical absorption range of the active layer (for example, where optical energy is converted into heat, which may degrade the operation of the device). For example, if it is advantageous to not let blue light into the iPV device, then it may be desirable to form the reflector 1104 of gold. In some embodiments, the reflector material may be chosen so as to absorb infrared wavelengths.

Likewise, as described above, the selection of a particular gap distance will dictate whether a particular color is reflected by the reflector layer (for example, 1104 of Figure 11B-H), e.g., red, green, or black. For example, the gap distance can be selected such that the reflector reflects a substantial portion of the incident light in the wavelength region corresponding to the band-gap of the active or absorber layer and is subsequently absorbed by the active layer/absorber and thus the IMOD appears black. Contrary to conventional methods directed to increasing the efficiency of a solar cell, however, the above described methods of optimizing the iPV device for increased absorption in the active layer may not always be associated with a device that appears completely black. The device may for example appear reddish black or other colors in some embodiments.

Figure 27 illustrates a diagram of a conventional multi-junction photovoltaic device 2700. The photovoltaic device 2700 comprises a glass substrate 2702, transparent electrodes 2704A and 2704B, active layers 2706A, 2706B and 2706C and a reflective layer 2708. In this embodiment, the substrate 2702 comprises glass, the first and second transparent electrodes 2704A and 2704B comprise ITO and the reflective layer 2708 comprises Al. The first active layer 2706A is configured to absorb blue light, the second active layer 2706B is configured to absorb green light and the third active layer 2706C is configured to absorb red and infrared light. In some embodiments, the active layers 2706A, 2706B and 2706C comprise similar materials with difference band gaps for red, green or blue. In some embodiments, the active layers 2706A, 2706B and 2706C comprise different material systems such as a combination of silicon, GaAs, or other materials known in the art.

In a multi-junction photovoltaic device, there are numerous approaches to optimize energy absorption in each of the junctions of the photovoltaic device. For example, one approach can be to dispose an optical resonant cavity between the combined stack of multi-junction active layers (for example, 2706A-2706C) and the reflector 2708. Another approach can be to dispose an optical resonant layer between each active layer that forms the multi-junction photovoltaic device and dispose an optical resonant cavity between the last active layer of the photovoltaic device and the reflector. These two approaches are described in detail below.

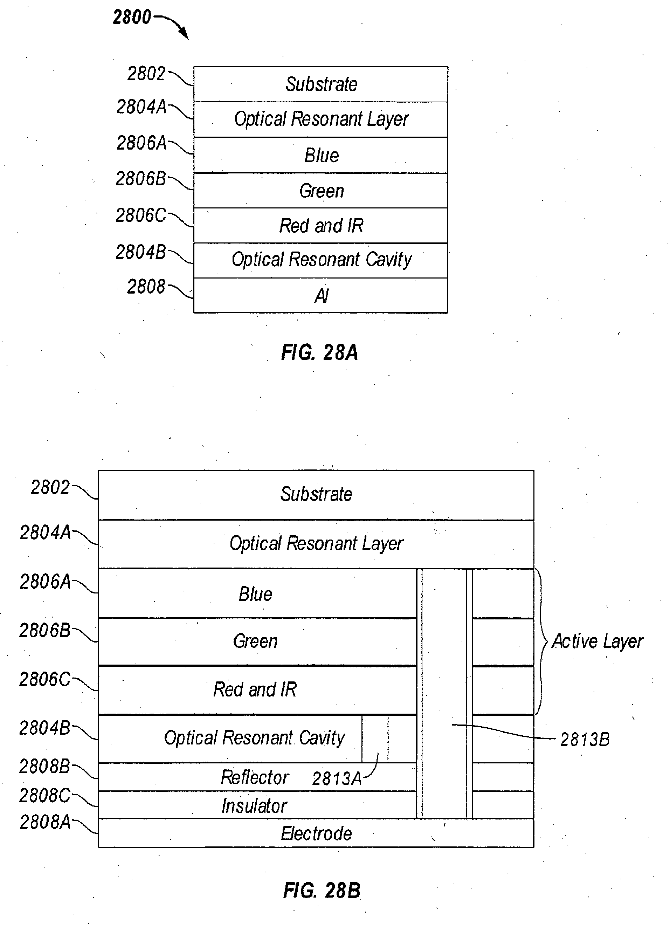

Figure 28A illustrates a diagram of one optimized version of the multi-junction photovoltaic device illustrated in Figure 27. In this embodiment, three absorber/active layers 2806A, 2806B and 2806C are configured to absorb light in the "Blue", "Green" and "Red and IR" wavelength ranges. These absorber layers are sandwiched between a first optical resonant layer 2804A and a second optical resonant cavity 2804B. The optical resonant layer 2804A and the optical resonant cavity 2804B can comprise transparent conducting electrode, TTO, air gap, $SiO_2$ or other materials. If the optical resonant layers or the optical resonant cavity comprise non-conducting materials, then vias as shown in Figure 28B may be used to provide electrical connectivity. The labels "Red, Green and Blue" only refer to a range of wavelengths and not to the real wavelength range of, for example, red. The active layers can absorb other wavelengths. Additionally, more or less active regions may be included. Other variations are possible.

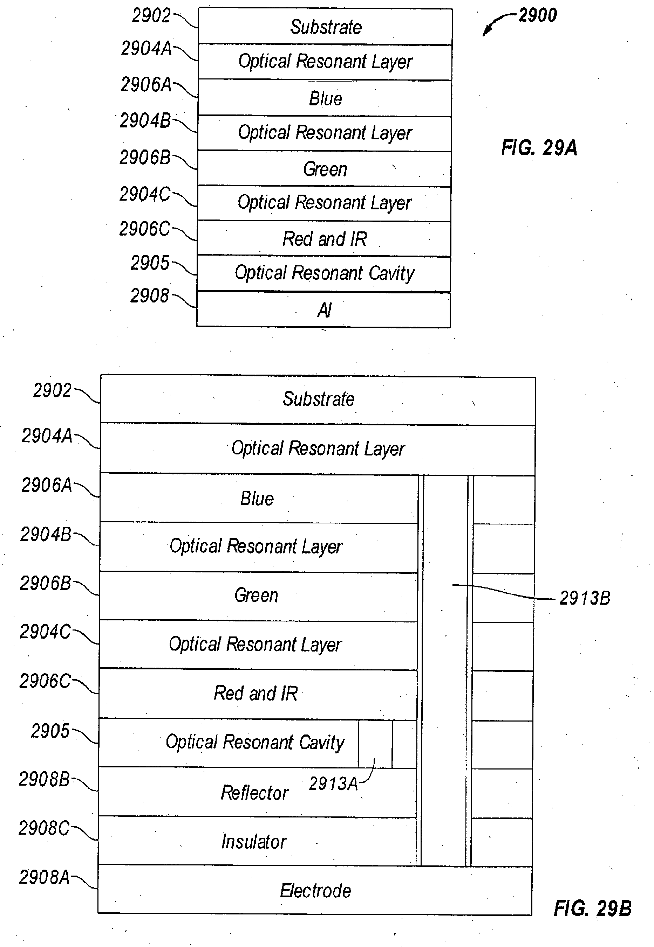

Figure 29A illustrates a diagram of one optimized version of the multi-junction photovoltaic device wherein an optical resonant layer is disposed between each active layer as well as between the top active layer and the substrate and an optical resonant cavity is disposed between the bottom active layer and the reflector. For example, optical resonant layer 2904A is disposed between the substrate 2902 and junction 2906A. Similarly optical resonant layers 2904B and 2904C have been added to form an alternating stack of optical resonant layers and active layers 2906A, 2906B, 2906C. An optical resonant cavity 2905 is disposed between the last active layer 2906C and the reflector 2908. Each optical resonant layer 2904A-2804C and the optical resonant cavity 2905 may comprise, e.g., ITO, an air gap, $SiO_2$, or other media. If the optical resonant layers or the optical resonant cavity comprise non-conducting materials, then vias as shown in Figure 29B may be used to provide electrical connectivity. Thus, the optical stack of the photovoltaic device 2900 comprises the optical resonant layer 2904A comprising ITO, an active layer 2906A configured to absorb wavelengths in the range of blue light, the optical resonant layer 2904B, an active layer 2906B configured to absorb wavelengths in the range of green light, the optical resonant layer 2904C, an active layer 2906C configured to absorb wavelengths in the range of red and infrared light, an optical resonant cavity 2905 and a reflector layer 2908. The multi-junction photodiode can be optimized based on the interferometric principles described above. In this modeled optimized diagram of a multi-junction photovoltaic device, for example, the absorbance of each active layer can be increased by varying the thicknesses of or materials used in other layers present in the optical stack. The photovoltaic device further includes insulator 2908C and electrode 2908A.

In some embodiments, the multi-junction photodiode include less optical resonant layers than shown in Figure 29A. For example in one embodiment, the optical resonant layer 2904A may be disposed between the substrate 2902 and one of the active layers 2906A and the other optical resonant layers 2904B and 2904C may be excluded. In another embodiment, the optical resonant layer 2904B may be disposed between active layers 2906A and 2906B and the other optical resonant layers 2904A and 2904C may be excluded. In another embodiment, the optical resonant layer 2904C may be disposed between active layers 2906B and 2906C and the other optical resonant layers 2904A and 2904B may be excluded. In other embodiments, more than one of the optical resonant layers 2904A, 2904B, 2904C may be included and one may be excluded. The optical resonant cavity 2905 may be included or excluded from any of the embodiments. A greater or lesser number of active layers may be included. These active layers may be separated by layers other than optical resonant layers. A greater or lesser number of optical resonator layers may be used. The number, arrangement, and type of active layers, optical resonant layers, and optical resonant cavities can thus vary and may depend on the design and/or optimization process. As described above, the labels "Red, Green and Blue" only refer to a range of wavelengths and not to the real wavelength of, for example, red, green and blue light. The active layers may absorb other wavelengths, Other variations are possible.

As described above, the composition and/or the thickness of each layer in the different embodiments of the photovoltaic device may be optimized in the design and fabrication stage using the methods described above to increase absorption in the active layers and decrease reflection. The iPV embodiments, for example, can be optimized using the IMOD design principles as described above. In some embodiments, a MEMS engine or platform can be provided to vary the thickness of the optical resonant cavities or layers in these embodiments dynamically while the iPV cell is in operation. The iPV embodiments described above can thus be improved as a result of interferometric effects. An increase in the absorption of energy in the PV absorber/active region may result in an increase in the overall efficiency of the iPV device.

The designs, however, are not truly optimal in every respect. For example, in those embodiments comprising a TCO layer in the optical resonant cavity, electrical losses may be negligible. However, the TCO may introduce some optical loss. The embodiments comprising air or SiO$_2$ in the optical resonant cavity may exhibit a small decrease in the optical absorption due to the presence of vias. In some embodiments, the presence of vias for electrical connection may result in optical aperture loss.

In some embodiments of the iPV device, increased or optimized absorption efficiency in the active layer may not be necessarily dependent upon the orientation of the incident light with respect to the iPV device. For example, the absorption efficiency when the incident light is substantially normal to the iPV device can be approximately the same as the absorption efficiency when the incident light is at high grazing incidence (for example, approximately 89 degrees from the normal to the iPV device). The orientation of the photovoltaic cell thus need not be completely aligned for optimal absorption efficiency. Nevertheless, the angle of incidence does affect the intensity of light reaching the active layer and thus affects the energy available to be absorbed by the active layer; the less light reaching the photovoltaic cell, the less energy is present to be absorbed by the active layer. Thus, it should be emphasized that for a given area of the photovoltaic device, without active tracking (e.g., moving the photovoltaic to align with the path of the sun), the total absorbed energy diminishes, as the angle of incident $\theta_i$ increases, by a factor of $\cos(\theta_i)$.

In some embodiments, however, where the absorption efficiency changes as a function of the angle of incidence, the iPV stack can be designed for particular angles of incidence using the IMOD principles and interferometric effects. For example, the thickness of the optical cavity can be adjusted to cause increased absorption of desired wavelengths of light incident on the device at non-normal angles. In some embodiments, the optical cavity may be variable (as opposed to fixed) so as to provide for different incident angles, for example, of the sun at different times of the day.

The principles described herein are applicable to both completely reflective (e.g., opaque) as well as transmissive PV devices.

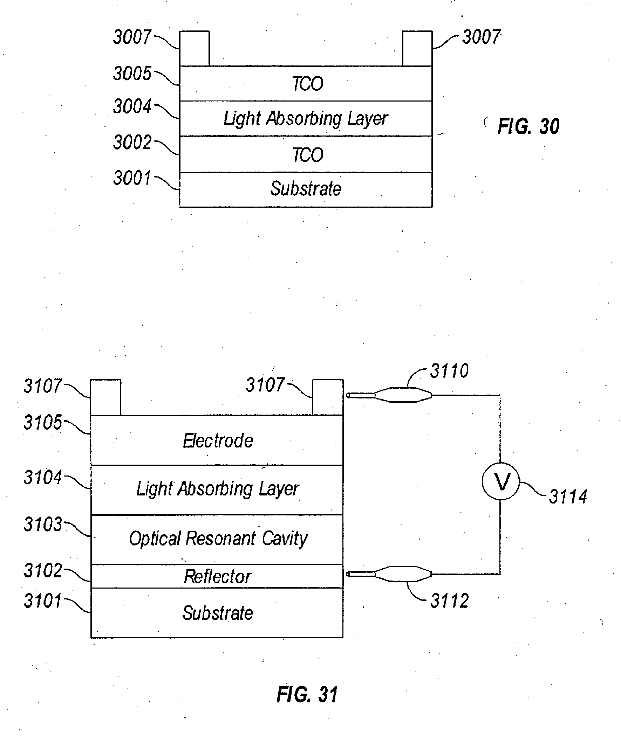

Figure 30 illustrates a conventional semi-transparent PV cell. As used herein, the term "semi-transparent" refers to partially optically transmissive and is not limited to 50% transmission. The semi-transparent PV cell shown in Figure 30 is formed by sandwiching a light absorbing layer 3004 between two transparent conducting oxide (TCO) layers 3005 and 3002. The stacked layers can be disposed over a substrate 3001. Metal leads 3007 may be provided over the TCO layer 3005 for making electrical connections. Metal leads similar to 3007 can be provided in all the embodiments described herein having a top optical resonant layer comprises a conducting material. Such metal leads can also be used in other embodiments as well. For example, in embodiments wherein the top layer comprises a non-conducting material, metal leads similar to 3007 can be provided on the top non-conducting layer and the metal leads can be electrically connected to the electrode layers, for example, through vias.

To optimize the semi-transparent PV cell of Figure 30 using the principles of optical interference and IMOD design principles, one approach can be to dispose an optical resonant cavity 3103 between the light absorbing layer 3104 and a reflecting layer 3102 as illustrated in Figure 31. In some embodiments, the top electrode layer 3105 can be an optical resonant layer comprising a transparent conducting electrode. The top electrode layer 3105 can comprise, for example, ITO or ZnO. In some embodiments, an AR coating may be disposed on the top electrode layer 3105. The thickness and the material properties (for example, refractive index n and extinction coefficient k) for the various layers comprising the PV cell including the optical resonant cavity 3103, the reflector layer 3102, the active layer 3304 that provide increased absorption in the active layer can be used. The thickness of the reflector can control the degree of transparency. For example, an iPV device with a very thin reflector may have a higher degree of transparency as compared to a reflector with a relatively thicker reflector layer. The thickness of the reflector layer may be reduced to produce a semi-transparent iPV device. For example in some embodiments, the thickness of the reflector in a semi-transparent iPV device may range between 5 nm and 25 nm. In certain embodiments, the thickness of the reflector in a semi-transparent iPV device may range between 1 nm and 500 nm. In various embodiments, the reflection has a reflectivity of at least 10%, 20%, 30%, 40% or more. In certain embodiments, the reflector has a reflectivity of 50%, 60%, 70%, 80%, 90% or more. In some embodiments, the semi-transparent PV cell can be designed with thinner PV material in comparison to an opaque PV cell. The thickness of the reflector layer may be incorporated in the design, e.g., the optimization, calculation, for increasing absorption in the active layer. A semi-transparent PV cell designed according to the methods described above can be more efficient than the conventional PV cell described in Figure 30 due to increased absorption efficiency. In other embodiments described herein as well as embodiments yet to be devised, the PV cell may be at least partially transparent or optically transmissive.

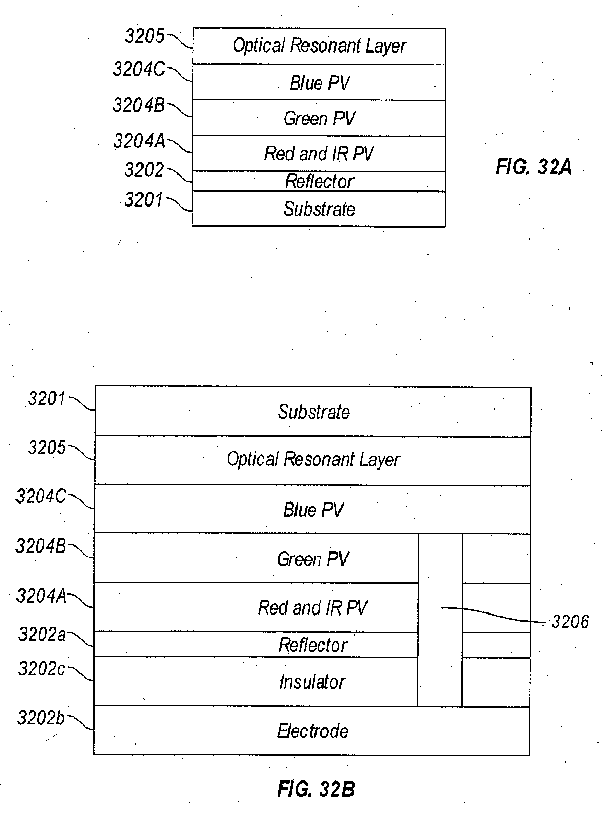

The multi-junction PV shown in Figures 28A-29B, for example, can be made partially optically transmissive by the methods described above. Figure 32A also shows an embodiment of a multi-junction PV cell that may be at least partially optically transmissive. The embodiment shown in Figure 32A comprises a multi-junction active material comprising three active or absorber layers 3204a, 3204b and 3204c. The three absorber layers may absorb light having different frequencies. For example, layer 3204a may absorb light having frequencies in the red and IR region, layer 3204b may substantially absorb light having frequencies in the green region and layer 3204c may substantially absorb light having frequencies in the blue region. The active layer may absorb other wavelengths in alternative embodiments. A reflector 3202 is disposed below the multi-junction active material. An optical resonant layer 3205 is disposed above the multi-junction active material. The thickness and the material composition of the optical resonant layer 3205 may be selected or optimized using the interferometric principles described above such that absorption in the active material can be increased or maximized. In the embodiment shown in Figure 32A, the optical resonant layer may comprise a transparent conducting material such as a TCO or a transparent conducting nitride. However, in other embodiments, the optical resonant layer can comprise a transparent non-conducting dielectric such as $SiO_2$ or an air gap. In other embodiments, the optical resonant layer may comprise a composite structure as described above. Other materials and designs may be used. In those embodiments wherein the optical resonant layer comprises a non-conducting material, a via 3206 can be used to provide electrical connection as shown in Figure 32B. The optical stack can be disposed on a substrate 3201 as shown in Figure 32A and Figure 32B. The substrate may be optically transmissive or opaque as described above.

A partially transmissive reflector layer may be used in other designs disclosed herein. For example, a partially optically transmissive reflector layer may be used in PV devices having a single active layer. Still other configurations are possible. As Figure 32A illustrates, a PV cell can include one or more optical resonant layers and no optical resonant cavity. Accordingly, the optical resonant cavity can be excluded in various PV cells described herein.

Although in various embodiments described herein, the absorption in the active layer has been optimized, as described above, in certain embodiments, the overall efficiency can be increased or optimized by additionally considering the effects of other factors such as collection efficiency. For example, one or more parameters may be adjusted to increase the aggregate effect of both the absorption efficiency and the collection efficiency. In such embodiments, for example, the overall efficiency may be monitored in the optimization process. Other figures of merit, however, may also be used and may be incorporated in the optimization, design or manufacturing process.

As described above, the devices or systems in which the device is integrated may be modeled and calculations performed to assess the performance of the device or system. In some embodiments, the actual performance may be measured. For example, the overall efficiency may be measured by making electrical connection with the electrodes contacting the active layer. Electrical probes 3110 and 3112, for example, are shown in Figure 31 electrically contacting one of the metal leads 3107 and the reflector 3102, which also is an electrode. The electrical probes 3110 and 3112 are electrically connected to a voltmeter 3114 that measures the electrical output of the PV device. Similar arrangements may be used for different embodiments disclosed herein. Electrical contact may be made to metal leads, via, electrode layers, etc. to measure electrical output signals. Other configurations may also be used.

A wide range of variations of the methods and structures described herein are possible.

Accordingly, in various embodiments described herein, the performance of photovoltaic devices may be improved using interferometric techniques. In some embodiments, an optical resonator cavity disposed between an active layer and a reflector may increase absorption in the active layer or layers. However, as described above, optical resonator layers located elsewhere may also provide an increase in absorption in one or more active layers and correspondingly increase efficiency. Thus, as described above, one or more parameters of one or more layers may be adjusted to increase, for example, the efficiency of the device in converting optical power into electrical power. These one or more layers may be the layers employed in conventional photovoltaic devices and not layers added to such structures to obtain improved performance. Accordingly, the optical resonant layers are not to be limited to layers added to a structure to obtain improvement. Additionally, the optical resonant layers are not limited to the layers described above, but may include any other layers that are tuned to provide increased absorption in the active layer using interferometric principles. The optical resonant layers or cavities can also have other functions such as operating as an electrode. The design or optimization may be implemented to increase absorption and efficiency in one or more active layers.

Additionally, although various techniques have been described above as providing for optimization, the methods and structures described herein are not limited to true optimal solutions. The techniques can be used to increase, for example, but not necessarily maximize, absorption in the active layer or overall optical efficiency of the device. Similarly, techniques can be used to decrease and not necessarily minimize absorption in layers other than the active layer. Similarly, the resultant structures are not necessarily the optimal result, but may nevertheless exhibit improved performance or characteristics.

The methods and structures disclosed herein, however, offer a wide range of benefits including performance advantages for some photovoltaic devices. For example, by using an optical resonant cavity or other optical resonant layers in the PV cell, the absorption efficiency of the photovoltaic device may be improved. In some embodiments, for example, the absorption efficiency of the active layer or layers increases by at least about 20% with the presence of at least one optical resonant cavity or layer. Here the absorption value is integrated over the wavelengths in the solar spectrum. In some other photovoltaic devices, the absorption efficiency integrated over the wavelengths in the solar spectrum can increase by at least 25%, 30%, 40%, 50%, 60%, 70%, 80%, 90% or more due to the presence of the optical resonant cavity or layer. In other embodiments, the increase may be 5% or more, 10% or more or 20% or more. For some embodiments, these values may apply when integrating over smaller wavelength ranges as well.

Accordingly interference principles can be applied to increase or optimize the efficiency of the active layer for one or more wavelengths. For example, at least one of the active layers may be configured to absorb light at wavelength of approximately 400 nm with an absorption efficiency greater than 0.7. At least one of the active layers may be configured to absorb light at wavelengths between 400 nm and 450 nm or between 350 nm and 400 nm with an absorption efficiency greater than 0.7. In some embodiments, the active layer or layers may be configured to absorb light between 350 nm and 600 nm with an absorption efficiency greater than 0.7. In other embodiments, the absorption efficiency can be increased or optimized for a single wavelength between 250 nm and 1500 nm, or alternately for a bandwidth of at least 50 nm, 100 nm or 500 nm in the wavelength range between 250 nm and 500 nm. For some embodiments, these values may apply when integrating over smaller wavelength ranges as well.

The overall efficiency of the photovoltaic device may increase as well. For example, in some photovoltaic devices the overall conversion efficiency integrated over the wavelengths in the solar spectrum can increase by at least 15%, 20%, 25% or 30%, 40%, 50%, 60%, 70%, 80%, 90% or more with suitable optical resonant layer or layers. In certain embodiments, the increase may be 5% or more or 10% or more. In some embodiments, the overall conversion efficiency of the photovoltaic device is greater than 0.7, 0.8, 0.9, or 0.95. In other embodiments, the overall conversion efficiency may be less. For example, the overall conversion efficiency may be at least 0.3, 0.4, 0.5, 0.6 or higher. In one embodiment, the overall conversion efficiency may be 0.1 or 0.2 or higher. For some embodiments, these values may apply when integrating over smaller wavelength ranges as well.

An increase in absorption of solar energy in the active layer or active layers of at least 5%, 10%, 20%, 25%, 30% or more may be obtained as a result of optical interference. These absorption values may be determined by integrating over the solar spectrum. For some embodiments, these values may apply when integrating over smaller wavelength ranges as well.

In some embodiments, the presence of at least one optical resonant cavity or layer can increase the average field intensity in the active layer or layers by at least 20%, 25% or 30% when the photovoltaic device is exposed to electromagnetic radiation such as solar spectrum. In other embodiments, the increase in average field intensity is at least 40%, 50%, 60% 70%, 80%, 90% or more. In certain embodiments, the increase is 5% or more, 10% or more or 15% or more. As described below, the average electric field intensity corresponds to the electric field is averaged across the thickness of the particular layer of interest, e.g., the active layer. For some embodiments, these values may apply when integrating over smaller wavelength ranges as well.

In certain embodiments, the presence of at least one optical resonant cavity or layer can produce an increase in the average electric field intensity integrated over the solar spectrum that is greater for the active layer or active layers than the increase in average electric field intensity integrated over the solar spectrum for any other layers in the photovoltaic device. In some embodiments, average electric field intensity in the active layer or layers of the photovoltaic device can increase by at least 1.1 times the average electric field intensity in the active layer or layers of a PV cell without an optical resonant layer. In some other embodiments, the average electric field intensity in the active layer or layers of the photovoltaic device can be at least 1.2 times or 1.3 times the average electric field in the active layer or layers of a PV cell without an optical resonant layer. In other embodiments the increase is at least 1.4 times, 1.5 time, 1.6 times, or 1.7 times the average electric field in the active layer of a PV cell without one or more resonant layer. For some embodiments, these values may apply when integrating over smaller wavelength ranges as well.

In some embodiments, the increase in the average electric field intensity may be greater in another layer of the photovoltaic device other than the active layer or layers. In such embodiments, the absorption in this other layer of the photovoltaic device may, however, be lesser than the absorption in the active layer or layers. In certain embodiments, the average electric field in the active layer or layers is higher than in any other layer, although in other embodiments, a layer other than the active layer has the highest average electric field intensity. Such conditions may be achieved for wavelengths over the solar spectrum or over smaller wavelength ranges.

In various embodiments disclosed, the optical power absorbed by the active layer or layers is increased. In certain embodiments, the increase in the optical power absorbed by the active layer or layers is greater than the optical power absorbed by all the other inactive layers of the photovoltaic device combined. The increase in optical power absorbed by the active layer or layers may be more than 1.1 times, 1.2 times, or 1.3 times the increase in absorbed optical power for any other layer in the PV device. In other embodiments, the increase is more than 1.4 times, 1.5 times, 1.6 times or 1.7 times the increase in absorbed optical power for any other layer in the PV cell.

As described above, these values may be determined by integrating over the solar spectrum. Additionally, these values may be determined for standard solar radiation known as the "air mass 1.5".

As noted above, in certain embodiments these values apply over a wavelength range smaller than the solar spectrum. The values may apply, for example, to the visible wavelength spectrum, the ultraviolet wavelength spectrum or the infrared wavelength spectrum. The values may apply to a wavelength range of 100 nm, 200 nm, 300 nm, 400 nm, 500 nm, 600 nm, 700 nm, 800 nm, 900 nm, 1000 nm or more. The values may apply for larger or smaller wavelength ranges as well. Thus, in certain embodiments these values apply when the parameter e.g. absorption efficiency, overall efficiency, electric field, optical power etc. are integrated over smaller wavelength range other than the entire solar spectrum.

Additionally, these values may be for one or more active layers. For example, the PV cell may be designed to increase absorption in one or more active layer (such as a p type layer, intrinsic semiconducting layer or n type layer) together or separately. Accordingly these values may apply to any of these layers individually or any combination of these layers.

Similarly one or more optical resonant layers may contribute to the level of performance recited herein. Likewise, the performance values listed above may depend on the presence of one or more design parameters of one optical resonant layer or of a group of two or more optical resonant layers.

A wide variety of alternative configurations are possible. For example, components (e.g., layers) may be added, removed, or rearranged. Similarly, processing and method steps may be added, removed, or reordered. Also, although the terms film and layer have been used herein, such terms as used herein include film stacks and multilayers. Such film stacks and multilayers may be adhered to other structures using adhesive or may be formed on other structures using deposition or in other manners. Likewise, the term active layer may be used to include p and n doped regions and/or intrinsic portions of an active region. Similarly, other types of materials may be used. For example, although the active layer may comprise semiconductor, other materials such as organic materials may also be used in some embodiments.

Numerous applications are possible for devices of the present disclosure. The photovoltaic devices may, for example, be used on architectural structures such as homes, or buildings, or in stand alone structures such as in a solar farm. The solar devices may be included on vehicles such as automobiles, planes, marine vessels, spacecraft, etc. The solar cells may be used on electronics devices including but not limited to cell phones, computers, portable commercial devices. The solar cells may be used for military, medical, consumer industrial and scientific applications. Applications beyond those specifically described herein are also possible.

It will also be appreciated by those skilled in the art that various modifications and changes may be made without departing from the scope of the invention. Such modifications and changes are intended to fall within the scope of the invention, as defined by the appended claims.

**Claims**

1. A photovoltaic device comprising:

   means (1102, 1103) for absorbing light, said light absorbing means (1102, 1103) configured to produce an electrical signal as a result of light absorbed by the light absorbing means (1102, 1103), and
   means (1104) for reflecting light disposed to reflect light transmitted through said at least one light absorbing means (1102, 1103); and **characterised by**
   means (1106) for producing optical resonance between said light absorbing means (1102, 1103) and said light reflecting means (1104), said optical resonance producing means (1106) configured to increase the amount of light absorbed by said at least one light absorbing means (1102, 1103),
   wherein said optical resonance producing means (1106) comprises means (1106B) for electrically insulating, and
   wherein said insulating means (1106B) comprises air.

2. The photovoltaic device of Claim 1, wherein said light absorbing means (1102, 1103) comprises at least one active layer (1102, 1103), or said reflecting means (1104) comprises a reflective layer (1104) or said optical resonance producing means comprises at least one optical resonance cavity (1106).

3. The photovoltaic device of Claim 2, wherein said active layer (1102, 1103) comprises semiconductor.

4. The photovoltaic device of Claims 2, wherein said active layer (1102, 1103) comprises a PN junction or a PIN junction.

5. The photovoltaic device of Claim 2, wherein said optical resonance cavity (1106) comprises a hollow region.

6. The photovoltaic device of Claim 5, wherein said hollow region comprises an air gap (1106B).

7. The photovoltaic device of Claim 2, wherein said active layer (1102, 1103) has an absorption efficiency for wavelengths in the solar spectrum and wherein the absorption efficiency integrated over the wavelengths in the solar spectrum increases by at least about 20% with the presence of said optical resonance cavity (1106).

8. The photovoltaic device of Claim 7, wherein the absorption efficiency integrated over the wavelengths in the solar spectrum increases by at least about 25% with the presence of said optical resonance cavity (1106).

**9.** The photovoltaic device of Claim 8, wherein the absorption efficiency integrated over the wavelengths in the solar spectrum increases by at least about 30% with the presence of said optical resonance cavity (1106).

**10.** The photovoltaic device of Claim 2, wherein said reflective layer (1104) has a reflectivity of at least 10%.

**11.** The photovoltaic device of Claim 2, wherein said reflective layer (1104) comprises metal.

**12.** The photovoltaic device of Claim 2, wherein said reflective layer (1104) is partially reflective such that said photovoltaic device is partially optically transmissive for some visible wavelengths.

**13.** The photovoltaic device of Claim 2, wherein said reflective layer (1104) is partially reflective such that said photovoltaic device is partially optically transmissive for some infrared or ultraviolet wavelengths.

**14.** The photovoltaic device of Claim 2, wherein said optical resonance cavity (1106) comprises a non-conducting oxide.

**15.** The photovoltaic device of Claim 14, wherein said optical resonance cavity (1106) comprises $SiO_2$.

**16.** The photovoltaic device of Claim 2, wherein said optical resonance cavity (1106) comprises multiple layers.

**17.** The photovoltaic device of Claim 2, wherein the thickness of the optical resonance cavity (1106) is optimized to increase light absorption in the active layer (1102, 1103).

**18.** The photovoltaic device of Claim 2, further comprising an antireflective layer disposed over the active layer (1102, 1103).

**19.** The photovoltaic device of Claim 2, further comprising a first via electrically connected to said active layer (1102, 1103).

**20.** The photovoltaic device of Claim 19, further comprising a second via electrically connected to said active layer(1102, 1103).

**21.** The photovoltaic device of Claim 2, wherein said optical resonance cavity (1106) has a thickness less than about 2000 nm.

**22.** The photovoltaic device of any of Claims 1 and 2, having an overall conversion efficiency for wavelengths in the solar spectrum, wherein the overall conversion efficiency integrated over the wavelengths in the solar spectrum increases by at least about 15% with the presence of said optical resonance producing means (1106).

**23.** The photovoltaic device of Claim 22, wherein the overall conversion efficiency integrated over the wavelengths in the solar spectrum increases by at least about 20% with the presence of said optical resonance producing means (1106).

**24.** The photovoltaic device of Claim 23, wherein the overall conversion efficiency integrated over the wavelengths in the solar spectrum increases by at least about 25% with the presence of said optical resonance producing means (1106).

**25.** The photovoltaic device of any of Claims 1 and 2, wherein the presence of said optical resonance producing means (1106) increases the average electric field intensity in said absorbing means when the photovoltaic device is exposed to the solar spectrum.

**26.** The photovoltaic device of any of Claims 1 and 2, wherein the presence of said optical resonance producing means (1106) increases the average electric field intensity in said absorbing means by at least 20% when the photovoltaic device is exposed to the solar spectrum.

**27.** The photovoltaic device of any of Claims 1 and 2, wherein the presence of said optical resonance producing means (1106) increases the average field strength in said absorbing means by at least 25% when the photovoltaic device is exposed to the solar spectrum.

**28.** The photovoltaic device of Claim 1 and 2, wherein the presence of said optical resonance producing means (1106) increases the average field strength in said absorbing means by at least 30% when the photovoltaic device is exposed to the solar spectrum.

**29.** The photovoltaic device of any of Claims 1 and 2, wherein said optical resonance producing means (1106) has a thickness such that said photovoltaic device has an overall conversion efficiency integrated over the solar spectrum that is greater than 0.7.

**30.** The photovoltaic device of any of Claims 1 and 2, wherein said optical resonance producing means (1106) has a thickness such that said photovoltaic device has an overall conversion efficiency integrated over the solar spectrum that is greater than 0.8.

**31.** The photovoltaic device of any of Claims 1 and 2, wherein said optical resonance producing means (1106) has a thickness such that said photovoltaic device has an overall conversion efficiency integrated over the solar spectrum that is greater than 0.9.

32. The photovoltaic device of any of Claims 1 and 2, wherein said optical resonance producing means (1106) has a thickness such that said photovoltaic device has an overall conversion efficiency integrated over the solar spectrum that is greater than 0.95.

33. The photovoltaic device of any of Claims 1 and 2, further comprising at least one additional absorbing means and at least one non-absorbing means separating said at least one additional absorbing means from said absorbing means.

34. The photovoltaic device of Claim 33, wherein said at least one non-absorbing means comprises at least one optical resonant layer (1106).

35. The photovoltaic device of any of Claims 1 and 2, further comprising at least one additional optical resonance producing means.

36. The photovoltaic device of Claim 35, wherein said at least one additional optical resonance producing means comprises at least one optical resonant cavity between said absorbing means (1102, 1103) and said reflecting means (1104).

37. A method of manufacturing a photovoltaic device according to claim 1, the method comprising:

   providing an active layer (1102, 1103), said active layer (1102, 1103) configured to produce an electrical signal as a result of light absorbed by said active layer (1102, 1103); and
   providing a reflector layer (1104) to reflect light transmitted through said active layer (1102, 1103); and **characterised by**
   disposing an optical resonance cavity (1106) between said active layer (1102, 1103) and said reflector layer (1104), said optical resonance cavity (1106) comprising an air gap (1106B), the presence of said optical resonance cavity (1106) increasing the amount of light absorbed by said active layer (1102, 1103).

**Patentansprüche**

1. Ein photovoltaisches Bauteil mit:

   Mitteln (1102, 1103) zum Absorbieren von Licht, wobei die Licht absorbierenden Mittel (1102, 1103) dafür ausgebildet sind, ein elektrisches Signal zu erzeugen aufgrund von Licht, das von den Licht absorbierenden Mitteln (1102, 1103) absorbiert wird; und
   Mitteln (1104) zum Reflektieren von Licht, die angeordnet sind, um Licht zu reflektieren, das durch das zumindest eine Licht absorbierende Mittel (1102, 1103) hindurchgeht, und **gekennzeichnet durch**
   Mittel (1106) zum Erzeugen von optischer Resonanz zwischen den Licht absorbierenden Mitteln (1102, 1103) und den lichtreflektierenden Mitteln (1104), wobei die eine optische Resonanz erzeugenden Mittel (1106) dafür ausgebildet sind, den Anteil an Licht zu erhöhen, der von dem zumindest einen Licht absorbierenden Mittel (1102, 1103) absorbiert wird,
   wobei die eine optische Resonanz erzeugenden Mittel (1106) Mittel (1106B) zum elektrischen Isolieren aufweisen, und
   wobei die isolierenden Mittel (1106B) Luft aufweisen.

2. Das photovoltaische Bauteil nach Anspruch 1, wobei die Licht absorbierenden Mittel (1102, 1103) zumindest eine aktive Schicht (1102, 1103) aufweisen, oder die reflektierenden Mittel (1104) eine reflektierende Schicht (1104) aufweisen, oder die eine optische Resonanz erzeugenden Mittel zumindest einen optischen Resonanzhohlraum (1106) aufweisen.

3. Das photovoltaische Bauteil nach Anspruch 2, wobei die aktive Schicht (1102, 1103) einen Halbleiter aufweist.

4. Das photovoltalsche Bauteil nach Anspruch 2, wobei die aktive Schicht (1102, 1103) einen PN-Übergang oder einen PIN-Übergang aufweist.

5. Das photovoltaische Bauteil nach Anspruch 2, wobei der optische Resonanzhohlraum (1106) einen hohlen Bereich aufweist.

6. Das photovoltaische Bauteil nach Anspruch 5, wobei der hohle Bereich einen Luftspalt (1106B) aufweist.

7. Das photovoltaische Bauteil nach Anspruch 2, wobei die aktive Schicht (1102, 1103) eine Absorptionseffizienz für Wellenlängen im Sonnenlichtspektrum hat und wobei die Absorptionseffizienz integriert über die Wellenlängen im Sonnenlichtspektrum bei Vorhandensein des optischen Resonanzhohlraums (1106) um zumindest ungefähr 20 % ansteigt.

8. Das photovoltaische Bauteil nach Anspruch 7, wobei die Absorptionseffizienz integriert über die Wellenlängen im Sonnenlichtspektrum bei Vorhandensein des optischen Resonanzhohlraums (1106) um zumindest ungefähr 25 % ansteigt.

**9.** Das photovoltaische Bauteil nach Anspruch 8, wobei die Absorptionseffizienz integriert über die Wellenlängen im Sonnenlichtspektrum bei Vorhandensein des optischen Resonanzhohlraums (1106) um zumindest ungefähr 30 % ansteigt.

**10.** Das photovoltaische Bauteil nach Anspruch 2, wobei die reflektierende Schicht (1104) eine Reflektivität von mindestens 10 % hat.

**11.** Das photovoltaische Bauteil nach Anspruch 2, wobei die reflektierende Schicht (1104) Metall aufweist.

**12.** Das photovoltaische Bauteil nach Anspruch 2, wobei die reflektierende Schicht (1104) teilweise reflektierend ist, so dass das photovoltaische Bauteil teilweise optisch durchlässig ist für einige sichtbare Wellenlängen.

**13.** Das photovoltaische Bauteil nach Anspruch 2, wobei die reflektierende Schicht (1104) teilweise reflektierend ist, so dass das photovoltaische Bauteil teilweise optisch durchlässig ist für einige infrarote oder ultraviolette Wellenlängen.

**14.** Das photovoltaische Bauteil nach Anspruch 2, wobei der optische Resonanzhohlraum (1106) ein nichtleitendes Oxid aufweist.

**15.** Das photovoltaische Bauteil nach Anspruch 14, wobei der optische Resonanzhohlraum (1106) $SiO_2$ aufweist.

**16.** Das photovoltaische Bauteil nach Anspruch 2, wobei der optische Resonanzhohlraum (1106) mehrere Schichten aufweist.

**17.** Das photovoltaische Bauteil nach Anspruch 2, wobei die Dicke von dem optischen Resonanzhohlraum (1106) optimiert ist, um Lichtabsorption in der aktiven Schicht (1102, 1103) zu erhöhen.

**18.** Das photovoltaische Bauteil nach Anspruch 2, ferner mit einer Antireflektierschicht, die über der aktiven Schicht (1102, 1103) angeordnet ist.

**19.** Das photovoltaische Bauteil nach Anspruch 2, ferner mit einem ersten Leiter, der mit der aktiven Schicht (1102, 1103) verbunden ist.

**20.** Das photovoltaische Bauteil nach Anspruch 19, ferner mit einem zweiten Leiter, der elektrisch mit der aktiven Schicht (1102, 1103) verbunden ist.

**21.** Das photovoltaische Bauteil nach Anspruch 2, wobei der optische Resonanzhohlraum (1106) eine Dicke von weniger als ungefähr 2000 nm hat.

**22.** Das photovoltaische Bauteil nach Anspruch 1 oder 2 mit einer Gesamtwandlungseffizienz für Wellenlängen im Sonnenlichtspektrum, wobei die Gesamtwandlungseffizienz integriert über die Wellenlängen im Sonnenlichtspektrum bei Vorhandensein der eine optische Resonanz erzeugenden Mittel (1106) um zumindest ungefähr 15 % ansteigt.

**23.** Das photovoltaische Bauteil nach Anspruch 22, wobei die Gesamtwandlungseffizienz integriert über die Wellenlängen im Sonnenlichtspektrum bei Vorhandensein der eine optische Resonanz erzeugenden Mittel (1106) um zumindest ungefähr 20 % ansteigt.

**24.** Das photovoltaische Bauteil nach Anspruch 23, wobei die Gesamtwandlungseffizienz integriert über die Wellenlängen im Sonnenlichtspektrum bei Vorhandensein der eine optische Resonanz erzeugenden Mittel (1106) um zumindest ungefähr 25 % ansteigt.

**25.** Das photovoltaische Bauteil nach Anspruch 1 oder 2, wobei die Anwesenheit der eine optische Resonanz erzeugenden Mittel (1106) die durchschnittliche Intensität des elektrischen Felds in den Absorptionsmitteln erhöht, wenn das photovoltaische Bauteil dem Sonnenlichtspektrum ausgesetzt ist.

**26.** Das photovoltaische Bauteil nach Anspruch 1 oder 2, wobei die Anwesenheit der eine optische Resonanz erzeugenden Mittel (1106) die durchschnittliche Intensität des elektrischen Felds in den Absorptionsmitteln um zumindest 20 % erhöht, wenn das photovoltaische Bauteil dem Sonnenlichtspektrum ausgesetzt ist.

**27.** Das photovoltaische Bauteil nach Anspruch 1 oder 2, wobei die Anwesenheit der eine optische Resonanz erzeugenden Mittel (1106) die durchschnittliche Intensität des elektrischen Felds in den Absorptionsmitteln um zumindest 25 % erhöht, wenn das photovoltaische Bauteil dem Sonnenlichtspektrum ausgesetzt ist.

**28.** Das photovoltaische Bauteil nach Anspruch 1 oder 2, wobei die Anwesenheit der eine optische Resonanz erzeugenden Mittel (1106) die durchschnittliche Intensität des elektrischen Felds in den Absorptionsmitteln um zumindest 30 % erhöht, wenn das photovoltaische Bauteil dem Sonnenlichtspektrum ausgesetzt ist.

**29.** Das photovoltaische Bauteil nach Anspruch 1 oder 2, wobei die eine optische Resonanz erzeugenden Mittel (1106) eine Dicke haben, so dass das photovoltaische Bauteil eine Gesamtwandlungseffizienz integriert über das Sonnenlichtspektrum hat, die größer ist als 0,7.

**30.** Das photovoltaische Bauteil nach Anspruch 1 oder 2, wobei die eine optische Resonanz erzeugenden Mittel (1106) eine Dicke haben, so dass das photovoltaische Bauteil eine Gesamtwandlungseffizienz integriert über das Sonnenlichtspektrum hat, die größer ist als 0,8.

**31.** Das photovoltaische Bauteil nach Anspruch 1 oder 2, wobei die eine optische Resonanz erzeugenden Mittel (1106) eine Dicke haben, so dass das photovoltaische Bauteil eine Gesamtwandlungseffizienz integriert über das Sonnenlichtspektrum hat, die größer ist als 0,9.

**32.** Das photovoltaische Bauteil nach Anspruch 1 oder 2, wobei die eine optische Resonanz erzeugenden Mittel (1106) eine Dicke haben, so dass das photovoltaische Bauteil eine Gesamtwandlungseffizienz integriert über das Sonnenlichtspektrum hat, die größer ist als 0,95.

**33.** Das photovoltaische Bauteil nach Anspruch 1 oder 2, ferner mit zumindest einem zusätzlichen Absorptionsmittel und zumindest einem nicht-absorbierenden Mittel, das das zumindest eine zusätzliche Absorptionsmittel von den Absorptionsmitteln trennt.

**34.** Das photovoltaische Bauteil nach Anspruch 33, wobei das zumindest eine nicht-absorbierende Mittel zumindest eine optisch resonierende Schicht (1106) aufweist.

**35.** Das photovoltaische Bauteil nach Anspruch 1 oder 2, feer mit zumindest einem zusätzlichen Mittel, das eine optische Resonanz erzeugt.

**36.** Das photovoltaische Bauteil nach Anspruch 35, wobei das zumindest eine zusätzliche Mittel, das eine optische Resonanz erzeugt, zumindest einen optisch resonierenden Hohlraum zwischen den Absorptionsmitteln (1102, 1103) und den reflektierenden Mitteln (1104) aufweist.

**37.** Ein Verfahren zum Herstellen eines photovoltaischen Bauteils nach Anspruch 1, das Verfahren mit:

Bereitstellen einer aktiven Schicht (1102, 1103), wobei die aktive Schicht (1102, 1103) dafür ausgebildet ist, ein elektrisches Signal aufgrund von Licht zu erzeugen, das von der aktiven Schicht (1102, 1103) absorbiert wurde; und
Bereitstellen einer Reflexionsschicht (1104), um Licht zu reflektieren, das durch die aktive Schicht (1102, 1103) hindurchgeht; und **gekennzeichnet durch**
Anordnen eines optischen Resonanzhohlraums (1106) zwischen der aktiven Schicht (1102, 1103) und der Reflexionsschicht (1104), wobei der optische Resonanzhohlraum (1106) einen Luftspalt (1106B) aufweist und wobei die Anwesenheit des optischen Resonanzhohlraums (1106) den Anteil an Licht erhöht, der von der aktiven Schicht (1102, 1103) absorbiert wird.

**Revendications**

**1.** Dispositif photovoltaïque comprenant :

un moyen (1102, 1103) pour absorber la lumière, ledit moyen d'absorption de lumière (1102, 1103) étant configuré pour produire un signal électrique en conséquence de la lumière absorbée par le moyen d'absorption de lumière (1102, 1103) ; et
un moyen (1104) pour réfléchir la lumière disposé pour réfléchir la lumière transmise à travers ledit au moins un moyen d'absorption de lumière (1102, 1103), et **caractérisé par**
un moyen (1106) pour produire une résonance optique entre ledit moyen d'absorption de lumière (1102, 1103) et ledit moyen de réflexion de lumière (1104), ledit moyen de production de résonance optique (1106) étant configuré pour augmenter la quantité de lumière absorbée par ledit au moins un moyen d'absorption de lumière (1102, 1103),
dans lequel ledit moyen de production de résonance optique (1106) comprend un moyen (1106B) pour isoler électriquement, et
dans lequel ledit moyen d'isolation (1106B) comprend de l'air.

**2.** Dispositif photovoltaïque selon la revendication 1, dans lequel ledit moyen d'absorption de lumière (1102, 1103) comprend au moins une couche active (1102, 1103), ou bien ledit moyen de réflexion (1104) comprend une couche réfléchissante (1104), ou bien ledit moyen de production de résonance optique comprend au moins une cavité de résonance optique (1106).

**3.** Dispositif photovoltaïque selon la revendication 2, dans lequel ladite couche active (1102, 1103) comprend un semi-conducteur.

**4.** Dispositif photovoltaïque selon la revendication 2, dans lequel ladite couche active (1102, 1103) comprend une jonction PN ou une jonction PIN.

**5.** Dispositif photovoltaïque selon la revendication 2, dans lequel ladite cavité de résonance optique (1106) comprend une région creuse.

**6.** Dispositif photovoltaïque selon la revendication 5, dans lequel ladite région creuse comprend un entrefer (1106B).

7. Dispositif photovoltaïque selon la revendication 2, dans lequel ladite couche active (1102, 1103) a une efficacité d'absorption pour les longueurs d'onde dans le spectre solaire, et dans lequel l'efficacité d'absorption intégrée sur les longueurs d'onde dans le spectre solaire augmente d'au moins 20 % environ avec la présence de ladite cavité de résonance optique (1106).

8. Dispositif photovoltaïque selon la revendication 7, dans lequel l'efficacité d'absorption intégrée sur les longueurs d'onde dans le spectre solaire augmente d'au moins 25 % environ avec la présence de ladite cavité de résonance optique (1106).

9. Dispositif photovoltaïque selon la revendication 8, dans lequel l'efficacité d'absorption intégrée sur les longueurs d'onde dans le spectre solaire augmente d'au moins 30 % environ avec la présence de ladite cavité de résonance optique (1106).

10. Dispositif photovoltaïque selon la revendication 2, dans lequel ladite couche réfléchissante (1104) a une réflectivité d'au moins 10 %.

11. Dispositif photovoltaïque selon la revendication 2, dans lequel ladite couche réfléchissante (1104) comprend un métal.

12. Dispositif photovoltaïque selon la revendication 2, dans lequel ladite couche réfléchissante (1104) est partiellement réfléchissante, de telle sorte que ledit dispositif photovoltaïque est partiellement transmissif optiquement pour certaines longueurs d'onde visibles.

13. Dispositif photovoltaïque selon la revendication 2, dans lequel ladite couche réfléchissante (1104) est partiellement réfléchissante, de telle sorte que ledit dispositif photovoltaïque est partiellement transmissif optiquement pour certaines longueurs d'onde infrarouges ou ultraviolettes.

14. Dispositif photovoltaïque selon la revendication 2, dans lequel ladite cavité de résonance optique (1106) comprend un oxyde non conducteur.

15. Dispositif photovoltaïque selon la revendication 14, dans lequel ladite cavité de résonance optique (1106) comprend du $SiO_2$.

16. Dispositif photovoltaïque selon la revendication 2, dans lequel ladite cavité de résonance optique (1106) comprend de multiples couches.

17. Dispositif photovoltaïque selon la revendication 2, dans lequel l'épaisseur de la cavité de résonance optique (1106) est optimisée pour augmenter l'absorption de lumière dans la couche active (1102, 1103).

18. Dispositif photovoltaïque selon la revendication 2, comprenant en outre une couche antireflet disposée par-dessus la couche active (1102, 1103).

19. Dispositif photovoltaïque selon la revendication 2, comprenant en outre un premier trou d'interconnexion relié électriquement à ladite couche active (1102, 1103).

20. Dispositif photovoltaïque selon la revendication 19, comprenant en outre un deuxième trou d'interconnexion relié électriquement à ladite couche active (1102, 1103).

21. Dispositif photovoltaïque selon la revendication 2, dans lequel ladite cavité de résonance optique (1106) a une épaisseur inférieure à environ 2000 nm.

22. Dispositif photovoltaïque selon l'une quelconque des revendications 1 et 2, ayant une efficacité de conversion globale pour les longueurs d'onde dans le spectre solaire, l'efficacité de conversion globale intégrée sur les longueurs d'onde dans le spectre solaire augmentant d'au moins 15 % environ avec la présence dudit moyen de production de résonance optique (1106).

23. Dispositif photovoltaïque selon la revendication 22, dans lequel l'efficacité de conversion globale intégrée sur les longueurs d'onde dans le spectre solaire augmente d'au moins 20 % environ avec la présence dudit moyen de production de résonance optique (1106).

24. Dispositif photovoltaïque selon la revendication 23, dans lequel l'efficacité de conversion globale intégrée sur les longueurs d'onde dans le spectre solaire augmente d'au moins 25 % environ avec la présence dudit moyen de production de résonance optique (1106).

25. Dispositif photovoltaïque selon l'une quelconque des revendications 1 et 2, dans lequel la présence dudit moyen de production de résonance optique (1106) augmente l'intensité moyenne du champ électrique dans ledit moyen d'absorption quand le dispositif photovoltaïque est exposé au spectre solaire.

26. Dispositif photovoltaïque selon l'une quelconque des revendications 1 et 2, dans lequel la présence dudit moyen de production de résonance optique (1106) augmente l'intensité moyenne du champ électrique dans ledit moyen d'absorption d'au moins 20 % quand le dispositif photovoltaïque est exposé au spectre solaire.

27. Dispositif photovoltaïque selon l'une quelconque des revendications 1 et 2, dans lequel la présence dudit moyen de production de résonance optique (1106) augmente l'intensité moyenne du champ dans ledit moyen d'absorption d'au moins 25 % quand le dispositif photovoltaïque est exposé au spectre solaire.

28. Dispositif photovoltaïque selon l'une quelconque des revendications 1 et 2, dans lequel la présence dudit moyen de production de résonance optique (1106) augmente l'intensité moyenne du champ dans ledit moyen d'absorption d'au moins 30 % quand le dispositif photovoltaïque est exposé au spectre solaire.

29. Dispositif photovoltaïque selon l'une quelconque des revendications 1 et 2, dans lequel ledit moyen de production de résonance optique (1106) a une épaisseur telle que ledit dispositif photovoltaïque a une efficacité de conversion globale intégrée sur le spectre solaire qui est supérieure à 0,7.

30. Dispositif photovoltaïque selon l'une quelconque des revendications 1 et 2, dans lequel ledit moyen de production de résonance optique (1106) a une épaisseur telle que ledit dispositif photovoltaïque a une efficacité de conversion globale intégrée sur le spectre solaire qui est supérieure à 0,8.

31. Dispositif photovoltaïque selon l'une quelconque des revendications 1 et 2, dans lequel ledit moyen de production de résonance optique (1106) a une épaisseur telle que ledit dispositif photovoltaïque a une efficacité de conversion globale intégrée sur le spectre solaire qui est supérieure à 0,9.

32. Dispositif photovoltaïque selon l'une quelconque des revendications 1 et 2, dans lequel ledit moyen de production de résonance optique (1106) a une épaisseur telle que ledit dispositif photovoltaïque a une efficacité de conversion globale intégrée sur le spectre solaire qui est supérieure à 0,95.

33. Dispositif photovoltaïque selon l'une quelconque des revendications 1 et 2, comprenant en outre au moins un moyen d'absorption supplémentaire et au moins un moyen non absorbant séparant ledit au moins un moyen d'absorption supplémentaire dudit moyen d'absorption.

34. Dispositif photovoltaïque selon la revendication 33, dans lequel ledit au moins un moyen non absorbant comprend au moins une couche optique résonante (1106).

35. Dispositif photovoltaïque selon l'une quelconque des revendications 1 et 2, comprenant en outre au moins un moyen de production de résonance optique supplémentaire.

36. Dispositif photovoltaïque selon la revendication 35, dans lequel ledit au moins un moyen de production de résonance optique supplémentaire comprend au moins une cavité optique résonante entre ledit moyen d'absorption (1102, 1103) et ledit moyen de réflexion (1104).

37. Procédé de fabrication d'un dispositif photovoltaïque selon la revendication 1, le procédé comprenant :

l'obtention d'une couche active (1102, 1103), ladite couche active (1102, 1103) étant configurée pour produire un signal électrique en conséquence de la lumière absorbée par ladite couche active (1102, 1103) ; et
l'obtention d'une couche réfléchissante (1104) pour réfléchir la lumière transmise à travers ladite couche active (1102, 1103) ; et **caractérisé par**
la mise en place d'une cavité de résonance optique (1106) entre ladite couche active (1102, 1103) et ladite couche réfléchissante (1104), ladite cavité de résonance optique (1106) comprenant un entrefer (1106B), la présence de ladite cavité de résonance optique (1106) augmentant la quantité de lumière absorbée par ladite couche active (1102, 1103).

**FIG. 1**

**FIG. 2**

**FIG. 3**

300

| Substrate | 301 |
|---|---|
| Electrode | 302 |
| Absorber | 303 |
| Optical Resonant Cavity | 304 |
| Reflector | 305 |

FIG. 4A

Incident Light

OPEN STATE

301 - Substrate

303 - Thin film stack

304 - Air gap

305 - Reflective membrane

**FIG. 4B**

Incident Light

CLOSED STATE

301 - Substrate

303 - Thin film stack

305 - Reflective membrane

**FIG. 4C**

Total Reflection

Wavelength(nm)

**FIG. 5A**

Total Absorption

Wavelength(nm)

**FIG. 5B**

Absorber Absorption

FIG. 5C

Reflector Absorption

FIG. 5D

FIG. 6A

FIG. 6B

Absorber Absorption

FIG. 6C

Reflector Absorption

FIG. 6D

Total Reflection

**FIG. 7A**

Total Absorption

**FIG. 7B**

Absorber Absorption

FIG. 7C

Reflector Absorption

FIG. 7D

Total Reflection

FIG. 8A

Total Absorption

FIG. 8B

Absorber Absorption

FIG. 8C

Reflector Absorption

FIG. 8D

**900**

Light Energy

902 — AR Coating

901 — Electrode

903 — n type semiconductor

904 — p type semiconductor

905 — Electrode

PV material

906

907

Current Flow

**FIG. 9**

**1000**

1001 — Glass Substrate

1002 — Electrode

1003 — α-Si (p / i / n)

1005 — Electrode

1006 — Reflector

**FIG. 10**

| | |
|---|---|
| 1101 | ITO or ZnO |
| 1102 | CdS n-type |
| 1103 | CIGS p-type |
| 1104 | Reflector |
| 1105 | Glass Substrate |

*FIG. 11A*

| | |
|---|---|
| 1101 | ITO or ZnO |
| 1102 | CdS n-type |
| 1103 | CIGS p-type |
| 1106 | ITO (Optical Resonant Cavity) |
| 1104 | Reflector |
| 1105 | Glass Substrate |

*FIG. 11B*

| | |
|---|---|
| 1101 | ITO or ZnO |
| 1102 | CdS n-type |
| 1103 | CIGS p-type |
| 1106 | Air (Optical Resonant Cavity) |
| 1104 | Reflector |
| 1105 | Glass Substrate |

*FIG. 11C*

FIG. 11D

FIG. 11E

| | |
|---|---|
| 1101 | ITO or ZnO |
| 1102 | CdS n-type |
| 1103 | CIGS p-type |
| 1106A | ITO |
| 1106B | SiO$_2$ |
| 1104 | Reflector |
| 1105 | Glass Substrate |

Optical Resonant Cavity

**FIG. 11F**

| | |
|---|---|
| 1101 | ITO or ZnO |
| 1102 | CdS n-type |
| 1103 | CIGS p-type |
| 1106A | SiO$_2$ |
| 1106B | Air |
| 1104 | Reflector |
| 1105 | Glass Substrate |

Optical Resonant Cavity

**FIG. 11G**

**FIG. 11H**

| | |
|---|---|
| 1101 | ITO or ZnO |
| 1102 | CdS n-type |
| 1103 | CIGS p-type |
| 1106A | ITO |
| 1106B | SiO$_2$ |
| 1106C | Air |
| 1104 | Reflector |
| 1105 | Glass Substrate |

Optical Resonant Cavity

**FIG. 11I**

| | |
|---|---|
| 1105 | Glass Substrate |
| 1101 | ITO or ZnO |
| 1102 | CdS n-type |
| 1103 | CIGS p-type |
| 1107 | Air (Optical Resonant Cavity) |
| 1104 | Reflector |

1107
1106

**FIG. 11J**

| | |
|---|---|
| 1105 | Glass Substrate |
| 1101 | ITO or ZnO |
| 1102 | CdS n-type |
| 1103 | CIGS p-type |
| 1106a | SiO$_2$ |
| 1107 | Air (Optical Resonant Cavity) |
| 1104 | Reflector |

1107
1106b

FIG. 12

*1300*

START — *1302*

↓

IDENTIFY FABRICATION CONSTRAINTS — *1304*

↓

OPTIMIZE NON-CONSTRAINT ELEMENTS OF PHOTOVOLTAIC DEVICE TO MAXIMIZE EFFICIENCY OF ACTIVE LAYER — *1306*

↓

FABRICATE PHOTOVOLTAIC DEVICE IN ACCORDANCE WITH FABRICATION CONSTRAINTS AND OPTIMIZED ELEMENTS — *1308*

↓

END — *1310*

**FIG. 13**

CIGS Absorption

Wavelength(nm)

FIG. 14

| 1501 | Glass |
| 1502 | 1st ITO Layer |
| 1503 | p |
| 1504 | a-Si:H    i |
| 1505 | n |
| 1506 | 2nd ITO Layer |
| 1507 | Ag or Al |

FIG. 15A

Total Absorption

**FIG. 15B**

Total Reflection

**FIG. 15C**

a-Si Absorption

Wavelength(nm)

FIG. 15D

1st ITO Absorption

Wavelength(nm)

FIG. 15E

2nd ITO Absorption

Wavelength(nm)

*FIG. 15F*

Al Absorption

Wavelength(nm)

*FIG. 15G*

FIG. 16A

a-Si Absorption

Wavelength(nm)

FIG. 16B

Total Absorption

Wavelength(nm)

FIG. 16C

1700

| 1703 | ITO or ZnO Electrode |
| 1707 | CdS n-type |
| 1706 | CIGS p-type |
| 1708 | Mo or Al |
| 1702 | Glass |

} 1701
Active Region

**FIG. 17**

CIGS Absorption

Wavelength(nm)

**FIG. 18A**

CdS Absorption

**FIG. 18B**

Total Active
Layer Absorption

**FIG. 18C**

**1900A**

| ITO Layer |
|---|
| CdS n-type |
| CIGS p-type |
| Optical Resonant Cavity |
| Mo or Al |
| Glass |

1904 — ITO Layer
1907 — CdS n-type
1906 — CIGS p-type
1910 — Optical Resonant Cavity
1908 — Mo or Al
1902 — Glass

} 1901

**FIG. 19A**

**1900B**

1904 — ITO Layer
1907 — CdS n-type
1906 — CIGS p-type
1910 — Optical Resonant Cavity (Air Gap)
1908 — Mo or Al
1902 — Glass

} 1901

**FIG. 19B**

CIGS Absorption

Wavelength(nm)

FIG. 20A

CdS Absorption

Wavelength(nm)

FIG. 20B

Total Active
Layer Absorption

**FIG. 20C**

**FIG. 21**

2200 —

Air

| 2204 — | Optical Resonant Layer | |
|---|---|---|
| 2207 — | CdS n-type | ⎫ —2101 |
| 2206 — | CIGS p-type | ⎬ Active Region |
| 2210 — | Optical Resonant Cavity | Via —2211A | ⎭ |
| 2208A — | Mo or Al | |
| 2208C — | Insulator | |
| 2202 — | Glass | |

**FIG. 22**

2300 —

| 2307 — | CdS n-type | | ⎫ —2301 |
|---|---|---|---|
| 2306 — | CIGS p-type | | ⎬ Active Region |
| 2310 — | Optical Resonant Cavity | Via —2311A | Via |
| 2308A — | Mo or Al | | —2311B |
| 2308C — | Insulator | | |
| 2308B — | Mo or Al | | |
| 2302 — | Glass | | |

**FIG. 23**

CIGS Absorption

FIG. 24

FIG. 25A

2506 — | Optical Resonant Layer |

2505 — | CdS n-type |
2504 — | CIGS p-type | } Active Layer

2503 — | Optical Resonant Cavity | Via | <u>2503</u> | Via | — 2507B
2502B — | Reflector | — 2507A |
2502C — | Insulator |
2502A — | Electrode |
2501 — | Substrate |

**FIG. 25B**

2506 — | Optical Resonant Layer |

2505 — | CdS n-type |
2504 — | CIGS p-type | } Active Layer
2508 — | ITO Layer | Via
2503 — | Optical Resonant Cavity | Via | — 2507B
2502B — | Reflector | 2507A |
2502C — | Insulator |
2502A — | Electrode |
2501 — | Substrate |

**FIG. 25C**

| | |
|---|---|
| 2605 | CdS n-type |
| 2604 | CIGS p-type |
| 2603 | Optical Resonant Cavity |
| 2602 | Reflector |
| 2601 | Substrate |

} Active Layer

**FIG. 26**

2700

| | |
|---|---|
| 2702 | Substrate |
| 2704A | Transparent Electrode |
| 2706A | Blue |
| 2706B | Green |
| 2706C | Red and IR |
| 2704B | Transparent Electrode |
| 2708 | Al |

**FIG. 27**

2800

| 2802 | Substrate |
| 2804A | Optical Resonant Layer |
| 2806A | Blue |
| 2806B | Green |
| 2806C | Red and IR |
| 2804B | Optical Resonant Cavity |
| 2808 | Al |

**FIG. 28A**

| 2802 | Substrate | | |
| 2804A | Optical Resonant Layer | | |
| 2806A | Blue | | } Active Layer |
| 2806B | Green | | |
| 2806C | Red and IR | | |
| 2804B | Optical Resonant Cavity | | — 2813B |
| 2808B | Reflector      2813A | | |
| 2808C | Insulator | | |
| 2808A | Electrode | | |

**FIG. 28B**

2902 — | Substrate |
2904A — | Optical Resonant Layer |
2906A — | Blue |
2904B — | Optical Resonant Layer |
2906B — | Green |
2904C — | Optical Resonant Layer |
2906C — | Red and IR |
2905 — | Optical Resonant Cavity |
2908 — | Al |

— 2900

**FIG. 29A**

2902 — | Substrate |
2904A — | Optical Resonant Layer |
2906A — | Blue |
2904B — | Optical Resonant Layer |
2906B — | Green |
2904C — | Optical Resonant Layer |
2906C — | Red and IR |
2905 — | Optical Resonant Cavity |
2908B — | Reflector 2913A |
2908C — | Insulator |
2908A — | Electrode |

— 2913B

**FIG. 29B**

3007 —
3005 —
3004 —
3002 —
3001 —

| TCO |
| Light Absorbing Layer |
| TCO |
| Substrate |

— 3007

( *FIG. 30*

3107 —
3105 —
3104 —
3103 —
3102 —
3101 —

3107 —

— 3110

| Electrode |
| Light Absorbing Layer |
| Optical Resonant Cavity |
| Reflector |
| Substrate |

V — 3114

— 3112

*FIG. 31*

| 3205 | Optical Resonant Layer |
| 3204C | Blue PV |
| 3204B | Green PV |
| 3204A | Red and IR PV |
| 3202 | Reflector |
| 3201 | Substrate |

*FIG. 32A*

| 3201 | Substrate |
| 3205 | Optical Resonant Layer |
| 3204C | Blue PV |
| 3204B | Green PV |
| 3204A | Red and IR PV |
| 3202a | Reflector |
| 3202c | Insulator |
| 3202b | Electrode |

3206

*FIG. 32B*

## REFERENCES CITED IN THE DESCRIPTION

### Patent documents cited in the description

- US 60995259 B
- EP 1691429 A
- US 20070153860 A

### Non-patent literature cited in the description

- Light-Trapping in a-Si Solar Cells: A Summary of the Results from PV Optics. **B. L. SOPORI.** National Center for Photovoltaics Program Review Meeting, Denver, Colorado. 08 September 1988
- **MIRO ZEMAN.** Thin Film Solar Cells, Fabrication, Characterization & Applications. John Wiley and Sons, 2006, 205
- **KRC et al.** Optical and Electrical Modeling of Cu(In,Ga)Se2 Solar Cells. *OPTICAL AND QUANTUM ELECTRONICS,* 2006, vol. 38, 1115-1123